(19) Europäisches Patentamt / European Patent Office / Office européen des brevets

(11) **EP 2 355 319 A2**

(12) **EUROPEAN PATENT APPLICATION**

(43) Date of publication:
**10.08.2011 Bulletin 2011/32**

(51) Int Cl.:
*H02M 1/12* (2006.01)     *H02M 7/5387* (2007.01)
*H02M 7/5395* (2006.01)   *H02M 7/501* (2007.01)

(21) Application number: **11153943.3**

(22) Date of filing: **10.02.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **10.02.2010 PCT/JP2010/051963**

(71) Applicant: **Hitachi Ltd.**
**Tokyo 100-8280 (JP)**

(72) Inventors:
• **Ooyama, Kazuto**
  **Tokyo 100-8220 (JP)**

• **Mitsui, Toshisada**
  **Tokyo 100-8220 (JP)**
• **Nishiguchi, Shingo**
  **Tokyo 100-8220 (JP)**
• **Furukawa, Kimihisa**
  **Tokyo 100-8220 (JP)**

(74) Representative: **MERH-IP**
**Matias Erny Reichl Hoffmann**
**Paul-Heyse-Strasse 29**
**80336 München (DE)**

(54) **Power conversion device**

(57)    A power conversion device 43, 140, 142 includes a power switching circuit 144 that supplies AC voltages generated between switching elements operating as upper arms 328 and switching elements operating as lower arms 330, and a control circuit 172 that generates and supplies to the driver circuit 174 signals for controlling the switching operation of the switching elements 328, 330 by a PWM method in a first operational region in which frequency of an AC power to be outputted is low, and that generates and supplies to the driver circuit 174 signals for controlling the switching operation of the switching elements 328, 330 at timings based upon the phase of the AC power to be outputted in an operational region in which the frequency of the AC power to be outputted is higher than in the first operational region.

FIG.2

EP 2 355 319 A2

**Description**

The disclosure of the following priority application is herein incorporated by reference: International Patent Application No. PCT/JP2010/051963 filed February 10, 2010

The present invention relates to a power conversion device that converts DC power into AC power, or AC power into DC power.

A power conversion device that receives DC power and converts that DC power into AC power for supply to a rotating electrical machine incorporates a plurality of switching elements. The DC power that is supplied is converted into AC power by these switching elements repeatedly performing switching operation. Many such power conversion devices are also used for converting AC power that is generated by a rotating electrical machine into DC power by the switching operation of the above described switching elements. It is per se known to control the switching elements described above on the basis of a pulse width modulation method (hereinafter termed the "PWM method") that uses a carrier wave that varies at a constant frequency. By increasing the frequency of the carrier wave, the accuracy of control may be enhanced, and moreover there is an accompanying tendency for the torque generated by the rotating electrical machine to become smoother.

However, the power losses when the switching elements described above are changed over from their discontinuous states to their continuous states and from their continuous states to their discontinuous states become greater, and the amount of heat generated also becomes greater.

An example of such a power conversion device is disclosed in Japanese Laid-Open Patent Publication No. S63-234878.

It is desirable to reduce the power losses described above caused by the switching elements, when they perform their switching operation to change over from their discontinuous states to their continuous states, and to change over from their continuous states to their discontinuous states. By reducing the power losses, it is also possible to reduce the amount of heat generated by the switching elements. For this, it is desirable to reduce the number of times that the switching elements described above are switched. As described above, with a per se conventional PWM method, in order to reduce the number of times that the switching elements described above perform their switching operation per unit time, it is necessary to reduce the frequency of the carrier wave. However, if the frequency of the carrier wave is reduced, the distortion of the AC current outputted from the power conversion device becomes greater. This is also accompanied by increase of pulsations of the rotational torque generated by the AC motor on the basis of supply of this AC current.

One object of the present invention is to provide a power conversion device that is capable of supplying AC power in which increase of output torque pulsations of a three phase AC motor that receives AC power from this power conversion device can be suppressed as much as possible, and with which it is also possible to anticipate reduction of the switching losses. The embodiments explained hereinafter reflect the results of much desirable research for production of this power conversion device as a manufactured product, and solve various concrete problems that need to be solved for production as a manufactured product. Some such concrete problems that are solved by the concrete structure and operation of the embodiments described below will be explained hereinafter in connection with the description of those embodiments.

The present invention has at least one of the distinguishing characteristics described below.

According to one aspect of the present invention, a power conversion device includes an inverter circuit that includes a plurality of switching elements for receiving a supply of DC power and converting it into AC power that is supplied to an inductance load such as a three phase AC motor or the like, and/or a control circuit that controls the continuity and discontinuity of the above described switching elements. The control circuit controls the continuity operation and the discontinuity operation of the above described switching elements on the basis of the angle (phase) of the AC power that is to be produced by this conversion. With this type of structure, it is possible to reduce the number of times that the switching elements described above are switched.

According to another aspect of the present invention, in the power conversion device having the structure with the special characteristic described above, the control circuit controls the timings of the starts of continuity of the switching elements in the inverter circuit so as to synchronize them with the phase of the AC power to be outputted. Furthermore, control is performed so that the angle over which the continuous state of the switching elements is maintained continuously (hereinafter termed the "continuity maintenance angle") for a second modulation index that is relatively larger is increased as compared to that for a first modulation index that is relatively smaller, while the angle over which the intercepted or discontinuous state of the switching elements is maintained continuously (hereinafter termed the "discontinuity maintenance angle") is decreased for the second modulation index as compared to the first modulation index. Yet further, for a third modulation index that is even larger than the second modulation index described above, control is performed so that, when the above described discontinuity maintenance angle decreases down to a predetermined angle that is smaller than the angle at which the switching elements described above can operate, then the discontinuity interval disappears, and the previous continuity maintenance angle merges with the next continuity maintenance angle. By performing control in this manner, in addition to reducing the number of times that the switching elements described above are switched, also it is possible to increase the reliability.

According to yet another aspect of the present invention, a power conversion device includes an inverter circuit that includes a plurality of switching elements for receiving a supply of DC power and converting it into AC power that is supplied to an inductance load such as a three phase AC motor or the like, and/or a control circuit that outputs a control signal for controlling the continuity and discontinuity operation of the above described switching elements. The control circuit described above controls the continuity operation and the discontinuity operation of the switching elements described above on the basis of the phase of the AC power that is to be supplied. The control circuit described above controls the switching elements described above so that if, for approximately the same state of modulation index, the rotational speed of the rotating electrical machine that is a machine such as, for example, a permanent magnet type synchronous rotating electrical machine or an induction rotating electrical machine that operates as an inductance load becomes higher, or if the torque command value of the rotating electrical machine described above becomes greater, then the time intervals for switching operation of the switching elements described above become shorter. In other words if, for approximately the same state of modulation index, the frequency of the AC power for supply to the inductance load changes from a first frequency to within a range of around 1.5 to 2 times that first frequency, or if the torque command value increases to some extent within a predetermined range, then the switching elements are controlled so that the number of times that switching operation of the inverter circuit is performed per one cycle for generating the AC power described above does not change. It is possible to suppress the harmonic components by ensuring that the operating positions in which the above described inverter circuit goes to continuous and supplies current continuously to the load on the basis of the DC power are phase positions that are suitable for thus suppressing the harmonic components. By doing this, it is possible to reduce the switching losses while also suppressing, to the greatest practicable extent, distortion of the AC power resulting from conversion.

According to still another aspect of the present invention, the power conversion device is capable of selecting the orders of the harmonic components that are to be eliminated, and is able to prevent increase of the number of times that switching of the switching elements is performed per unit phase by not eliminating (or not selecting) certain harmonic components that do not need to be eliminated. For example, at phase positions of the AC output at which it is possible to reduce the harmonic component of the fifth order whose influence upon the operation of the rotating electrical machine is great, the inverter circuit may be made continuous, so that current from the DC power is supplied to the load at these phase positions. With this type of structure, according to this control method, it is possible to reduce the supply to the load of the harmonic component of the fifth order whose influence upon the operation of the rotating electrical machine is great.

According to even another aspect of the present invention, it is possible to reduce the number of times that switching of the switching elements is performed per unit phase, since the harmonic components of the orders that are to be eliminated are overlapped, and then are eliminated only once per unit phase, for example only once in the interval from 0 [radians] to $\pi$ [radians].

According to a further aspect of the present invention, a power conversion device includes a bridge circuit that includes a plurality of switching elements that constitute upper arms and lower arms for converting DC power that is supplied into three phase AC power for driving a rotating electrical machine, a control circuit for controlling the continuity and discontinuity of these switching elements, and/or a driver circuit that generates drive signals for causing the switching elements to go continuous and discontinuous. In a first interval, drive signals based upon the phase of the AC power to be outputted are supplied from the driver circuit to the switching elements, and/or the switching elements go continuous and discontinuous on the basis of these drive signals, so that AC current is supplied to the rotating electrical machine. Energy is accumulated in the rotating electrical machine in advance by the switching elements being made continuous in intervals obtained by the control circuit, and then, in second intervals, all of either the upper arms or the lower arms of the bridge circuit are made discontinuous while all of the other arms are made continuous, and thereby current continues to flow to the rotating electrical machine on the basis of the accumulated energy. The number of times that switching is performed can be reduced by providing the first interval and the second interval alternatingly.

According to even another aspect of the present invention, in a first operational region, the power conversion device supplies drive signals to the switching elements to control the switching operation of the switching elements on the basis of the phase of the AC power that it is desired to output, so that the switching elements are made continuous in correspondence with the phase of the AC power that is to be outputted. Furthermore, in a second operational region in which the frequency of the AC power to be outputted is lower than in the first operational region, PWM control is performed to control the continuity and discontinuity of the switching elements on the basis of a carrier wave. By employing this type of structure, along with reducing increase of the distortion in the second region, it is also possible to reduce the number of times that switching is performed in the first region, and thus it is possible to reduce losses of power.

According to still another aspect of the present invention, in addition to the above described specific features, an HM control mode in which the switching elements are controlled corresponding to the phase of the AC waveform to be outputted, and a sine wave PWM mode in which the switching elements are controlled on the basis of a carrier wave having a fixed period, on the basis of the rotational speed of the motor, or on the basis of the AC signal that is to be outputted.

According to still yet another aspect of the present invention, in addition to the specific characteristics described above, the HM control mode further includes a square wave control mode in which the switching elements for each phase are each turned ON and OFF once for each one rotation of the motor.

According to still another aspect of the present invention, with the above described power conversion device, in the HM control mode, at least one of the electrical angle position at which the first interval is defined and the length of the first interval is changed, so that a harmonic component of the AC current flowing to the motor is changed to a desired value, and transition to the square wave control mode is accomplished by thus changing this harmonic component.

And yet another specific feature of the present invention is that the power conversion device may be further provided with a means for compensating transient currents generated in the AC current flowing to the motor. This transient current compensation means is adapted to output a compensation pulse when changeover takes place between the HM control mode and the sine wave PWM control mode.

According to even another characteristic of the present invention, this transient current compensation means is adapted to output a compensation pulse when changeover takes place between the HM control mode and the sine wave PWM control mode, or, in addition thereto, when some predetermined condition is satisfied.

According to still another characteristic of the present invention, the power conversion device is further provided with a decision means that makes a decision as to whether or not it is possible to detect the rotational state of the motor, and a chopper control means that, on the basis of the decision result by the decision means, outputs a predetermined signal for single phase chopper control for creating the first interval and the second interval for each of the phases, irrespective of electrical angle.

According to yet another characteristic of the present invention, the period of the signal for single phase chopper control is determined according to the inductance of the motor.

According to still another characteristic of the present invention, a power conversion device includes a bridge circuit that includes a plurality of switching elements that make up upper and lower arms, a drive circuit that outputs drive signals for making the above described switching elements go continuous or discontinuous, and/or a controller for controlling the drive circuit; and/or, along with operating the switching elements in correspondence to the phase of the AC power that is to be converted from DC power, the continuous and discontinuous intervals of the switching elements are controlled on the basis of the modulation index.

And, according to even another characteristic of the present invention, with the characteristic described above, further a harmonic component of the AC current flowing to the motor is changed to a desired value, and, when the modulation index is a maximum, square wave control is performed in which the switching elements for each phase are turned ON and OFF once each for each one rotation of the motor.

According to the present invention, with a power conversion device, it is possible to suppress increase in torque pulsations to a certain extent, while at the same time reducing the switching losses.

It should be understood that in the embodiments described below, as will be explained hereinafter, various other problems have also been solved, as has been found desirable for production as a manufactured product.

BRIEF DESCRIPTION OF THE DRAWINGS

Fig. 1 is a figure showing control blocks of a hybrid electric vehicle;
Fig. 2 is a figure showing the structure of an electrical circuit;
Fig. 3 is a figure showing changeover between control modes;
Fig. 4 is a figure for explanation of PWM control and square wave control;
Figs. 5A and 5B are a pair of figures showing an example of harmonic components generated during square wave control;
Fig. 6 is a figure showing a motor control system with a control circuit according to a first embodiment of the present invention;
Fig. 7 is a figure showing the structure of a pulse generator;
Fig. 8 is a flow chart showing a procedure for pulse generation by table lookup;
Fig. 9 is a flow chart showing a procedure for pulse generation by real time calculation;
Fig. 10 is a flow chart showing a procedure for pulse pattern calculation;
Fig. 11 is a figure illustrating a method of generating pulses with a phase counter;
Fig. 12 is a figure showing examples of waveforms of a voltage between lines in the HM control mode;
Fig. 13 is an explanatory figure showing a case in which the widths of one pair of pulses of a voltage between lines are not equal to the widths of the other pulses in the pulse train;
Fig. 14 is another figure showing examples of waveforms of a voltage between lines in the HM control mode;

Fig. 15 is a figure showing examples of waveforms of phase voltages in the HM control mode;

Fig. 16 is a figure showing a conversion table between voltages between lines and phase terminal voltages;

Fig. 17 is a figure showing an example of conversion of pulses of a voltage between lines to phase voltage pulses, in the square wave control mode;

Fig. 18 is a figure showing an example of conversion of pulses of a voltage between lines to phase voltage pulses, in the HM control mode;

Figs. 19A and 19B are figures showing the magnitude of the amplitude of the fundamental wave of a pulse voltage between lines, and the magnitudes of the amplitudes of the harmonic components that are to be eliminated, as the modulation index is changed;

Fig. 20 is a figure showing an example of a waveform of a voltage between lines in the HM control mode;

Fig. 21 is a figure showing an example of a phase voltage waveform in the HM control mode;

Figs. 22A, 22B, 22C, 22D, and 22E are figures for explanation of a method of generating PWM pulse signals;

Fig. 23 is a figure showing examples of a waveform of a voltage between lines in the PWM control mode;

Fig. 24 is a figure showing examples of a phase voltage waveform in the PWM control mode;

Figs. 25A and 25B are figures for comparison of the pulse waveform of a voltage between lines due to an HM pulse signal with the pulse waveform of a voltage between lines due to a PWM pulse signal;

Fig. 26 is a figure showing the situation when changeover is performed between the PWM control mode and the HM control mode;

Figs. 27A and 27B are figures for explanation of the difference in pulse shapes between PWM control and HM control;

Figs. 28A, 28B, and 28C are figures showing the relationship between motor rotational speed and the pulse waveform of a voltage between lines due to an HM pulse signal;

Fig. 29 is a figure showing a relationship between the number of pulses of voltages between lines generated in HM control and in PWM control, and motor rotational speed;

Fig. 30 is a figure showing a flow chart for motor control performed by the control circuit according to the first embodiment of the present invention;

Fig. 31 is a figure showing a motor control system with a control circuit according to a second embodiment of the present invention;

Fig. 32 is a figure for explanation of generation of a compensation current;

Fig. 33 is a figure showing portions of a phase current waveform and a compensation pulse waveform of Fig. 32 as enlarged;

Fig. 34 is a flow chart of a procedure for motor control performed by the control circuit according to the second embodiment;

Fig. 35 is a flow chart showing a procedure for transient current compensation;

Fig. 36 is a figure showing a circuit model used for calculation of a phase voltage application time period;

Fig. 37 is a figure showing a motor control system with a control circuit according to a third embodiment of the present invention;

Fig. 38 is a figure showing an example of single phase chopper control;

Fig. 39 is a flow chart for motor control performed by the control circuit according to the third embodiment;

Figs. 40A, 40B, and 40C are explanatory figures for explanation of the operational theory of reduction of harmonic components;

Figs. 41A and 41B are explanatory figures for explanation of switching timings for switching elements in order to reduce harmonic components;

Fig. 42 is an explanatory figure for explanation of how a method for elimination of harmonic components may be viewed on the basis of Fourier series expansion;

Fig. 43 is an explanatory figure for explanation of a pattern of the voltage between lines for the U phase and the V phase, when third order, fifth order, and seventh order harmonic components have been eliminated; and

Fig. 44 is a figure showing the structure of a pulse modulator for performing PWM control.

DESCRIPTION OF THE PREFERRED EMBODIMENTS

In addition to the details described above, in the following embodiments, it has been possible to solve various problems that need to be resolved in connection with production as a manufactured product, and to obtain various desirable advantageous effects in connection with production as a manufactured product. Along with the following description of the details mentioned above, and of overlapping and closely related details, the solutions of certain concrete problems and certain concrete beneficial effects will be explained.

[Reduction of the frequency of switching of the switching elements]

With the power conversion devices explained in connection with the following embodiments, on the basis of the angle of the waveform of the AC power that is being converted from DC power, in other words on the basis of the phase, drive signals are supplied to switching elements incorporated in the inverter circuit from a drive circuit that operates according to control signals from a control circuit for controlling the switching operation of the switching elements, and the switching elements described above perform operation to go continuous or discontinuous in correspondence to the phase of the AC power that is converted. By providing a structure and operation that control the continuity operation of the switching elements incorporated in the above described inverter circuit in this manner in correspondence to the phase angle according to control signals from the control circuit, it is possible to reduce the number of switching operations of the switching elements described above per unit time, or the number of switching operations of the switching elements per one cycle of the AC power, as compared to a per se conventional PWM method. Furthermore with the structure described above the advantageous effect is obtained that, irrespective of whether or not the switching frequency of the switching elements of the inverter circuit is reduced, it is possible to suppress increase of distortion of the AC waveform that is outputted, and it is possible to reduce the loss entailed by the switching operation. This fact is linked to reduction of the generation of heat by the switching elements in a power switching circuit incorporated in the inverter circuit.

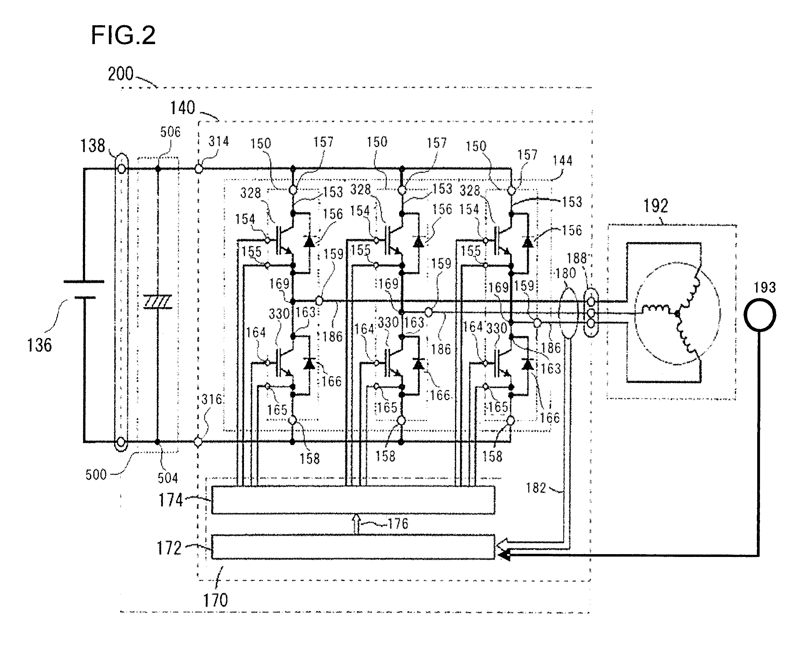

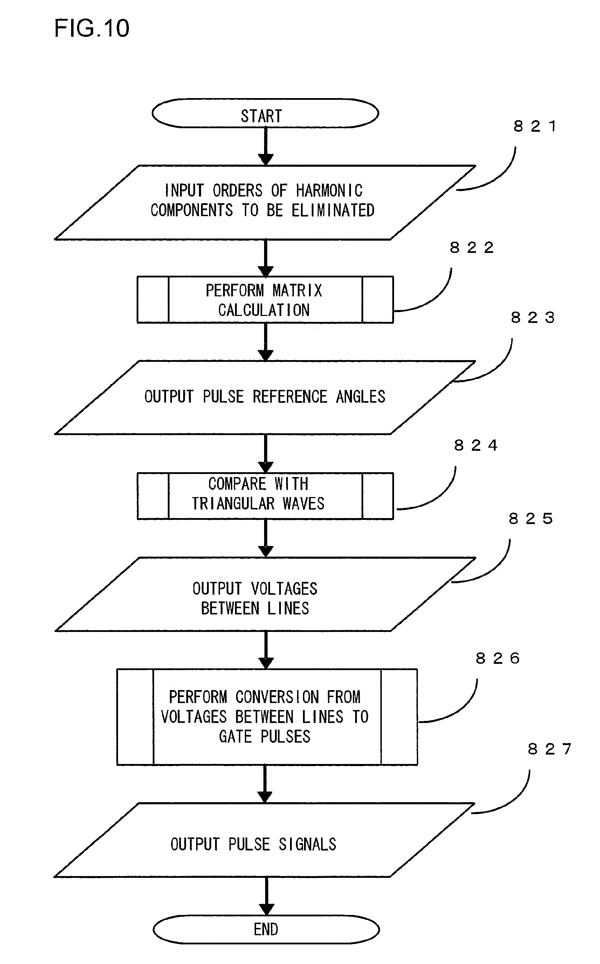

With the embodiments explained below, and in particular with the embodiments explained in connection with Figs. 10, 40A, 40B, 40C, 41A, and 41B, a selection is made of the number of orders of harmonic components that are to be eliminated. Since it is possible to select the number of orders of harmonic components to be eliminated to match the subject of application of the present invention in this manner, accordingly it is possible to prevent the number of orders of harmonic components to be eliminated from increasing to be more than necessary, and thereby it becomes possible to reduce the number of times that switching is performed for each unit phase of the switching elements of the power switching circuit. With a rotating electrical machine that includes a synchronous electric motor or an induction electric motor to which AC power is supplied upon which the negative influence of the harmonic components of low order is great, the very beneficial effect is also obtained of reduction of the harmonic components of comparatively low order in the outputted AC power, such as the fifth order harmonic component and the seventh order harmonic component. With the embodiments of the present invention, it is possible to reduce the fifth order harmonic component by supplying current from the DC power supply to the above described rotating electrical machine based upon continuity of the inverter, at least at the phase positions that are applied to reduction of the fifth order harmonic component. The DC power supply here is not only limited to being a battery in which DC power is accumulated; it could also be a smoothing capacitor, for example a capacitor module 500 shown in Fig. 2.

It should be understood that, for the switching elements, it is desirable to employ elements whose operating speed is high, and whose operation to go continuous and to go discontinuous can both be controlled on the basis of control signals: this type of element may, for example, be an insulated gate bipolar transistor (hereinafter referred to as an "IGBT") or a field effect transistor (such as a MOS transistor), and this type of element is preferable from the point of view of responsiveness and controllability.

The AC power outputted from the power conversion device described above is supplied to an inductance circuit included in a rotating electrical machine or the like, and AC current flows on the basis of its inductance operation. In the embodiments described below, examples will be cited and explained of rotating electrical machines that perform inductance circuit operation as motors or generators. From the point of view of benefits, the use of the present invention for generating AC power to operate such a rotating electrical machine is optimum, but the present invention can also be used as a power conversion device for supplying AC power to an inductance circuit other than a rotating electrical machine.

In the following embodiments, in a first operational region in which the rotational speed of the rotating electrical machine is high, the switching operation of the switching elements is generated on the basis of the phase of the AC waveform that is to be outputted, while on the other hand, in a second operational region in which the rotational speed of the rotating electrical machine is lower than in the above described first operational region, the above described switching elements are controlled according to a PWM method in which the operation of the switching elements is controlled on the basis of a carrier wave of a constant frequency. The stopped state in which the rotor of the above described rotating electrical machine is stationary may be included in the above described second operational region. It should be understood that in the following embodiments examples will be explained of the use of a motor-generator, that is a rotating electrical machine that can function both as a motor and a generator.

[Reduction of distortion of the outputted AC power]

With the method of controlling the switching elements included in an inverter to go continuous or discontinuous on the basis of the angle of the AC waveform that is to be outputted, in other words on the basis of the phase position, in the region in which the frequency of the AC power to be outputted is low, there is a tendency for distortion of the AC waveform to become great. In the explanation provided above, in the second region in which the frequency of the AC output is low, the PWM method is used and the switching elements are controlled on the basis of the elapsed time, while in the first region in which the frequency of the outputted AC power is higher than in the second region, the switching elements are controlled on the basis of the angle, in other words of the phase position (hereinafter this is termed "HM control"). By controlling the switching elements of the inverter circuit in this manner by using two different methods, the beneficial effect is obtained that it is possible to reduce distortion in the AC power that is outputted.

[The fundamental control]

In the embodiments explained below, as the fundamental control method, AC power is generated by the PWM control method as described above in the low rotational speed of the rotating electrical machine to which AC power is to be supplied, and, in a situation in which the rotational speed of the rotating electrical machine has been elevated, a transition takes place to control of generation of AC power by the HM control method as explained below. By doing this, it is possible to keep down the influence of distortion as much as possible, and thereby it is possible to implement enhancement of the efficiency.

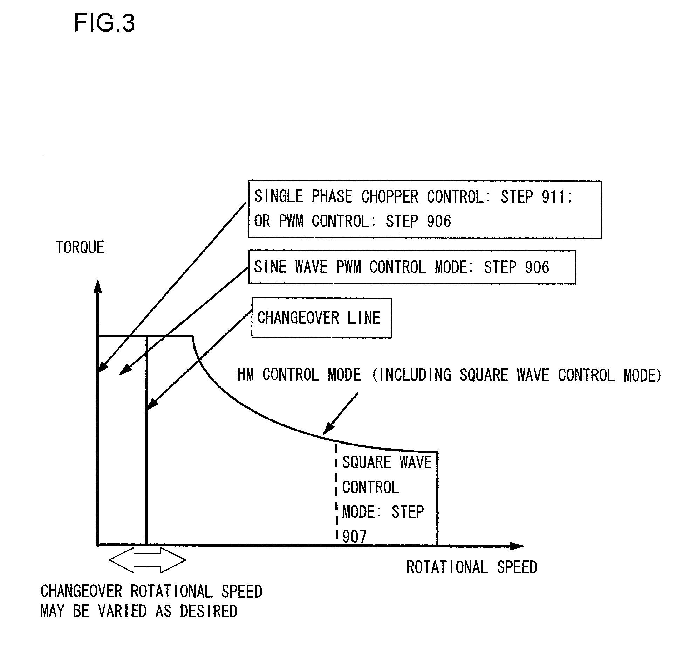

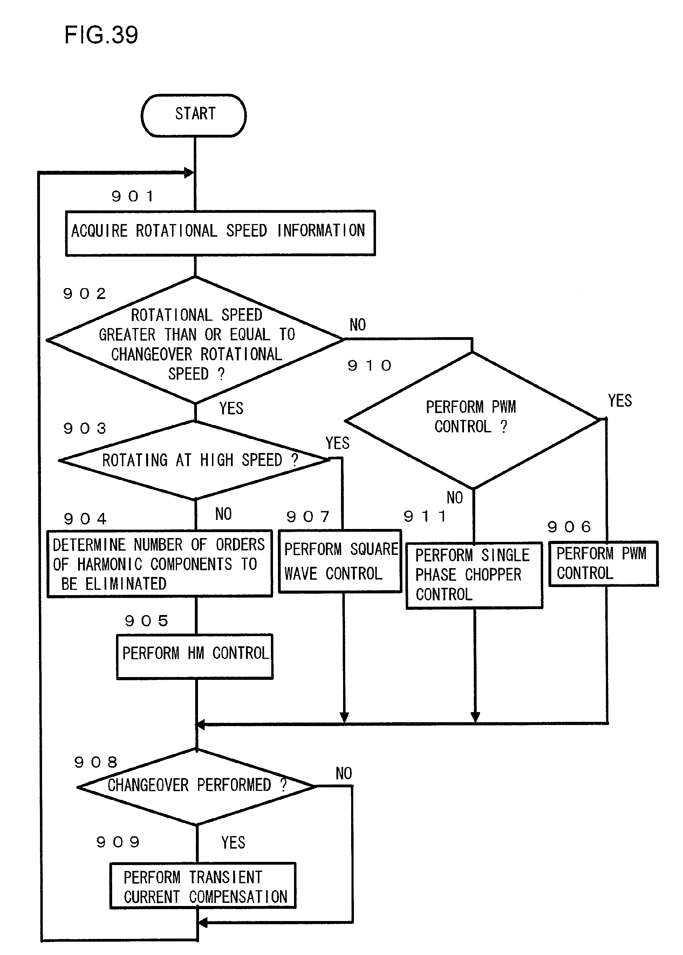

Moreover, with the above described fundamental control, chopper control as described in Figs. 3 and 39 is performed in the state in which the rotating electrical machine is stopped, and a transition is executed from chopper control to PWM control.

Furthermore, to view the fundamental control described above from another standpoint, as explained in connection with the embodiments described below, in the high speed operational state of the rotating electrical machine, a transition is executed within HM control to square wave control. With the HM control explained in the following, the switching timings are controlled in correspondence with the phase of the AC waveform that is to be outputted, and, as the modulation index becomes higher, the number of times that switching is performed in a half cycle of the AC power (from zero to $\pi$ of electrical angle, or from $\pi$ to $2\pi$) gradually decreases, and finally a transition is executed to square wave control in which continuity is only established once in each half cycle. In this manner, in the embodiments described below, there is the advantage that it is possible to transition smoothly to square wave control, and due to this the controllability is excellent.

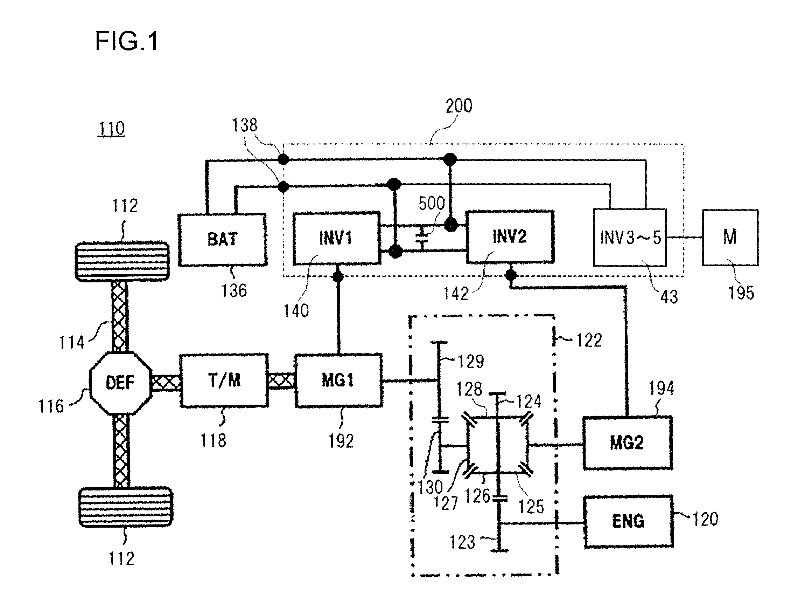

The details of power conversion devices according to embodiments of the present invention will be explained hereinafter with reference to the drawings. The power conversion device according to embodiments of the present invention are examples of application to power conversion devices that generate AC power for driving a rotating electrical machine in a hybrid electric vehicle (hereinafter termed an "HEV") or a pure electric vehicle (hereinafter termed an "EV"). The fundamental structure and control of a power control device for an HEV and of a power conversion device for an EV are fundamentally the same, and accordingly, as a representative example, the control structure and the circuit structure of the power conversion devices according to the following embodiments of the present invention will be explained in the case of application to an HEV, as shown in Figs. 1 and 2. Fig. 1 is a figure showing control blocks of an HEV.

The power conversion devices according to embodiments of the present invention will be explained in terms of onboard power conversion devices for an onboard electrical system that is mounted to an automobile. In particular, examples will be cited and explained of power conversion devices for driving a vehicle that are used in an electrical system for powering the vehicle, for which the mounting environment and the operational environment are very severe. A power conversion device for driving a vehicle is included in the electrical system for powering the vehicle, as a control device that drives a rotating electrical machine that powers the vehicle. This power conversion device for powering the vehicle converts DC power that is supplied from an onboard battery or from an onboard electricity generation device that constitutes an onboard power supply into predetermined AC power, and supplies this AC power that has been produced to the rotating electrical machine described above, thus driving that rotating electrical machine. Moreover since the above described rotating electrical machine, in addition to serving as an electric motor, is also endowed with the function of serving as a generator, accordingly the power conversion device described above not only converts DC power to AC power, but, according to the operational mode, also is capable of performing operation to convert AC power generated by the above described rotating electrical machine into DC power. This DC power thus obtained by conversion is supplied to the onboard battery.

It should be understood that the structure of this embodiment is optimized for powering a vehicle such as an automobile or a truck or the like. However, the present invention may also be applied to power conversion devices of other types; for example, the present invention could also be applied to a power conversion device for a train or a ship or an aircraft or the like, to a power conversion device for use in industry for generating electric power to be supplied to a rotating electrical machine that drives a machine in a workplace, or to a power conversion device for household use that is employed as a control device for an electric motor that drives a home solar electricity generating system or an item of household electrical equipment or the like.

The explanation below refers to the drawings. In Fig. 1, an HEV 110 is a single electrically operated vehicle that is equipped with two vehicle drive systems. One of these is an engine system that utilizes an engine 120 as its power source. The engine system is used as the principal drive source for driving the HEV 110. The other drive system is an onboard electrical system that utilizes two motor-generators 192 and 194 as power sources. This onboard electrical system is principally used as a drive power source for the HEV 110 and as an electrical power generating source for the HEV 110. The motor-generators 192 and 194 may be, for example, synchronous machines or induction machines, and since, in terms of their method of operation, they function both as motors and as generators, in this specification they will be termed "motor-generators".

Front wheel shafts 114 are rotatably supported at the front portion of the body of the vehicle. And a pair of front wheels 112 are provided at the ends of these front wheel shafts 114. Rear wheel shafts (not shown in the drawing) are rotatably supported at the rear portion of the vehicle body. And a pair of rear wheels (also not shown) are provided at the ends of these rear wheel shafts. While, with the HEV 110 of this embodiment, the so-called front wheel drive configuration is employed in which the main wheels that are powered by drive force are the front wheels 112, and the auxiliary wheels that free-wheel are the rear wheels (not shown), the present invention could also be applied to the reverse configuration, i.e. to an HEV that employs the rear wheel drive configuration.

A front wheel side differential gear system 116 (hereinafter termed the "front wheel DEF") is provided at the central portion between the two front wheel shafts 114. The front wheel shafts 114 are mechanically connected to output sides of this front wheel DEF 116. Furthermore, the output shaft of a speed change mechanism 118 is mechanically connected to an input side of the front wheel DEF 116. The front wheel DEF 116 is a differential type drive force distribution mechanism that distributes the rotational drive force transmitted and speed-changed by the speed change mechanism 118 between the left and right front wheel shafts 114. The output side of the motor-generator 192 is mechanically connected to the input side of the speed change mechanism 118. Furthermore, the output side of the engine 120 and the output side of the motor-generator 194 are mechanically connected to the input side of the motor-generator 192 via a drive force distribution mechanism 122. It should be understood that the motor-generators 192 and 194 and the drive force distribution mechanism 122 are housed in the interior of the casing of the speed change mechanism 118.

The motor-generators 192 and 194 are synchronous machines whose rotors incorporate permanent magnets. Drive control of each of the motor-generators 192 and 194 is performed by AC power that is supplied to its fixed armature winding being controlled by a respective power conversion device 140, 142. A battery (BAT) 136 is electrically connected to the power conversion devices 140 and 142. Accordingly mutual transfer of power can be performed between the battery 136 and the power conversion devices 140 and 142.

The HEV 110 of this embodiment includes two grouped electric drive / generator units, i.e. a first electric drive / generator unit that includes the motor-generator 192 and the power conversion device 140, and a second electric drive / generator unit that includes the motor-generator 194 and the power conversion device 142; and usage is divided between these according to the current operational state. In other words, when the vehicle is being driven by the drive force from the engine 120, if the drive torque of the vehicle is to be assisted, the second electric drive / generator unit is operated as an electricity generation unit by the drive force from the engine 120, while the first electric drive / generator unit is operated as an electrical drive unit using the power that is generated in this way. Moreover, in a similar way, if the speed of the vehicle is to be assisted, the first electric drive / generator unit is operated as an electricity generation unit by the rotational force from the engine 120, while the second electric drive / generator unit is operated as an electrical drive unit using the power that is generated in this way.

Furthermore, with this first embodiment, it is possible to operate the first electric drive / generator unit as an electrical drive unit using the power of the battery 136, so as to drive the vehicle only with the drive force of the motor-generator 192. Yet further, with this first embodiment, it is possible to operate either the first electric drive / generator unit or the second electric drive / generator unit as an electricity generation unit with power from the engine 120, or with power from the vehicle wheels, so as to charge up the battery 136.

The battery 136 is also used as a power supply for driving an auxiliary machinery motor 195. In such auxiliary machinery there may be incorporated, for example, a motor that drives a compressor for an air conditioner, or a motor that drives a hydraulic pump for control. DC power is supplied from the battery 136 to the power conversion device 43, and is converted into AC power by the power conversion device 43 and supplied to the motor 195. This auxiliary machinery power conversion device 43 is endowed with a function similar to that of the power conversion devices 140 and 142 for driving the vehicle, and controls the phase, the frequency, and the power of the AC that it supplies to the motor 195. For example, the motor 195 generates torque due to the supply of AC power that has a phase leading with respect to the rotation of the rotor of the motor 195. Conversely, by AC power having a delayed phase being generated, the motor 195 operates as a generator, so that the motor 195 performs regenerative braking operation. The control function of this type for the power conversion device 43 is the same as the control functions for the power conversion devices 140 and 142. The maximum conversion power of the power conversion device 43 is smaller than those of the power conversion devices 140 and 142 since the capacity of the motor 195 is smaller than the capacities of the motor-generators 192 and 194. However, the circuit structure and the operations of the power conversion device 43 are fundamentally the same as the circuit structures and the operations of the power conversion devices 140 and 142.

Furthermore, a capacitor module 500 is in close electrical relationship with the power conversion devices 140, 142 and 43. Moreover, these devices all have the common feature of needing countermeasures against generation of heat. Yet further, it is desirable to make the volumes of the power conversion devices as small as possible. From these points of view, in the power conversion device that is described in detail hereinafter, the power conversion devices 140 and 142, the power conversion device 43, and the capacitor module 500 are housed within the chassis of the power conversion device. With this type of structure, it is possible to implement a system that is compact and whose reliability is high.

Yet further, by housing the power conversion devices 140 and 142, the power conversion device 43, and the capacitor module 500 within a single chassis, the beneficial effect is obtained that it is possible to simplify the wiring and to implement countermeasures against noise. Yet further, it is possible to reduce the inductances in the circuitry that connects the capacitor module 500, the power conversion devices 140 and 142, and the power conversion device 43, and due to this not only is it possible to prevent the generation of spike voltages, but also it is possible to anticipate reduction of heat generation and enhancement of heat dissipation efficiency.

Next, the circuit structure of the power conversion devices 140 and 142 and the power conversion device 43 will be explained using Fig. 2. It should be understood that, in the embodiment shown in Figs. 1 and 2, an example is presented in which each of the power conversion devices 140, 142, and 43 has its own individual structure. However, each of the power conversion devices 140, 142, and 43 has similar circuit structure and operates in a similar manner and has similar functions. Accordingly here the power conversion device 140 will be explained as a representative example.

The power conversion device 200 according to this embodiment includes the power conversion device 140 and the capacitor module 500. The power conversion device 140 includes a power switching circuit 144 and a control unit 170. Furthermore, the power switching circuit 144 includes a plurality of switching elements that operate as upper arms and a plurality of switching elements that operate as lower arms. In this embodiment, IGBTs (Insulated Gate Bipolar Transistor) are used as these switching elements. The IGBTs 328 that operate as upper arms are connected in parallel with diodes 156, while the IGBTs 330 that operate as lower arms are connected in parallel with diodes 166. An intermediate point (i.e. an intermediate electrode) 169 of each of a plurality of upper and lower arm series circuits 150 (in the example shown in Fig. 2, three such upper and lower arm series circuits 150, 150, 150) is connected via an AC terminal 159 to an AC power line (i.e. an AC bus bar) 186 that leads to the motor-generator 192. The control unit 170 also includes a driver circuit 174 that controls the operation of the power switching circuit 144, and a control circuit 172 that supplies a control signal to the driver circuit 174 via a signal line 176.

The IGBTs 328 and 330 in the upper and lower arms are switching elements, and are operated by drive signals received from the control unit 170 so as to convert DC power supplied from the battery 136 into three phase AC power. This power that has been converted is supplied to the armature windings of the motor-generator 192. As described above, the power conversion device 140 is capable of converting the three phase AC power generated by the motor-generator 192 into DC power.

The power conversion device 200 according to this embodiment incorporates, as shown in Fig. 1, not only the power conversion devices 140 and 142, but also the power conversion device 43 and the capacitor module 500. Since, as described above, the power conversion devices 140 and 142 and also the power conversion device 43 have similar structures, here the power conversion device 140 will be described as a representative, and description of the power conversion device 142 and the power conversion device 43 will be omitted since it will already have been described.

The power switching circuit 144 is built as a three phase bridge circuit. A DC positive terminal 314 and a DC negative terminal 316 are respectively electrically connected to the positive electrode side and the negative electrode side of the battery 136. The upper and lower arm series circuits 150, 150, 150 for each of the three phases are electrically connected in parallel between the DC positive terminal 314 and the DC negative terminal 316. Here, the upper and lower arm series circuits 150 will be termed "arms". Each of these arms includes an upper arm side switching element 328 and a diode 156, and a lower arm side switching element 330 and a diode 166.

In this embodiment, an example will be described in which the IGBTs 328 and 330 are used as the switching elements. The IGBTs 328 and 330 have respective collector electrodes 153 and 163, emitter electrodes (respective signal emitter electrode terminals) 155 and 165, and gate electrodes (respective gate electrode terminals) 154 and 164. Diodes 156 and 166 are respectively electrically connected in parallel between the collector electrodes 153 and 163 of the IGBTs 328 and 330 and their emitter electrodes, as shown in the figure. Each of the diodes 156 and 166 has two electrodes, a cathode electrode and an anode electrode. The cathode electrodes are electrically connected to the collector electrodes of the IGBTs 328 and 330 while the anode electrodes are electrically connected to the emitter electrodes of the IGBTs 328 and 330, so that the forward directions of the diodes 156 and 166 are in the directions from the emitter electrodes of the IGBTs 328 and 330 towards their collector electrodes. It would also be acceptable to use MOSFETs (Metal Oxide Semiconductor Field Effect Transistors) as these switching elements. In such a case, the diodes 156 and 166 would not be required.

The upper and lower arm series circuits 150 are provided for each of three phases, corresponding to each of the phases of the AC power supplied to the three phase motor-generator 192, and the connection points 169 between the emitter electrodes of the IGBTs 328 and the collector electrodes of the IGBTs 330 are used for outputting the U phase, the V phase, and the W phase of the AC power. Via the AC terminals 159 and the connector 188, the connection points 169 described above for each of the three phases are connected to the armature windings of the motor-generator 192 (in the case of a synchronous electric motor, the stator windings) for the U phase, the V phase, and the W phase, and thereby currents for the U phase, the V phase, and the W phase flow in the above described armature windings. In each pair, the upper and lower arm series circuits 150 are connected in parallel. The collector electrodes 153 of the upper arm IGBTs 328 are each electrically connected via DC bus bars or the like to the positive pole side capacitor electrodes of the capacitor module 500 via the positive terminals 157 (i.e. the P terminals), while the emitter electrodes of the lower arm IGBTs 330 are each electrically connected to the negative pole side capacitor electrode of the capacitor module 500 via the negative terminals 158 (i.e. the N terminals).

The capacitor module 500 acts as a smoothing circuit for suppressing fluctuations of the DC voltage generated by the switching operation of the IGBTs 328 and 330. Via DC connectors 138, the positive pole side of the battery 136 is connected to the positive pole side capacitor electrode of the capacitor module 500, while the negative pole side of the battery 136 is connected to the negative pole side capacitor electrode of the capacitor module 500. Due to this, the capacitor module 500 is connected between the collector electrodes 153 of the upper arm IGBTs 328 and the positive electrode side of the battery 136, and between the emitter electrodes of the lower arm IGBTs 330 and the negative pole side of the battery 136, so as to be electrically connected to the battery 136 and to the upper and lower arm series circuits 150 in parallel.

The control unit 170 performs control for operating the IGBTs 328 and 330 to make them continuous and discontinuous, and includes a control circuit 172 that generates timing signals for controlling the timings at which the IGBTs 328 and 330 are switched on the basis of information that is inputted from other control devices or sensors or the like, and a drive circuit 174 that generates drive signals for causing this switching operation of the IGBTs 328 and 330 on the basis of these timing signals output from the control circuit 172.

The control circuit 172 includes a microcomputer that performs processing for calculating the switching timings for the IGBTs 328 and 330. As input information, a target torque value that is requested for the motor-generator 192, values of the currents being supplied to the armature windings of the motor-generator 192 from the upper and lower arm series circuits 150, and the position of the magnetic poles of the rotor of the motor-generator 192, are input to this microcomputer. The target torque value is a value based upon a command signal output from a higher level control device not shown in the figures. And the current values are values that are determined on the basis of detection signals output from a current sensor 180. Moreover, the magnetic pole position is a value that is determined on the basis of a detection signal output from a magnetic pole rotation sensor not shown in the figures that is provided to the motor-generator 192. While in this embodiment an example is described in which the AC current value for each of the three phases is detected, it would also be acceptable to arrange to detect AC current values for only two of the phases.

The microcomputer incorporated in the control circuit 172 calculates current command values for the d and q axes of the motor-generator 192 on the basis of the target torque value, and then calculates voltage command values for the d and q axes on the basis of the differences between the current command values for the d and q axes that are the result of the above calculation and the current values for the d and q axes that have been detected, and generates drive signals in pulse form from these voltage command values for the d and q axes. As will be described hereinafter, the control circuit 172 has the function of generating drive signals according to two different methods. One or the other of these two methods is selected, on the basis of the state of the motor-generator 192, i.e. its inductance load, or on the basis of the frequency of the AC power to which it is desired to perform conversion, or the like.

One of the two methods described above is a modulation method (hereinafter referred to as the HM method) in which the switching operation of the IGBTs 328 and 330, that are the switching elements, is controlled on the basis of phase of the AC waveform that it is desired to output. And the other of the two methods described above is the per se known PWM (Pulse Width Modulation) method.

When driving a lower arm, the driver circuit 174 amplifies the modulated pulse signal and outputs it as a drive signal to the gate electrode of the IGBT 330 of the corresponding lower arm. Furthermore, when driving an upper arm, it amplifies the modulated pulse signal after having shifted the level of the reference potential of this modulated pulse signal to the level of the reference potential of the upper arm, and outputs it as a drive signal to the gate electrode of the IGBT 328 of the corresponding upper arm. Due to this, each of the IGBTs 328 and 330 performs switching operation on the basis of the drive signal that is inputted to it. By the switching operation of the IGBTs 328 and 330 that is performed in this manner according to the drive signals from the control unit 170, the power conversion device 140 converts the voltage that is supplied from the battery 136, which constitutes a DC power supply, into output voltages for the U phase, the V phase, and the W phase spaced apart by $2\pi/3$ radians of electrical angle, and supplies these output voltages to the motor-generator 192, which is a three phase AC motor. It should be understood that the electrical angle is a quantity that corresponds to the rotational state of the motor generator 192, i.e. in concrete terms to the rotational position of its rotor, and is a cyclic quantity that varies between 0 and $2\pi$. By using this electrical angle as a parameter, it is possible to determine the switching states of the IGBTs 328 and 330, in other words the output voltages for the U phase, the V phase, and the W phase, according to the rotational state of the motor-generator 192.

Moreover, the control unit 170 performs detection of anomalies such as excess current, excess voltage, excess temperature and so on, and thereby protects the upper and lower arm series circuits 150. For this purpose, sensing information is inputted to the control unit 170. For example, information about the current that flows to the emitter electrode of each of the IGBTs 328 and 330 is inputted from the signal emission electrode terminals 155 and 165 of each arm to the corresponding drive unit (IC). Based upon this, each of the drive units (ICs) performs excess current detection, and, if it has detected excess current, stops the switching operation of the corresponding IGBT 328 or 330, thus protecting the corresponding IGBT 328 or 330 from excessive current. Furthermore, information about the temperatures of the upper and lower arm series circuits 150 is inputted to the microcomputer from temperature sensors (not shown in the figures) that are provided to the upper and lower arm series circuits 150. Yet further, information about the voltages at the DC positive electrode sides of the upper and lower arm series circuits 150 is inputted to the microcomputer. The microcomputer performs excess temperature detection and excess voltage detection on the basis of this information, and, if it detects excess temperature or excess voltage, stops the switching operation of all of the IGBTs 328 and 330, thus protecting the upper and lower arm series circuits 150 (and also the semiconductor modules that include these circuits 150) from excess temperature and excess voltage.

In Fig. 2, the upper and lower arm series circuits 150 are series circuits of the upper arm IGBTs 328 and the upper arm diodes 156, and series circuits of the lower arm IGBTs 330 and the lower arm diodes 166. And the IGBTs 328 and 330 are switching semiconductor devices. The operation of the IGBTs 328 and 330 of the upper and lower arms of the power conversion device circuit 144 to go continuous and discontinuous is changed over in a fixed order. And the current in the stator windings of the motor-generator 192 during this changeover flows in the circuits constituted by the diodes 156 and 166.

As shown in Fig. 2, the upper and lower arm series circuits 150 have: positive terminals (P terminals) 157, negative terminals (N terminals) 158, AC terminals 159 from the connection points 169 of the upper and lower arms, upper arm signal terminals (signal emission electrode terminals) 155, upper arm gate electrode terminals 154, lower arm signal terminals (signal emission electrode terminals) 165, and lower arm gate electrode terminals 164. Furthermore, the power conversion device 200 has the DC connector 138 at its input side and the AC connector 188 at its output side, and is connected to the battery 136 and the motor-generator 192 via these two connectors 138 and 188, respectively. Furthermore, it would also be acceptable to provide power conversion devices having a circuit structure in which, for each phase, two upper and lower arm series circuits are connected in parallel, as circuits that generate the output for each phase of the three phase AC to be outputted to the motor-generator.

Fig. 3 is a graph showing the relationship between the maximum torque that can be outputted by the rotating electrical machine and the rotational speed of the rotating electrical machine. The changing over between the control modes that is performed by the power conversion device 140 will now be explained with reference to this Fig. 3. The power conversion device 140 employs either the PWM control method or the HM control method that will be described hereinafter, while changing over between them according to the rotational speed of the motor-generator 192, or according to the frequency of the AC power to be outputted. Fig. 3 shows the way in which the power conversion device 140 changes over between these control methods. It should be understood that the rotational speed at which changeover between the control methods is performed may be varied as desired. For example, if the automobile is starting to move from the stopped state, then it is necessary for the motor-generator 192 to generate a large torque in the stopped state. Furthermore, smooth starting off from rest and acceleration are desirable in order for the driver and passengers to experience a high level of comfort from the vehicle. On the other hand, in the state in which motor rotation is stopped, either PWM control or chopper control is performed for controlling the AC current supplied to the stator of the rotor in correspondence to the torque that is requested. And transition to PWM control is executed as the rotational speed of the motor-generator 192 rises.

It is desirable to reduce the distortion of the AC power supplied to the motor-generator 192 in order to implement smooth acceleration when the vehicle is starting off from rest and during acceleration, and in this case the switching operation of the switching elements incorporated in the power switching circuit 144 is controlled by the PWM control method. With the HM control explained hereinafter, there is a problem with controllability in very low speed states of the rotational speed of the motor-generator 192 including its stopped state, and also there is a tendency for the distortion of the AC power waveform to become large; but it is possible to compensate for this type of shortcoming by combining the HM control method with the PWM control method, or by further adding chopper control.

In the low speed operational state of the motor-generator 192, there is a limit upon the AC current that can be supplied, and control is performed to limit the maximum torque that is generated. Along with increase of the rotational speed of the motor-generator 192, its internally induced voltage rises, and there is a tendency towards decrease of the amount of current supplied. Due to this, there is a tendency for the output torque of the motor-generator 192 to decrease when the rotational speed increases. In recent years there has been a tendency for the maximum rotational speed demanded from the motor-generator to become higher, and, if a rotational speed higher than around 15,000 rpm is required, then HM control becomes very effective at medium and high rotational speeds.

The rotational speed at which the motor-generator is changed over between control according to the PWM method and control according to the HM method is not to be considered as being particularly limited; for example, it may be considered to perform control according to the PWM method at rotational speeds less than or equal to 700 rpm, while performing control according to the HM method at rotational speeds higher than 700 rpm. The range from 1500 rpm to 5000 rpm is an operational region in which control according to the HM method is particularly appropriate, and, in this region, the beneficial effect obtained for reduction of switching losses in the switching elements by employing the HM method as contrasted to using the PWM method is very great. Moreover, this operational region is an operational region that is much used for traveling in urban areas, and control according to the HM method provides a great beneficial effect in this operational region that is closely related to our daily lives.

In this embodiment, the mode of control according to the PWM control method (hereinafter termed the "PWM control mode) is used in the region in which the rotational speed of the motor-generator 192 is comparatively low, while on the other hand the mode of control according to the HM control method that will be described hereinafter is used in the region in which the rotational speed is comparatively high. In the PWM control mode, as previously described, the power conversion device 140 performs control using a PWM signal. In other words, voltage command values for the d and q axes of the motor-generator 192 are calculated by the microcomputer within the control circuit 172 on the basis of the target torque value that is inputted, and these are converted to voltage command values for the U phase, the V phase, and the W phase. And, for each phase, a sine wave corresponding to the voltage command value is taken as a fundamental wave, this is compared with a triangular wave of a predetermined period that constitutes a carrier wave, and a modulated wave in pulse form having a pulse width determined on the basis of the result of this comparison is outputted to the driver circuit 174. Thus, by outputting a drive signal corresponding to this modulated wave from the driver circuit 174 to the IGBTs 328 and 330 that correspond respectively to the upper and lower arms of each phase, the DC voltage outputted from the battery 136 is converted into three phase AC voltage, and is supplied to the motor-generator 192.

The details of HM control will be explained hereinafter. The modulated waves generated by the control circuit 172 in the HM control mode are outputted to the driver circuit 174. Due to this, drive signals corresponding to these modulated waves are outputted from the driver circuit 174 to the IGBTs 328 and 330 that correspond to each of the phases. As a result, the DC voltage outputted from the battery 136 is converted into three phase AC voltage, and is supplied to the motor-generator 192.

When converting DC power into AC power using switching elements, as in the case of the power conversion device 140, it is possible to reduce the switching losses by reducing the number of times switching is performed per unit time or per predetermined phase of the AC power; but the obverse is that the torque pulsations increase since there is a tendency for more harmonic components to be included in the AC power that is produced, so that there is a possibility that the responsiveness of motor control deteriorates. Thus, with the present invention, control is performed by changing over between the PWM control mode and the HM control mode as described above according to the frequency of the AC power to which conversion is desired or according to the rotational speed of the motor that is correlated with this frequency; in other words the HM control method is applied in the high rotational speed region in which it is unlikely that serious influence will be experienced from the low order harmonic components, while the PWM control method is applied in the low rotational speed region in which it is quite likely for torque pulsations to be generated. By doing this, it is possible to suppress increase of torque pulsations to a comparatively low level, while at the same time it is possible to reduce the switching losses.

It should be understood that the state of control of the motor for which the number of times of switching per unit time or per unit cycle of the AC power that is outputted becomes a minimum, is the state in which control is performed by square waves, in which the switching elements for each of the phases are turned ON and OFF once per each half cycle of the AC power supplied to the motor. This state of control by square waves may, in the HM control method described above, be considered as being the final state reached by reduction of the number of times of switching per half cycle according to increase of the modulation index of the AC power waveform that is converted, and thus as being one type of state of control by the HM control method. This point will be explained in detail hereinafter.

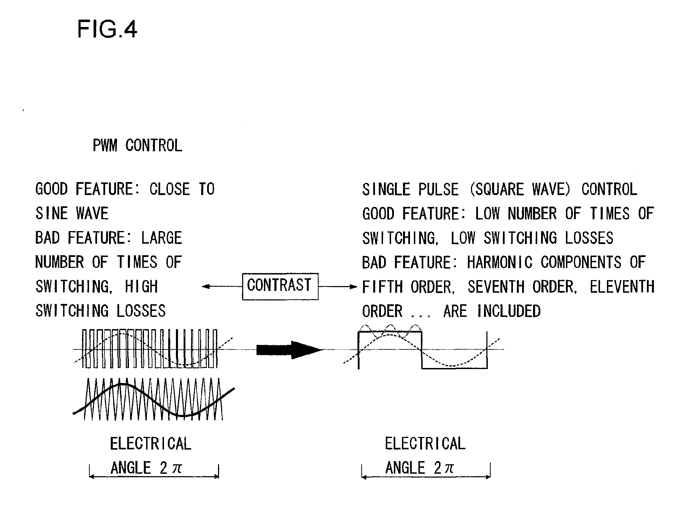

Next, in order to explain the HM control method, first control according to the PWM method and square wave control will be explained with reference to Fig. 4. In the case of PWM control, this is a method of controlling the switching elements to go continuous and interrupted at timings that are determined on the basis of comparison of the magnitudes of a carrier wave of constant frequency and of the AC waveform that is it desired to output. By using PWM control it is possible to supply to the motor AC power having a low level of pulsations, and it becomes possible to control the motor so that the level of torque pulsations is low. On the other hand, there is the shortcoming that the switching losses are large, because the number of times switching is performed per unit time or per each cycle of the AC waveform is great. By contrast, as an extreme example, if control of the switching elements is performed using square waves that consist of single pulses, then it is possible to minimize the switching losses since the number of times of switching is very low. But the obverse of this is that, if the influence of the inductance of the load is ignored, the AC waveform that has been obtained by conversion reaches the shape of a square wave, and it is possible to view this as being as a sine wave with the addition of harmonic components of the fifth order, the seventh order, the eleventh order... and so on. When such a square wave is Fourier expanded, in addition to the basic sine wave, harmonic components of the fifth order, the seventh order, the eleventh order... and so on appear. These harmonic components generate current distortions, that in their turn cause torque pulsations. In this manner, PWM control and square wave control exhibit a mutually contrasting relationship of benefits and disadvantages.

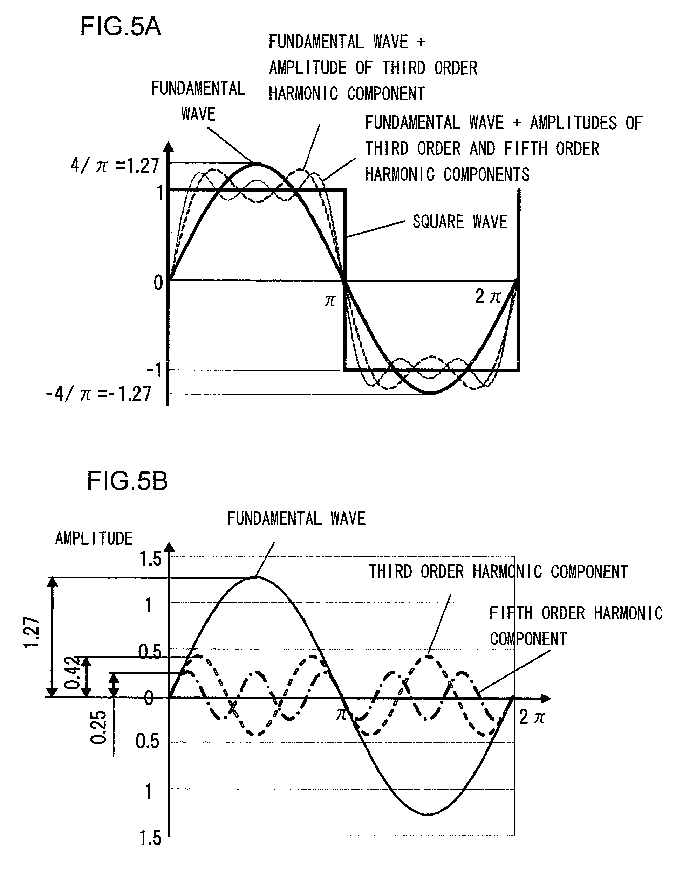

If it is supposed that control to make the switching elements go continuous and interrupted is performed according to a square wave pattern, then an example of the harmonic components in the generated AC power is shown in Figs. 5A and 5B. Fig. 5A is an example in which an AC waveform that varies in a square wave pattern has been decomposed into a sine wave (this is the fundamental wave) and harmonics of the fifth order, the seventh order, the eleventh order, .... and so on. The Fourier series expansion of the square wave shown in Fig. 5A is as given by Equation (1):

$$f(\omega t) = 4/\pi \times \{\sin\omega t + (\sin 3\omega t)/3 + (\sin 5\omega t)/5 + (\sin 7\omega t)/7 + ...\} \qquad (1)$$

Equation (1) shows that the square wave shown in Fig. 5A is made up from the fundamental sine wave given by $4/\pi \sin(\omega t)$ and components of the third order, the fifth order, the seventh order... and so on, that are its harmonic components. It will be understood that, by combining higher order harmonic components with the fundamental wave in this manner, the result can be made to approach arbitrarily close to a square wave.

Fig. 5B shows the situation when the amplitudes of the fundamental wave, the third order harmonic component, and the fifth order harmonic component are compared together. If the amplitude of the square wave of Fig. 5A is taken as unity, then the amplitude of the fundamental wave is 1.27, the amplitude of the third order harmonic component is 0.42, and the amplitude of the fifth order harmonic component is 0.25. Since the amplitude of each harmonic component becomes smaller in this manner as its order becomes higher, it will be understood that the influence that it exerts upon square wave control also becomes smaller. In particular in connection with the influence of the various harmonic components upon a rotating electrical machine, the influence of the fifth order harmonic component is large because it is of relatively low order. Here, it should be noted that in a three phase AC motor the mutual influences of the third order harmonic components (that are the ones of lowest order) for the three phases operate to cancel one another out, and accordingly the influence of harmonic components whose orders are multiples of three does not cause any hindrance to operation. Because of this, it is the fifth order harmonic component, whose amplitude is relatively large, that exerts the greatest influence. The next harmonic component that exerts an influence is the seventh harmonic component, and (since the ninth harmonic component exerts no influence due to the phenomenon described above) the eleventh order harmonic component is the next one that exerts an influence. There is a tendency for yet higher order harmonic components to exert less and less influence, the higher their order becomes. However, depending upon the characteristics of the rotating electrical machine, sometimes it is the fifth order harmonic component, the seventh order harmonic component, or the eleventh order harmonic component whose influence becomes the most significant.

In consideration of torque pulsations that may be generated when the switching elements are made continuous and discontinuous according to a square wave pattern, by leaving those higher order harmonic components whose influence is small and ignoring their influence, while eliminating those lower order harmonic components whose influence is large, it is possible to implement a power converter that can reduce switching losses and moreover can keep the increase of torque pulsations to a low level. With the HM control employed in this embodiment, AC power is outputted in which the harmonic components included in square wave AC current are more or less reduced according to the state of control, and by doing this the influence of torque pulsations upon the motor control is reduced, while on the other hand it is arranged to reduce the switching losses by allowing certain harmonic components to be included within a range for which no problem actually arises in practice. As described above, in this specification, this type of control method is referred to as the HM control method.

Furthermore, in the following embodiments, it is arranged to use the PWM control method in a state in which, with the HM control method, AC power of low frequency would be outputted in which the influence of harmonic components would be large, or that would provide poor controllability. In concrete terms, it is desirable to perform motor control by changing over between PWM control and HM control as appropriate according to the rotational speed of the motor, so that control is performed using the PWM method in the low rotational speed region, while control is performed using the HM method in rotational speed regions where the rotational speed is higher than in the low rotational speed region.

Next, the structure of the control circuit 172 for implementing the control described above will be explained. Methods of three different types for motor control will be explained as control methods performed by this control circuit 172 provided to the power conversion device 140, and, in the following, these three methods for motor control will be explained in connection with first, second, and third embodiments of the present invention. It should be understood that, in the concrete structure of the embodiments, the fundamental operation of the control circuit is performed in software by processing by a microcomputer that operates according to a control program, but, for the convenience of explanation and understanding, the operation of the microcomputer will be considered as being separated into functional blocks, and the explanation will be made in terms of the actual hardware existence of circuit blocks corresponding to these functions, that in fact would be an alternative possibility for implementation.

- The first embodiment -

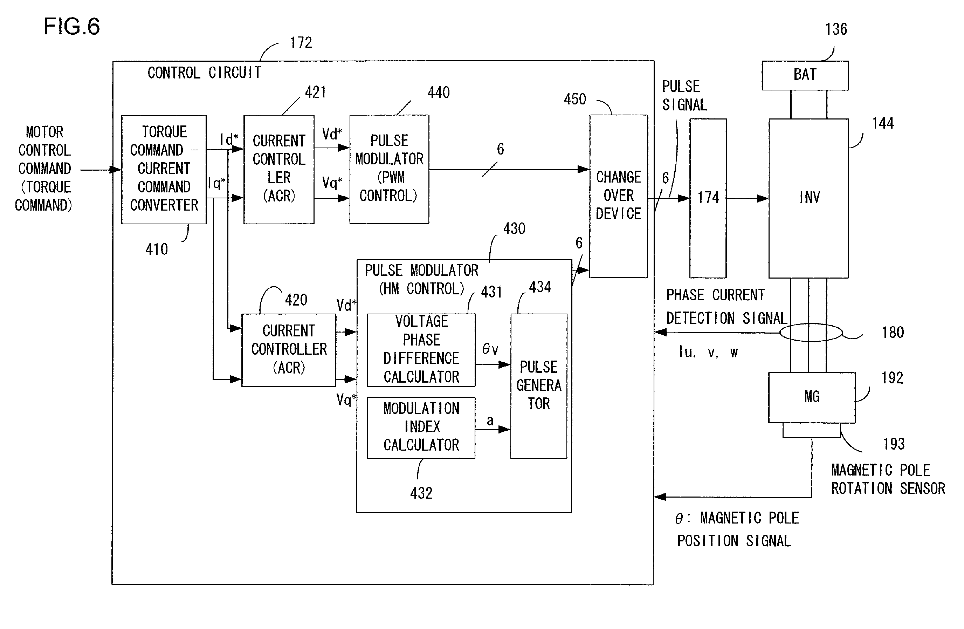

A block diagram in which the functions of the motor control system employing this control circuit 172 according to the first embodiment of the present invention are shown as functional blocks is given in Fig. 6. A control command for the motor-generator 192, for example a torque command T* that provides a target torque value, is inputted to the control circuit 172 by a higher level control device that controls the vehicle. Using data in a torque /rotational speed map that has been stored in advance, a torque command to current command converter 410 converts a torque command to a d axis current command signal Id* and a q axis current command signal Iq* on the basis of this torque command T* that has been inputted and rotational speed information according to a magnetic pole position signal θ detected by a magnetic pole rotation sensor 193. The d axis current command signal Id* and the q axis current command signal Iq* thus produced by the torque command to current command converter 410 are respectively outputted to current controllers (ACRs) 420 and 421.

On the basis of the d axis current command signal Id* and the q axis current command signal Iq* outputted from the torque command to current command converter 410, and on the basis of Id and Iq current signals obtained by phase current detection signals lu, lv, and lw for the motor generator 192 detected by the current sensor 180 being converted to d and q axes by a three phase / two phase converter, not shown in the figures but incorporated in the control circuit 172, according to the magnetic pole position signal from a rotation sensor, the current controllers (ACRs) 420 and 421 respectively calculate a d axis voltage command signal Vd* and a q axis voltage command signal Vq*, so that the currents flowing to the motor-generator 192 track the d axis current command signal Id* and the q axis current command signal Iq* The d axis voltage command signal Vd* and the q axis voltage command signal Vq* obtained by the current controller (ACR) 420 are outputted to a pulse modulator 430 for HM control. On the other hand, the d axis voltage command signal Vd* and the q axis voltage command signal Vq* obtained by the current controller (ACR) 421 are outputted to a pulse modulator 440 for PWM control.

The pulse modulator 430 for HM control includes a voltage phase difference calculator 431, a modulation index calculator 432, and a pulse generator 434. The d axis voltage command signal Vd* and the q axis voltage command signal Vq* outputted from the current controller 420 are inputted to the voltage phase difference calculator 431 and the modulation index calculator 432 in the pulse modulator 430.

The voltage phase difference calculator 431 calculates the phase difference between the magnetic pole position of the motor-generator 192 and the voltage phase of the d axis voltage command signal Vd* and the q axis voltage command signal Vq*, in other words the voltage phase difference. If this voltage phase difference is termed δ, then the voltage phase difference δ is given by the following Equation (2):

$$\delta = \arctan(-Vd^*/Vq^*) \qquad (2)$$

Furthermore, the voltage phase difference calculator 431 calculates a voltage phase by adding the magnetic pole position given by the magnetic pole position signal θ from the magnetic pole rotation sensor 193 to the above described voltage phase difference θ. And it outputs a voltage phase signal θv corresponding to this calculated voltage phase to the pulse generator 434. If the magnetic pole position given by the magnetic pole position signal θ is termed θe, then this voltage phase signal θv is given by the following Equation (3):

$$\theta v = \delta + \theta e + \pi \qquad (3)$$

The modulation index calculator 432 calculates the modulation index by normalizing the magnitude of the vector given by the d axis voltage command signal Vd* and the q axis voltage command signal Vq* by the voltage of the battery 136, and outputs a modulation index signal a corresponding to this modulation index to the pulse generator 434. In this embodiment, the modulation index signal a described above is determined on the basis of the battery voltage supplied to the power switching circuit 144 shown in Fig. 2, i.e. the DC voltage, and, when the battery voltage becomes higher, this modulation index a has a tendency to become smaller. Moreover, when the amplitude value of the command value becomes high, the modulation index a has a tendency to become high. In concrete terms, if the battery voltage is termed Vdc, then the modulation index a is given by Equation (4). It should be understood that, in Equation (4), Vd is the value of the amplitude of the d axis voltage command signal Vd* and Vq is the value of the amplitude of the q axis voltage command signal Vq*.

$$a = (\sqrt{(2/3)})\, (\sqrt{(Vd^2 + Vq^2)})\, /\, (Vdc/2) \qquad (4)$$

On the basis of the voltage phase signal θv from the voltage phase difference calculator 431 and the modulation index signal a from the modulation index calculator 432, the pulse generator 434 generates six pulse signals based upon HM control corresponding to the upper and lower arms in the inverter circuit for the U phase, the V phase, and the W phase. And these pulse signals that have been generated are outputted to the changeover device 450, and (when the changeover device 450 is switched over to them) are outputted from the changeover device 450 to the driver circuit 174 (as explained with reference to Fig. 2), and based thereupon drive signals are generated and outputted to the switching elements included in the inverter circuit. It should be understood that the method by which the pulse signals are generated on the basis of HM control (hereinafter termed the "HM pulse signals") will be explained in detail hereinafter.

On the other hand, by a per se known PWM method, the pulse modulator 440 for PWM control generates six pulse signals based upon PWM control (hereinafter termed "PWM pulse signals") corresponding to the upper and lower arms in the inverter circuit for the U phase, the V phase, and the W phase on the basis of the d axis voltage command signal Vd* and the q axis voltage command signal Vq* outputted from the current controller 421, and on the basis of the magnetic pole position signal θ from the magnetic pole rotation sensor 193. And these PWM pulse signals that have been generated are outputted to the changeover device 450 and (when the changeover device 450 is switched over to them) are supplied from the changeover device 450 to the driver circuit 174 (as explained with reference to Fig. 2), and based thereupon drive signals are generated and outputted to the switching elements included in the inverter circuit.

The changeover device 450 selects either the HM pulse signals outputted from the pulse modulator 430 for HM control or the PWM pulse signals outputted from the pulse modulator 440 for PWM control. This selection of pulse signals by the changeover device 450 is performed according to the rotational speed of the motor-generator 192, as previously described. In other words, if the rotational speed of the motor-generator 192 is less than a predetermined threshold value that has been set as a changeover line, then the PWM control method is applied by the power conversion device 140 by the PWM pulse signals being selected. On the other hand, if the rotational speed of the motor-generator 192 is higher than the predetermined threshold value, then the HM control method is applied by the power conversion device 140 by the HM pulse signals being selected. In this manner, either the HM pulse signals or the PWM pulse signals are selected by the changeover device 450, and are outputted to the driver circuit 174.

As has been explained above, either the HM pulse signals or the PWM pulse signals are outputted from the control circuit 172 to the driver circuit 174 as modulated waves. Corresponding to these modulated waves, drive signals are outputted by the driver circuit 174 to the IGBTs 328 and 330 of the power switching circuit 144. Furthermore, in the above description the control circuit 172 has been expressed in the form of a block diagram, in which functions that actually are performed by a microcomputer that executes a computer program are described as being separate blocks.

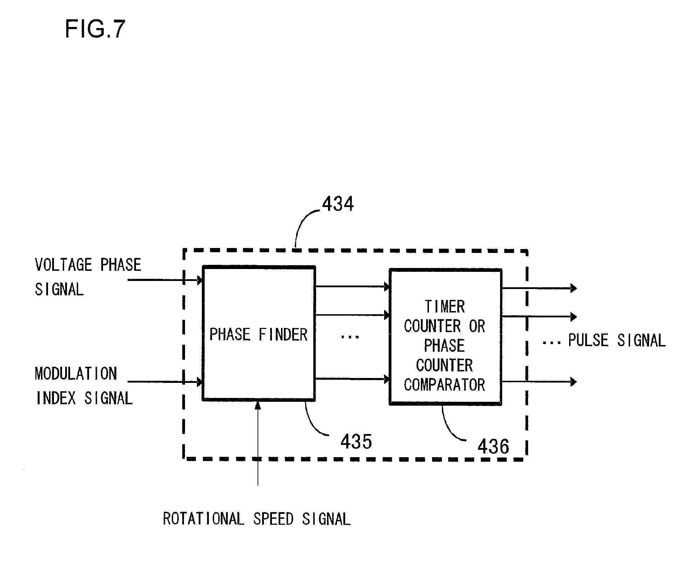

Now the details of the pulse generator 434 shown in Fig. 7 will be explained. This pulse generator 434 is implemented by a phase finder 435 and a timer counter comparator 436, as shown for example in Fig. 6. On the basis of the voltage phase signal θv from the voltage phase difference calculator 431, the modulation index signal a from the modulation index calculator 432, and rotational speed information based upon the magnetic pole position signal θ, the phase finder 435 searches for switching pulse phases in a table of phase information that has been stored in advance, extracts the phases of the switching pulses that are to be outputted for each of the upper and lower arms for the U phase, the V phase, and the W phase, and outputs information specifying the results that have been found to the timer counter comparator 436. And, on the basis of these results outputted from the phase finder 435, the timer counter comparator 436 generates HM pulse signals as switching commands for each of the upper and lower arms for each of the U phase, the V phase, and the W phase. These six HM pulse signals for each of the upper and lower arms of each of the phases thus generated by the timer counter comparator 436 are outputted to the changeover device 450, as previously described.

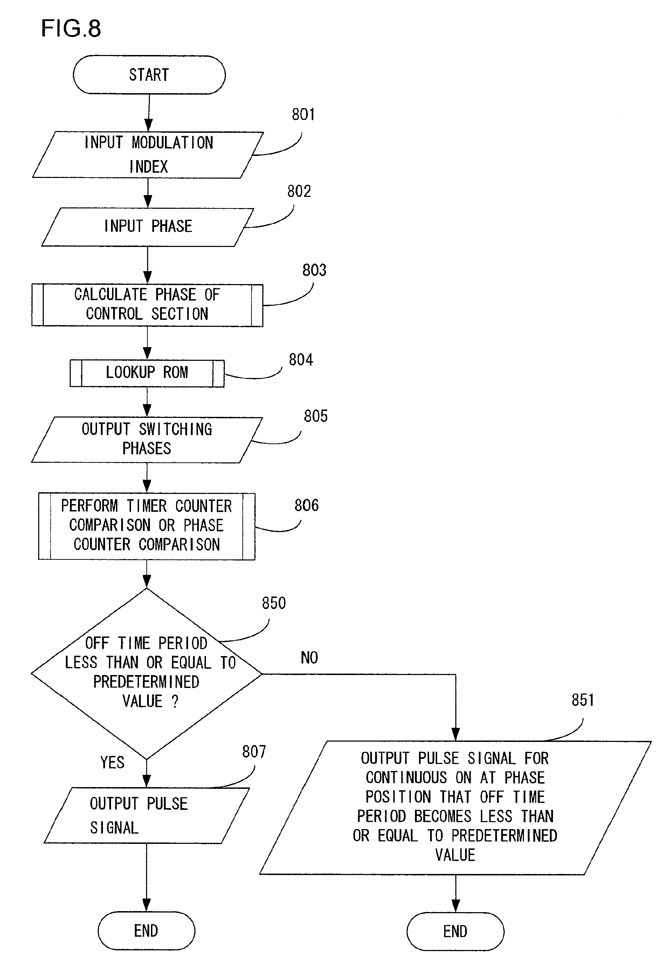

Fig. 8 is a flow chart for explanation of the details of this procedure for pulse generation by the phase finder 435 and the timer counter comparator 436 of Fig. 7. In a step 801 the phase finder 435 inputs the modulation index a as an input signal, and then in a step 802 it inputs the voltage phase signal θv as an input signal. Then in a step 803 the phase finder 435 calculates a range of voltage phase that corresponds to the next control cycle, on the basis of the current voltage phase signal θv that has been inputted, and in consideration of the control delay time period and the rotational speed. Thereafter in a step 804 the phase finder 435 performs lookup from the ROM. In this ROM lookup, on the basis of the modulation index signal a that was inputted, the phases for ON and OFF switching are found for the range of voltage phase calculated in the step 803, according to a table that has been stored in advance in a ROM (not shown in the figures).

Next in a step 805 the phase finder 435 outputs to the timer counter comparator 436 the information specifying the phases for switching ON and OFF that has been found by the ROM lookup in the step 804. The timer counter comparator 436 converts this phase information into time period information in a step 806, and generates HM pulse signals using a compare and match function with a timer counter. It should be understood that the process of converting the phase information to time period information utilizes the information in the rotational speed signal. Or, in the step 806, it would also be acceptable to generate the HM pulses by using a compare and match function with a phase counter for the information for the phases for switching ON and OFF obtained by ROM lookup in the step 804.

Then in the next step 807 the timer counter comparator 436 outputs the HM pulse signals generated in the step 806 to the changeover device 450. By the processing of the steps 801 through 807 explained above being performed by the phase finder 435 and the timer counter comparator 436, the HM pulse signals are generated by the pulse generator 434.

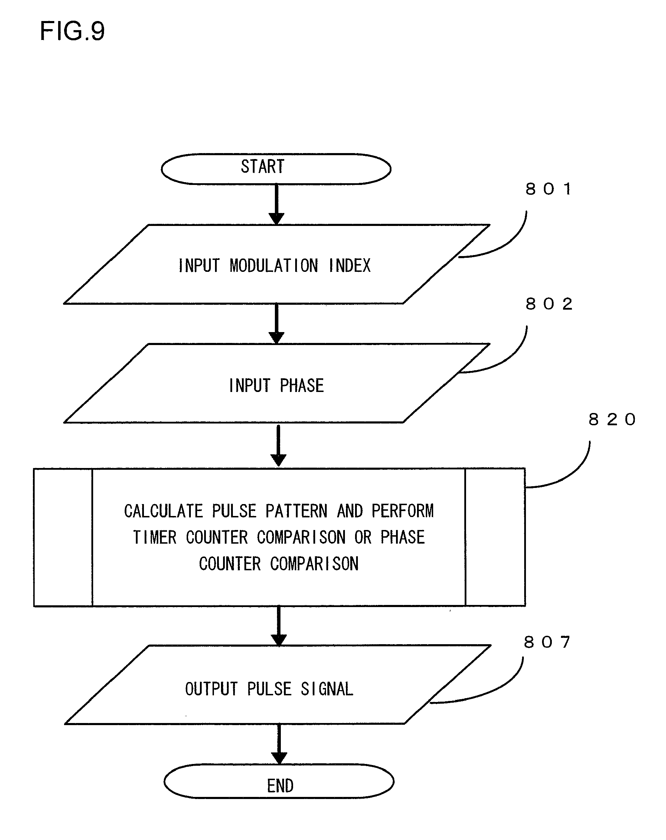

Or, instead of the flow chart of Fig. 8, it would also be acceptable to arrange for the pulse generation to be performed by the processing shown in the flow chart of Fig. 9 being executed by the pulse generator 434. This processing does not utilize the table lookup method of finding the switching phase using a table stored in advance, as in the case of the flow chart shown in Fig. 8; rather, it is a method of generating the switching phases for each control cycle of the current controller (ACR) by calculation.

In a step 801 the pulse generator 434 inputs the modulation index signal a, and then in a step 802 it inputs the voltage phase signal θv. Next in a step 820 the pulse generator 434 determines the phases for switching ON and OFF for each control cycle of the current controller (ACR) by calculation, on the basis of the modulation index signal a and the voltage phase signal θv that have thus been inputted, and in consideration of the control delay time period and the rotational speed.

The details of the processing to determine the switching phases in the step 820 are shown in the flow chart of Fig. 10. In a step 821, on the basis of the rotational speed, the pulse generator 434 designates the orders of the harmonic components to be eliminated. For this, in the next step 822 the pulse generator 434 performs processing such as matrix calculation or the like according to the orders of the harmonic components that have been designated, and outputs pulse reference angles in the step 823.

The calculations for the pulse generation process of the steps 821 through 823 are performed according to the matrix equations shown as the following Equations (5) through (8).

Here, as a typical example, a case will be described in which the harmonic components of the third order, the fifth order, and the seventh order are to be eliminated.

When the harmonic components of the third order, the fifth order, and the seventh order have been designated in the step 821 as the harmonic components for elimination, the pulse generator 434 performs the following matrix calculation in the next step 822.

Here, a row vector like that shown in Equation (5) is constructed for the harmonic components of the third order, the fifth order, and the seventh order that are to be eliminated.

$$\begin{bmatrix} x_1 & x_2 & x_3 \end{bmatrix} = \pi/2 \begin{bmatrix} k_1/3 & k_2/5 & k_3/7 \end{bmatrix} \quad (5)$$

The elements within the right side brackets of Equation (5) are $k_1/3$, $k_2/5$, and $k_3/7$. Now, $k_1$, $k_2$, and $k_3$ may be selected to be any desired odd numbers. However, $k_1$ is never selected to be 3, 9, or 15, $k_2$ is never selected to be 5, 15, or 25, $k_3$ is never selected to be 7, 21 35, and so on. Under these conditions, the harmonic components of the third order, the fifth order, and the seventh order are perfectly eliminated.

To describe the above more generally, the value of each of the terms in Equation (5) may be determined by making the value of the denominator be the order of a harmonic component that is to be eliminated, and by making the value of the numerator be any desired odd number except for an odd multiple of the denominator. Thus in the example shown in Equation (5) the number of elements in the row vector is 3, because there are harmonic components of three orders to be eliminated (i.e. the third order, the fifth order, and the seventh order). In a similar manner, for elimination of harmonic components of N orders, it is possible to construct a row vector whose number of elements is N, and to determine the value of each of its elements.

It should be understood that it is also possible, by making the values of the numerator and of the denominator of each of the elements in Equation (5) different from those described above, to perform waveform shaping of the spectrum, instead of eliminating the corresponding harmonic component. In this process, it would also be acceptable to arrange to select the values of the numerator and of the denominator of each of the elements as desired, with the principal objective not of completely eliminating the corresponding harmonic components, but rather of shaping the spectrum waveform. In this case, while there is no need for the numerators and the denominators necessarily to be integers, it still will be unacceptable to select an odd multiple of the denominator as the value of the numerator. Furthermore, it is not necessary for the values of the numerator and of the denominator to be constant; it would also be acceptable for them to be values that change with time.

If, as described above, there are three elements whose values are determined by combinations of a denominator and a numerator, then a three column vector may be established as shown in Equation (5). In a similar manner, a vector with N elements whose values are determined by combinations of a denominator and a numerator, in other words a vector of N columns, may be set up. In the following, this N column vector will be termed the "harmonic component reference phase vector".

If the harmonic component reference phase vector is a three column vector as in Equation (5), then Equation (6) is calculated by transposing this harmonic component reference phase vector. As a result, the pulse reference angles S 1 through S4 are obtained.

These pulse reference angles S 1 through S4 are parameters that specify the center positions of the pulses, and are compared with a triangular wave carrier that will be described hereinafter. If in this manner the number of pulse reference angles (S1 through S4) is four, then, generally, the number of pulses for one cycle of the voltages between lines will be 16.

$$\begin{bmatrix} S_1 \\ S_2 \\ S_3 \\ S_4 \end{bmatrix} = \left\{ 2 \begin{bmatrix} 1 & 0 & 0 \\ 1 & 0 & 1 \\ 1 & 1 & 0 \\ 1 & 1 & 1 \end{bmatrix} - \begin{bmatrix} 1 & 1 & 1 \\ 1 & 1 & 1 \\ 1 & 1 & 1 \\ 1 & 1 & 1 \end{bmatrix} \right\} \begin{bmatrix} x_1 \\ x_2 \\ x_3 \end{bmatrix} \tag{6}$$

Moreover, if the harmonic component reference phase vector is a four column vector as in Equation (7) instead of a three column vector as in Equation (5), then the matrix calculation Equation (8) is employed:

$$\begin{bmatrix} x_1 & x_2 & x_3 & x_4 \end{bmatrix} = \pi/2 \begin{bmatrix} k_1/3 & k_2/5 & k_3/7 & k_4/11 \end{bmatrix} \tag{7}$$

$$\begin{bmatrix} S_1 \\ S_2 \\ S_3 \\ S_4 \\ S_5 \\ S_6 \\ S_7 \\ S_8 \end{bmatrix} = \left\{ 2 \begin{bmatrix} 1 & 0 & 0 & 0 \\ 1 & 0 & 0 & 1 \\ 1 & 0 & 1 & 0 \\ 1 & 0 & 1 & 1 \\ 1 & 1 & 0 & 0 \\ 1 & 1 & 0 & 1 \\ 1 & 1 & 1 & 0 \\ 1 & 1 & 1 & 1 \end{bmatrix} - \begin{bmatrix} 1 & 1 & 1 & 1 \\ 1 & 1 & 1 & 1 \\ 1 & 1 & 1 & 1 \\ 1 & 1 & 1 & 1 \\ 1 & 1 & 1 & 1 \\ 1 & 1 & 1 & 1 \\ 1 & 1 & 1 & 1 \\ 1 & 1 & 1 & 1 \end{bmatrix} \right\} \begin{bmatrix} x_1 \\ x_2 \\ x_3 \\ x_4 \end{bmatrix} \tag{8}$$

As a result, the pulse reference angle outputs S1 through S8 are obtained. At this time, the number of pulses for one cycle of the voltages between lines is 32.

The relationship between the number of harmonic components to be eliminated and the number of pulses is generally as follows. That is: if there are two harmonic components to be eliminated, then the number of pulses for one cycle of the voltages between lines is 8; if there are three harmonic components to be eliminated, then the number of pulses for one cycle of the voltages between lines is 16; if there are four harmonic components to be eliminated, then the number of pulses for one cycle of the voltages between lines is 32; and if there are five harmonic components to be eliminated, then the number of pulses for one cycle of the voltages between lines is 64. In a similar manner, each time the number of harmonic components to be eliminated increases by one, the number of pulses for one cycle of the voltages between lines doubles.

However, in the case of a pulse configuration in which positive pulses and negative pulses are superimposed in the voltages between lines, sometimes it is the case that the number of pulses is not the same as described above.

Pulse waveforms for the three voltages between lines, i.e. for the voltage between the U and V lines, the voltage between the V and W lines, and the voltage between the W and U lines, are created by the HM pulse signals that are generated as described above by the pulse generator 434. These pulse waveforms of the voltages between lines are all actually the same pulse waveform, but shifted apart by $2\pi/3$. Accordingly in the following only the voltage between the U and V lines will be explained, since it will serve as a representative of all of the voltages between lines.

The relationship between the reference phase θuvl of the voltage between the U and V lines and the voltage phase signal θv and the magnetic pole position θe is as in the following Equation (9):

$$\theta uvl = \theta v + \pi/6 = \theta e + \delta + 7\pi/6 \text{ [rad]} \qquad (9)$$

The waveform of the voltage between the U and V lines shown by Equation (9) is bilaterally symmetric about the positions θuv1=$\pi/2$ and $3\pi/2$ as centers, and moreover is point symmetric about he positions θuv1=0 and $\pi$ as centers. Accordingly, the waveform of one cycle of the pulses of the voltage between the U and V lines (from θuv1=0 to $2\pi$) may be expressed based upon the pulse waveform from θuvl=0 to $\pi/2$ by duplicating it symmetrically left and right or symmetrically up and down for each interval of $\pi/2$.

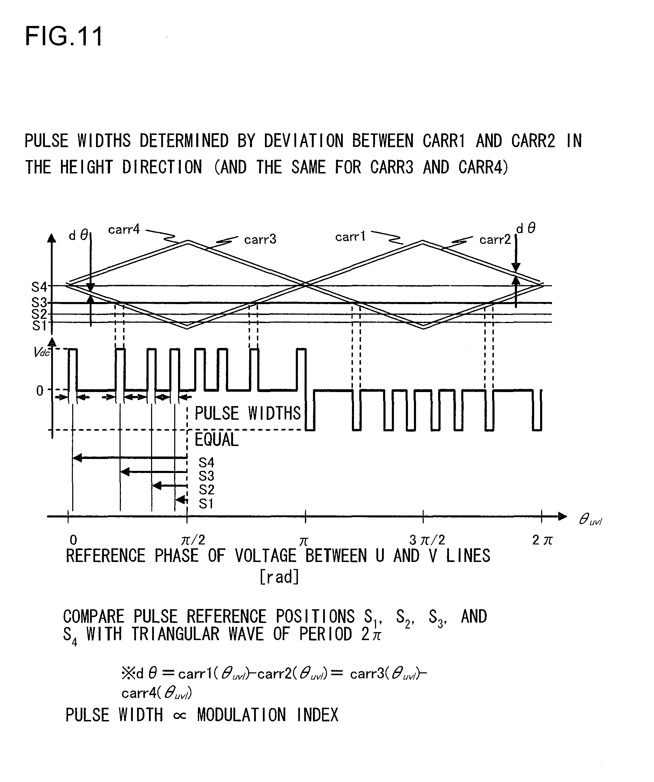

One method of implementing this is an algorithm for comparing the center phases of the pulses of the voltage between the U and V lines in the range $0 \le \theta uv1 \le \pi/2$ with a four channel phase counter, and for generating the pulses of the voltages between the U and V lines for a full cycle, in other words for the range $0 \le \theta uv1 \le 2\pi$, on the basis of the result of this comparison. A conceptual figure for this is shown in Fig. 11.

Fig. 11 shows, as an example, a case in which the number of pulses of the voltage between lines in the range $0 \le \theta uv1 \le \pi/2$ is 4. In Fig. 11, the pulse reference angles S1 through S4 are the center phases of these four pulses.

Each of carr1(θuv1), carr2(θuv1), carr3(θuv1), and carr4(θuv1) represents one of four phase counters on four channels. All of these phase counters are triangular waves having a period of $2\pi$ radians with respect to the reference phase θuvl. Moreover, carr1(θuv1) and carr2(θuv1) are deviated apart by a deviation dθ in the amplitude direction, and the same relationship holds for carr3(θuv1) and carr4(θuv1).

dθ denotes the width of the pulses of the voltage between lines. The amplitude of the fundamental wave changes linearly with respect to this pulse width dθ.

The pulses of the voltage between lines are formed at each point of intersection of the phase counters carr1(θuvl), carr2(θuvl), carr3(θuvl), and carr4(θuvl) and the pulse reference angles S 1 through S4 that give the center phases of the pulses in the range $0 \le \theta uv1 \le \pi/2$. Due to this, the pulse signals are formed in a pattern that is symmetrical every 90°.

In more detail, pulses of width dθ and having a positive amplitude are generated at the points that carr1(θuv1) and carr2(θuv1) and S1 through S4 agree with one another. On the other hand, pulses of width dθ and having a negative amplitude are generated at the points that carr3(θuv1) and carr4(θuv1) and S1 through S4 agree with one another.

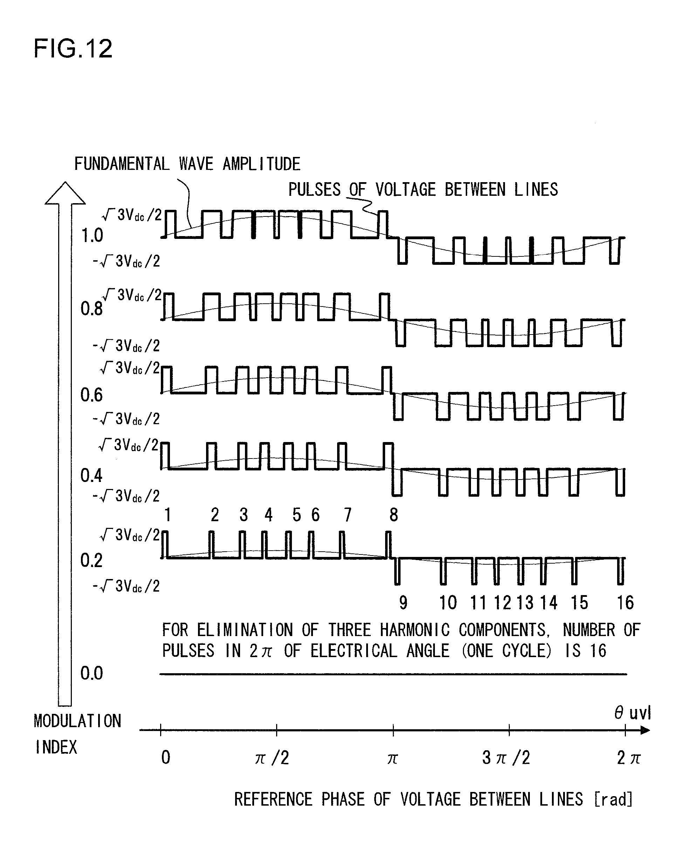

Examples of waveforms of the voltage between lines generated for various modulation indices using a method like that explained above are shown in Fig. 12. For Fig. 12, $k_1$=1, $k_2$=1, and $k_3$=3 are selected as values of $k_1$, $k_2$, and $k_3$ in Equation (5), and examples of the pulse waveform of the voltage between lines are shown as the modulation index changes from 0 to 1.0. According to Fig. 12, it will be understood that the pulse width increases almost proportionally to increase of the modulation index. By increasing the pulse width in this manner, it is possible to increase the effective value of the voltage. However, for modulation indices of 0.4 or greater, the widths of the pulses in the vicinity of θuv1=0, $\pi$, and $2\pi$ do not change even though the modulation index changes. This type of phenomenon is caused by pulses of positive amplitude and pulses of negative amplitude overlapping one another.

As described above, in the embodiment described above, switching operation is performed on the basis of the AC power that is required to be outputted from the various switching elements of the power switching circuit 144 by the drive signals from the driver circuit 174 being supplied to the switching elements. The number of times that the switching elements are switched for each one cycle of the AC power has a tendency to increase along with increase of the types of harmonic components that are to be eliminated. Now since, if this three phase AC power is to be outputted for supply to a three phase AC rotating electrical machine, the harmonic components whose order is a multiple of three act to mutually cancel one another out, accordingly it will be acceptable not to include these harmonic components as ones that are to be eliminated.

To view this from another standpoint, the modulation index increases when the voltage of the DC power that is supplied decreases, and there is a tendency for the continuous intervals in which the switching operation goes to continuous to become longer. Furthermore, when driving a rotating electrical machine such as a motor or the like, if the torque to be generated by the rotating electrical machine becomes larger, then the modulation index becomes larger, and as a result the continuous intervals of the switching operation become longer; while, if the torque to be generated by the rotating electrical machine becomes smaller, then the continuous intervals of the switching operation become shorter. When the continuous intervals become longer and the discontinuous intervals have become shorter, in other words when the switching gaps have become somewhat shorter, there is a possibility that cutoff of the switching elements cannot be performed safely, and in this case control is performed to connect together successive continuous intervals so as not to perform cutoff but to maintain the continuous state.

To view this from yet another standpoint, in a state in which the frequency of serious influence of distortion of the outputted AC power is low, in particular in a state in which the rotating electrical machine is stopped or its rotational speed is extremely low, control is not performed according to the HM method, but rather the power switching circuit 144 is controlled according to the PWM method employing a carrier wave having a fixed period, and control of the power switching circuit 144 is changed over to the HM method in the state in which the rotational speed has increased. If the present invention is applied to a power conversion device for powering an automobile, then it is particularly desirable to minimize the influence of torque pulsations during the stage when the vehicle is being started off from rest in the stationary state and is being accelerated, in order to maximize the sense of comfort provided by the vehicle and so on. Due to this consideration, the power switching circuit 144 is controlled according to the PWM method at least at the stage in which the vehicle is being started off from rest in the stationary state, and the control method is changed over to the HM method after the vehicle has accelerated somewhat. By doing this it is possible to perform control to minimize torque pulsations at least when the vehicle is starting off from rest, and it becomes possible to perform control according to the HM method in which switching losses are lower at least in the state of normal traveling in which the vehicle is moving at a relatively constant speed, so that it is possible to implement control in which losses are reduced while at the same time suppressing the influence of torque pulsations.

According to the HM pulse signals that are employed in the present invention, when the modulation index is fixed as described above, the specific characteristic is exhibited that the waveform of the voltage between lines consists of a train of pulses of equal widths, except for certain exceptions. It should be understood that, when exceptionally the widths of some pulses of the voltage between lines are not equal to the widths of the other pulses in the pulse train, this is because, as described above, a pulse that has positive amplitude and a pulse that has negative amplitude have become overlapped. In this case, if the portion where the pulses are overlapped is decomposed into the pulse that has positive amplitude and the pulse that has negative amplitude, then the widths of all of the pulses over the entire cycle necessarily become equal. In other words, the modulation index changes along with change of the pulse widths.

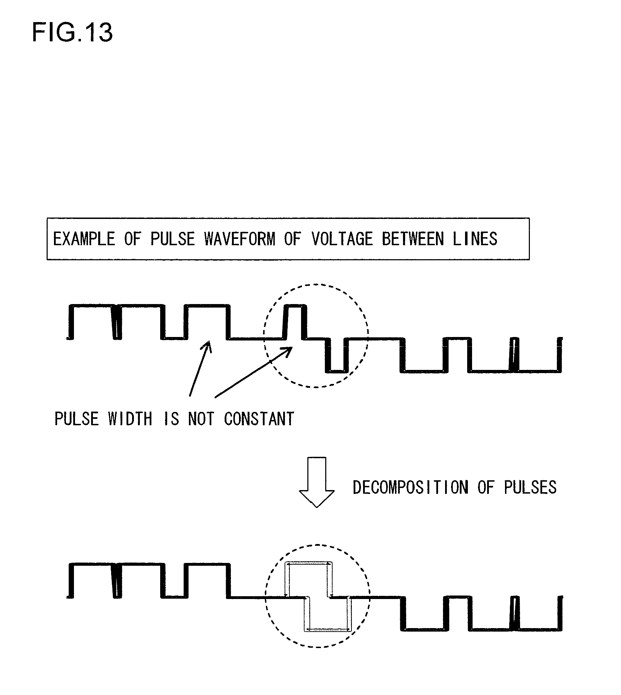

Now, the case in which exceptionally the width of a pulse of the voltage between lines is not equal to that of the other pulses in the train will be further explained in detail with reference to Fig. 13. In the upper portion of Fig. 13, the portion of the pulse waveform of the voltage between lines for modulation index of 1.0 in the range from $\pi/2 \leq \theta uv1 \leq 3\pi/2$ is shown as enlarged. The two pulses near the center of this portion of the pulse waveform of the voltage between lines have a different width from the other pulses in this pulse train.

And, in the lower portion of Fig. 13, the situation is shown when this portion with two pulses of different width from the other pulses has been decomposed. From this figure it will be understood that, in this portion, a pulse having positive amplitude and a pulse having negative amplitude and both having the same pulse width as the other pulses are overlapped, and that two pulses having different pulse width from the other pulses have been created by these positive and negative pulses being thus combined. In other words, by decomposing the overlapped pulses in this manner, it will be understood that the pulse waveform of the voltage between lines created according to the HM pulse signal consists of pulses all having the same constant width.

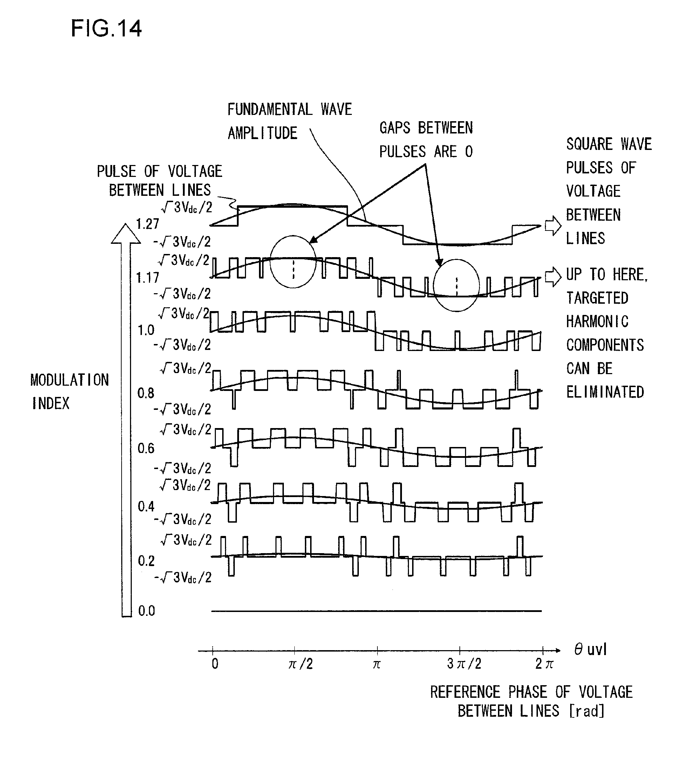

Another example of a pulse waveform of the voltage between lines due to an HM pulse signal generated according to the present invention is shown in Fig. 14. Here, $k_1$=1, $k_2$=1, and $k_3$=5 are selected as values of $k_1$, $k_2$, and $k_3$ in Equation (5), and examples of the pulse waveform of the voltage between lines are shown as the modulation index changes from 0 to 1.27. According to Fig. 14, when the modulation index becomes 1.17 or greater, at the positions $\theta uv1 = \pi/2$ and $3\pi/2$, the gap between the two adjacent pulses that are mutually symmetric left and right disappears. Accordingly it will be understood that, while it is possible to eliminate the targeted harmonic components in the range where the modulation index is less than 1.17, when the modulation index becomes greater than this value, it is not possible to eliminate the targeted harmonic components effectively. Moreover, as the modulation index progressively becomes greater, the gaps between adjacent pulses in other positions as well progressively diminish and disappear, and finally when the modulation index is 1.27 the pulse waveform of the voltage between lines becomes a square wave. When the modulation index becomes large the peak value of the power increases, and the output power increases. Now, the modulation index increases when the target torque or the target rotational speed, i.e. the command value of the motor-generator, increases. It is possible to generate an AC output of higher peak value than the voltage of the DC power that is supplied when the modulation index becomes large, and, with square wave control, in theory it is possible to generate an AC voltage whose peak value is 1.27 times the voltage of the DC power supply. By changing the modulation index as shown in Fig. 14, it is possible to change the peak value of the AC power generated continuously, up to a maximum peak value of 1.27 times the voltage of the DC power supply.

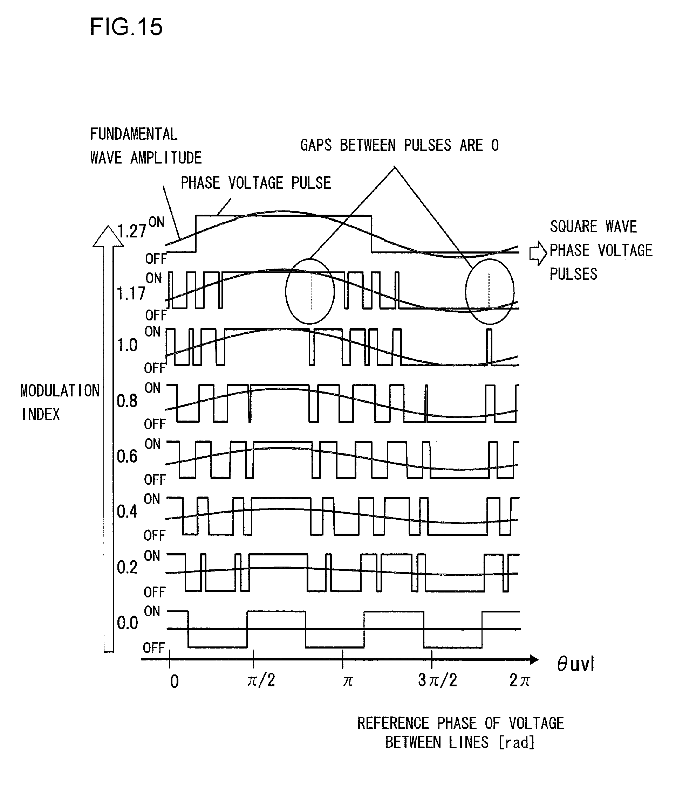

An example showing the pulse waveforms of the voltage between lines shown in Fig. 14 as the corresponding phase voltage pulse waveforms is shown in Fig. 15. First, in this specification, in relation to Figs. 14 and 15, by a pulse is meant a continuous interval of the inverter circuit, during which a current is supplied from the DC power supply to the load such as a rotating electric machine or the like. It will be understood that, when in Fig. 15 the modulation index becomes 1.17 or greater, the gap between two adjacent pulses disappears, in a similar manner to the case in Fig. 14. It should be understood that there is a phase difference of $\pi/6$ between the phase voltage pulse waveform shown in Fig. 15 and the pulse waveform of the voltage between lines shown in Fig. 14. As shown in these Figs. 14 and 15, when the modulation index becomes great, the interval in which the connection provided by the inverter circuit between the DC power supply and the load, in other words the discontinuous interval of the inverter circuit, becomes shorter. In this example, as shown by the broken lines in the figure for modulation index 1.17 and greater, the discontinuous interval of the inverter circuit becomes short, and it becomes impossible for the switching elements incorporated in the inverter circuit to perform their interception operation so quickly. In this case, their continuous operation is continued without interruption. Due to this, the number of intercepted intervals in a half cycle decreases as the modulation index becomes high, and finally the system operates in a rectangular wave control mode in which it goes continuous just once in a full half cycle.

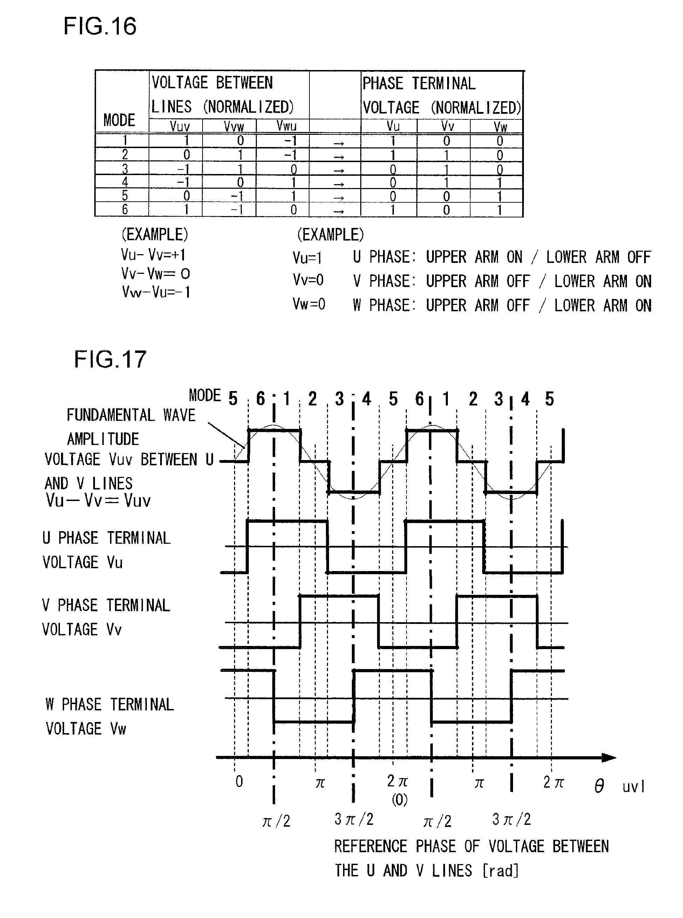

Next, a method for converting the pulses of the voltage between lines to phase voltage pulses will be explained. In Fig. 16, there is shown an example of a conversion table that is employed for converting the pulses of the voltage between lines to phase voltage pulses. The six modes 1 through 6 listed in the column at the left end of this table are numbers allocated to the switching state that currently is in force. The relationships from the voltages between lines to the output voltages are one-to-one with the modes #1 through #6. Each mode is an active interval in which energy transfer takes place between the DC side and the three phase AC side. It should be understood that the voltages between lines of Fig. 16 have been adjusted by normalizing the patterns exhibited as potential differences between the different phases by the battery voltage Vdc.

The table of Fig. 16 is stored in a memory, and shows the phases that are used for control and the pulses between lines, in other words, the phases and the states of continuity between lines. In Fig. 16, for example, while in mode #1 it is shown that Vuv→1, Vvw→0, and Vwu→-1, this is the way of expressing the relationships Vu-Vv=Vdc, Vv-Vw=0, and Vw-Vu=-Vdc when normalized. The phase terminal voltages at this time (that are proportional to the gate voltages), according to the table of Fig. 16, are shown normalized as Vu→1 (the upper arm of the U phase is ON and the lower arm is OFF), Vv→0 (the upper arm of the V phase is OFF and the lower arm is ON), and Vw→0 (the upper arm of the W phase is OFF and the lower arm is ON). In other words, in the table of Fig. 16, they are shown normalized as Vu=Vdc, Vv=0, and Vw=0. The modes #2 through #6 are established according to similar principles.

An example of conversion of pulses of a voltage between lines to phase voltage pulses using the conversion table of Fig. 16 in the case in which the power switching circuit 144 is being controlled in the square wave mode is shown in Fig. 17. In Fig. 17, the upper portion shows the voltage Vuv between the U and V lines as a representative example of a voltage between lines, while the lower portion shows the corresponding U phase terminal voltage Vu, the corresponding V phase terminal voltage Vv, and the corresponding W phase terminal voltage Vw. As shown in Fig. 17, in the square wave control mode, the mode shown in the conversion table of Fig. 16 changes in order from 1 to 6. It should be understood that no three phase short circuited interval as described hereinafter exists in the square wave control mode.

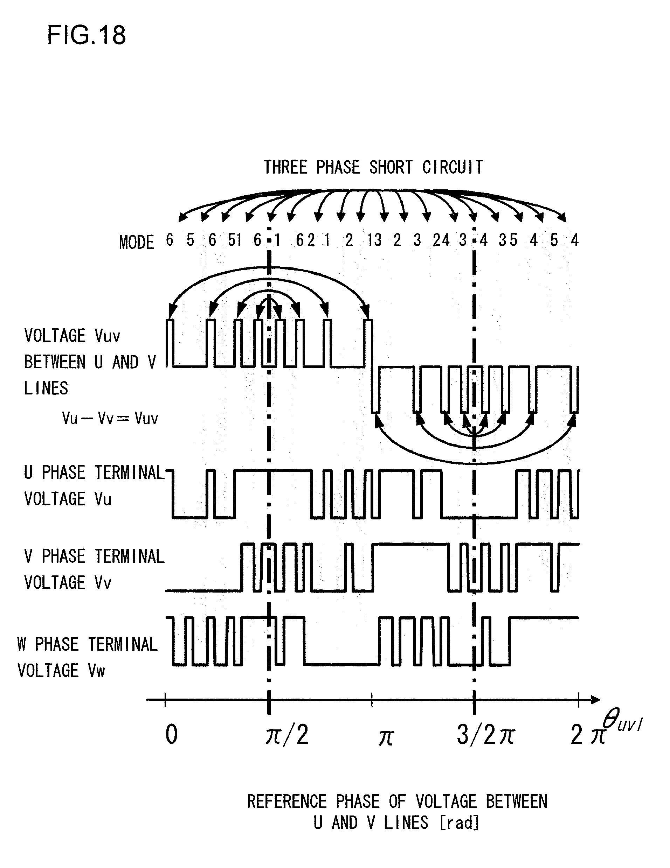

Fig. 18 shows the situation when conversion of the pulse waveform of the voltage between lines shown in the example of Fig. 12 into phase voltage pulses is performed according to the conversion table of Fig. 16. The upper portion of this figure shows the pulses of the voltage between the U and the V lines as a representative example of the voltages between lines, while the lower portion shows the U phase terminal voltage Vu, the V phase terminal voltage Vv, and the W phase terminal voltage Vw.

The number of the mode (i.e. the active interval in which energy transfer takes place between the DC side and the three phase AC side) and the time interval over which a three phase short circuit is created are shown in the upper portion of Fig. 18. In this three phase short circuit interval, while either all of the upper arms for all of the three phases are ON or all of the lower arms for all of the three phases are ON, any of the switch modes may be selected, according to the situation with switching losses and continuity losses.

For example, when the voltage Vuv between the U and V lines is 1, the U phase terminal voltage Vu is 1 and the V phase terminal voltage Vv is 0 (modes #1 and #6). And, when the voltage Vuv between the U and V lines is 0, the U phase terminal voltage Vu and the V phase terminal voltage Vv have the same value, in other words either Vu is 1 and moreover Vv is 1 (mode #2, three phase short circuit), or Vu is 0 and moreover Vv is 0 (mode #5, three phase short circuit). And, when the voltage Vuv between the U and V lines is -1, the U phase terminal voltage Vu is 0 and the V phase terminal voltage Vv is 1 (modes #3 and #4). The phase terminal voltage pulses (i.e. the gate voltage pulses) are generated on the basis of this type of relationship.

Furthermore, in Fig. 18, the patterns of the pulses of voltage between lines and of phase terminal voltage pulses are patterns that repeat quasi-periodically with respect to the phase θuv1 at a standard period whose minimum unit is $\pi/3$. In other words, the pattern of the U phase terminal voltage in the interval $0 \leq \theta uv1 \leq \pi/3$ with 1 and 0 interchanged is the same as the pattern of the W phase terminal voltage in the interval $\pi/3 \leq \theta uv1 \leq 2\pi/3$. Moreover, the pattern of the V phase terminal voltage in the interval $0 \leq \theta uv1 \leq \pi/3$ with 1 and 0 interchanged is the same as the pattern of the U phase terminal voltage in the interval $\pi/3 \le \theta uv1 \le 2\pi/3$, and also the pattern of the W phase terminal voltage in the interval $0 \le \theta uv1 \le \pi/3$ with 1 and 0 interchanged is the pattern of the V phase terminal voltage in the interval $\pi/3 \le \theta uv1 \le 2\pi/3$. In particular, this characteristic is exhibited prominently in the stationary state in which the rotational speed and the output of the motor are constant.

Here, the modes #1 through #6 described above are defined as a first interval in which the upper arm IGBTs 328 and the lower arm IGBTs 330 are turned ON at different phases and current is supplied to the motor-generator 192 from the battery 136 that constitutes a DC power supply. Furthermore, the three phase short circuit interval is defined as a second interval in which, for all phases, either the upper arm IGBTs 328 or the lower arm IGBTs 330 are turned ON, and the torque is maintained by energy accumulated in the motor-generator 192. It will be understood that, in the example shown in Fig. 18, this first interval and second interval are formed alternatingly according to the electrical angle.

Furthermore, in Fig. 18, in the interval $0 \le \theta uv1 \le \pi/3$ for example, the modes #6 and #5 are repeated alternatingly as the first interval, on both sides of three phase short circuit intervals as the second interval. As will be understood from Fig. 16, here, in the mode #6, while for the V phase the lower arm IGBT 330 is switched to ON, for the other phases, i.e. for the U phase and the W phase, the IGBTs on the side opposite to that of the V phase, in other words the upper arm IGBTs 328, are switched to ON. On the other hand, in the mode #5, while for the W phase the upper arm IGBT 328 is switched to ON, for the other phases, i.e. for the U phase and the V phase, the IGBTs on the side opposite to that of the W phase, i.e. the lower arm IGBTs 330, are switched to ON. That is to say, in the first interval, some one phase of the U phase, the V phase, and the W phase is selected (in mode #6 the V phase, and in mode #5 the W phase), and, along with switching the upper arm IGBT 328 or the lower arm IGBT 330 for this selected one phase to ON, also, for the other two phases (in mode #6 the U phase and the W phase, and in mode #5 the U phase and the V phase), the IGBTs 328 or 330 for the arms on the side different from that of the one phase that is selected are switched to ON. Furthermore, the selected one phase (the V phase or the W phase) is changed over for each successive first interval.

And, in the intervals other than the interval $0 \le \theta uv1 \le \pi/3$ as well, in a similar manner to that described above, certain ones of the modes #1 through #6 are alternatingly repeated as the first interval, interleaved with the three phase short circuit interval being repeated as the second interval. In other words: in the interval $\pi/3 \le \theta uv1 \le 2\pi/3$, the modes #1 and #6 are repeated alternatingly; in the interval $2\pi/3 \le \theta uv1 \le \pi$, the modes #2 and #1 are repeated alternatingly; in the interval $\pi \le \theta uv1 \le 4\pi/3$, the modes #3 and #2 are repeated alternatingly; in the interval $4\pi/3 \le \theta uv1 \le 5\pi/3$, the modes #4 and #3 are repeated alternatingly; and in the interval $5\pi/3 \le \theta uv1 \le 2\pi$, the modes #5 and #4 are repeated alternatingly. Due to this, in a similar manner to that described above, in the first interval, any single one of the U phase, the V phase, and the W phase is selected, and, for the selected phase, the upper arm IGBT 328 or the lower arm IGBT 330 is switched to ON, and also, for the other two phases, the IGBTs 328 or 330 for the arms on the side that is different from the side of the single phase that is selected are switched to ON. Furthermore, the selection of the single phase is changed over for each successive first interval.

Now, according to a command to the motor-generator 192 for requesting torque or rotational speed or the like, it is possible to change the electrical angle position at which the first interval described above (in other words, the interval of the modes #1 through #6) is formed, and the length of that interval. In other words, in order to change the number of orders of harmonic components to be eliminated along with change of the rotational speed or the torque of the motor as previously described, the specified electrical angle position at which the first interval is formed may be changed. Or, according to change of the rotational speed or the torque of the motor, the length of the first interval, in other words the pulse width, may be changed, so that the modulation index is changed. Due to this, the waveform of the AC current flowing in the motor, in more concrete terms the harmonic components of this AC current, are changed to the desired values, and, due to this change, it is possible to control the power that is supplied from the battery 136 to the motor-generator 192. It should be understood that it would be acceptable either to change only one of the specified electrical angle position and the length of the first interval, or alternatively to change both of them simultaneously.

Now, the following relationship holds between the shape of the pulses and the voltage. The width of the pulses shown in the figure acts to change the effective value of the voltage, and when the pulse width of the voltage between lines is broad the effective value of the voltage is large, while when it is narrow the effective value of the voltage is small. Furthermore, since the effective value of the voltage is high when the number of harmonic components to be eliminated is small, accordingly the waveform approaches a rectangular wave at the upper limit of the modulation index. This effect is beneficial when the electric motor (i.e. the motor-generator 192) is rotating at high speed so that it is possible to perform output for the motor while exceeding the upper limit of output that could be obtained if control were being performed by normal PWM. In other words, by changing the length of the first interval during which power is supplied to the motor-generator 192 from the battery 136 that constitutes a DC power source and the specified electrical angle position at which this first interval is formed, it is possible to obtain output corresponding to the rotational state of the motor generator 192 by changing the effective value of the AC voltage that is applied to the motor-generator 192.

Furthermore, for each of the U phase, the V phase, and the W phase, the pulse shape of the drive signal shown in Fig. 18 is left and right asymmetric about any $\theta uv1$, in other words about any electrical angle. Moreover, at least one of the pulse ON interval or the pulse OFF interval includes a continuous interval over $\pi/3$ or more of $\theta uv1$ (electrical

angle). For example, for the U phase, there is an ON interval of $\pi/6$ or more in length both before and after a center near $\theta uv1=\pi/2$, and there is also an OFF interval of $\pi/6$ or more in length both before and after a center near $\theta uv1=3\pi/2$. In a similar manner, for the V phase, there is an OFF interval of $\pi/6$ or more in length both before and after a center near $\theta uv1=\pi/6$, and there is also an ON interval of $\pi/6$ or more in length both before and after a center near $\theta uv1=7\pi/6$; and, for the W phase, there is an OFF interval of $\pi/6$ or more in length both before and after a center near $\theta uv1=5\pi/6$, and there is also an ON interval of $\pi/6$ or more in length both before and after a center near $\theta uv1=11\pi/6$. The system has this type of characteristic pulse shape.

As has been explained above, according to the power conversion device of this embodiment, when the HM control mode is selected, a first interval in which power is supplied from the DC power supply to the motor, and a second interval in which the upper arms for all the phases or the lower arms for all the phases of this three phase full bridge circuit are switched to ON, are generated alternately at a specified timing according to electrical angle. Due to this, it is possible to manage with a switching frequency that is from 1/7 to 1/10 as compared to that for control in the PWM mode. Accordingly, it is possible to reduce the switching losses. In addition, it is also possible to alleviate EMC (electromagnetic noise).

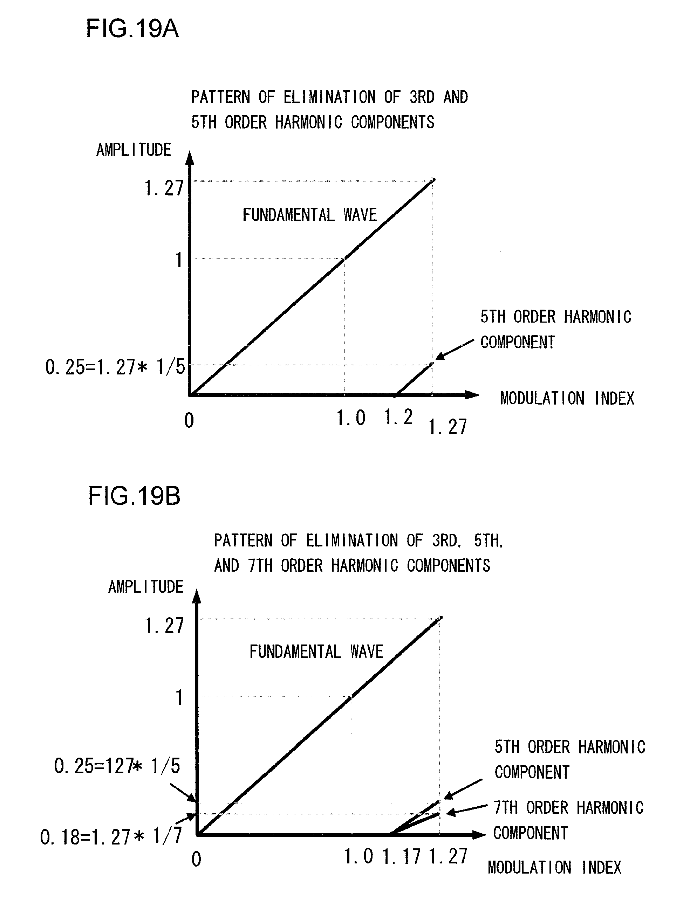

Next, the situation will be explained in relation to elimination of harmonic components in the pulse waveform of the voltage between lines when the modulation index is changed, as in the example shown in Fig. 14. Figs. 19A and 19B are figures showing the magnitudes of the amplitudes of the harmonic components that are to be eliminated in the pulse waveform of the voltage between lines, as the modulation index is changed.

In Fig. 19A, by way of example, the amplitudes are shown of the fundamental wave and of certain harmonic components in a pulse voltage between lines that is a subject for elimination of the harmonic components of the third order and of the fifth order. According to this figure it will be understood that, in the range of modulation index of 1.2 and higher, the fifth order harmonic component appears to some extent because it can no longer be completely eliminated. And, in Fig. 19B, the amplitudes are shown of the fundamental wave and of certain harmonic components in a pulse voltage between lines that is a subject for elimination of the harmonic components of the third order, of the fifth order, and of the seventh order. According to this figure it will be understood that, in the range of modulation index of 1.17 and higher, the fifth order harmonic component and the seventh order harmonic component appear to some extent because they can no longer be completely eliminated.

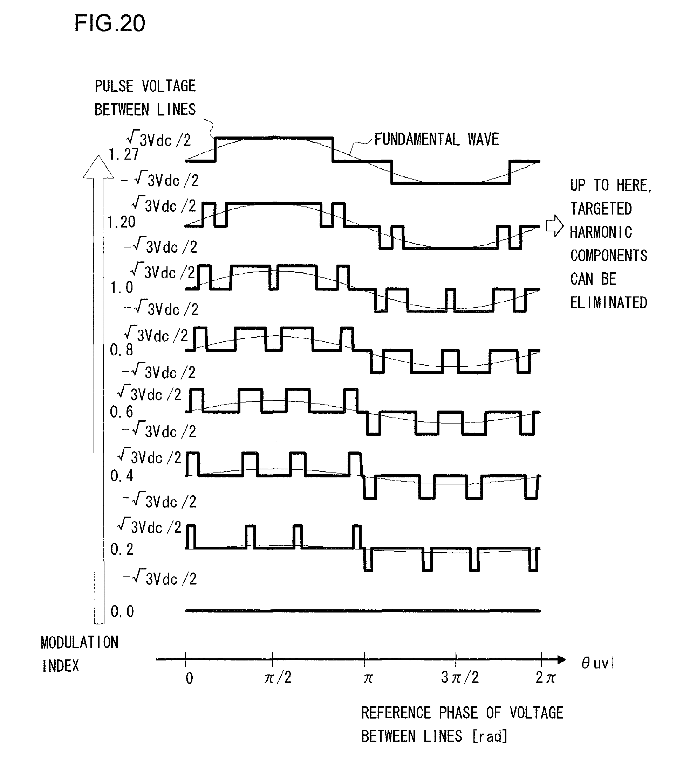

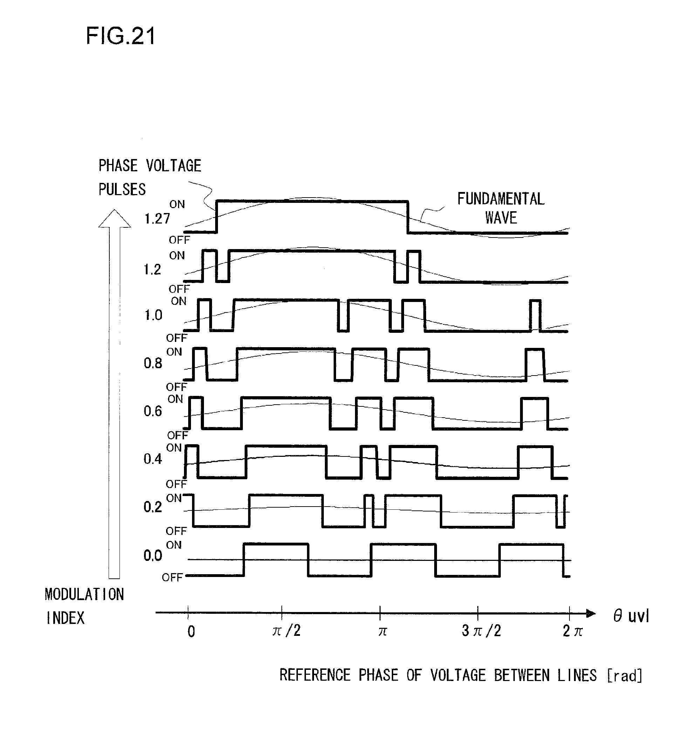

It should be understood that examples of the pulse waveform of the voltage between lines and of the phase voltage pulse waveform corresponding to Fig. 19A are shown in Figs. 20 and 21 respectively. Here, examples of the pulse waveform of the voltage between lines and of the phase voltage pulse waveform are shown that result from setting up a row vector whose number of elements is 2, selecting the values of $k_1=1$ and $k_2=3$ for the elements $(k_1/3, k_2/5)$, and changing the modulation index from 0 to 1.27. Furthermore, Fig. 19B corresponds to the pulse waveform of the voltage between lines and of the phase voltage pulse waveform shown in Figs. 14 and 15 respectively.

From the above explanation, it will be understood that, when a fixed threshold value of the modulation index is exceeded, the harmonic component or components that are the subject of elimination start to appear because they cannot be completely eliminated. Furthermore it will be understood that, the more are the types (i.e. the greater is the number) of harmonic components that are targeted for elimination, the lower is the threshold value of the modulation index at which it becomes no longer possible to eliminate those harmonic components entirely.

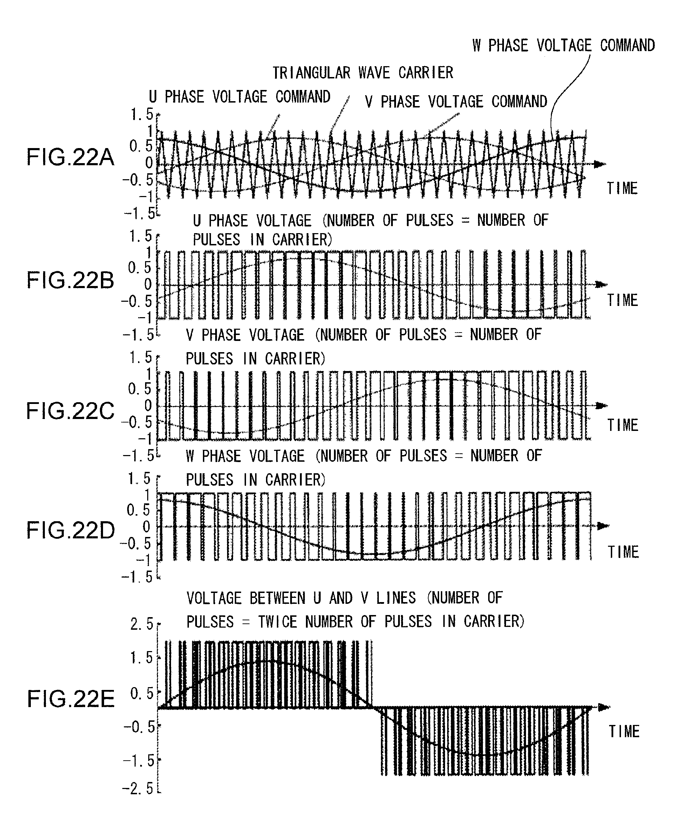

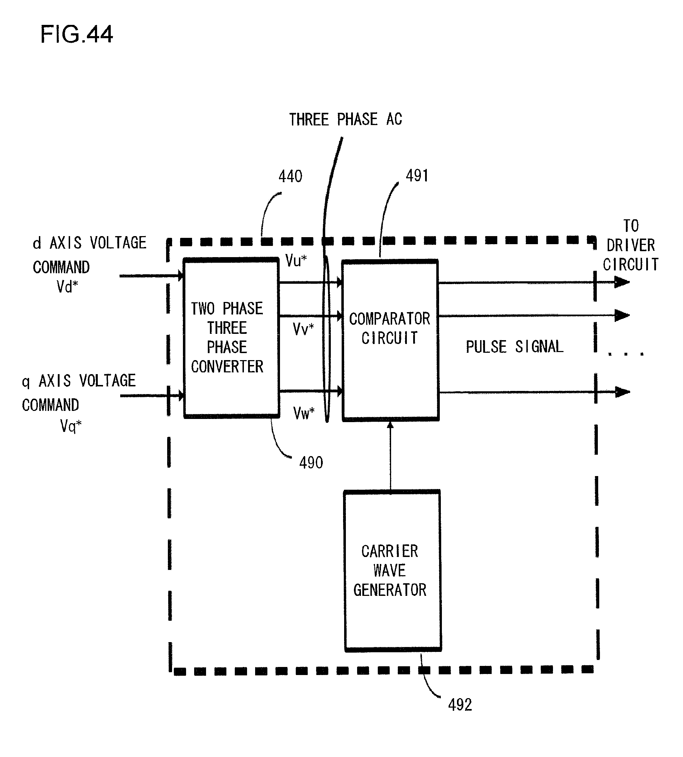

Next, the method by which the PWM pulse signals are generated by the pulse modulator 440 for PWM control will be explained with reference to Figs. 44 and 22A through 22E. Fig. 44 is a figure showing the structure of the pulse modulator 440 for PWM control. This pulse modulator 440 for PWM control includes a two phase - three phase converter 490 that receives the d axis voltage command and the q axis voltage command and converts these voltage commands on two axes to three phase voltage command signals, a carrier wave generator 492 that generates a triangular wave carrier at a specified frequency, and a comparator circuit 491 that compares these three phase voltage command signals with the triangular wave carrier and outputs to the driver circuit pulse signals to make the switching elements for each phase go continuous or discontinuous. Fig. 22A shows the waveforms of the voltage command signals for each of the U phase, the V phase, and the W phase, and the waveform of the triangular wave carrier that is used for generating the PWM pulses. The voltage command signals for the three phases are sine wave command signals that are mutually phase shifted apart by $2\pi/3$, and their amplitudes change according to the modulation index. These voltage command signals are compared with the triangular wave carrier signal for each of the U, V, and W phases, and the voltage pulse waveforms for each of the U phase, the V phase, and the W phase shown in Figs. 22B, 22C, and 22D respectively are generated by taking their respective points of intersection as the timings for turning the respective pulses ON and OFF. It should be understood that the number of pulses in each of these pulse waveforms is equal to the number of triangular wave pulses in the triangular wave carrier.

And Fig. 22E shows the waveform of the voltage between the U and V lines. The number of pulses here is equal to twice the number of triangular wave pulses in the triangular wave carrier; in other words, the number of pulses is twice the number in each of the voltage pulse waveforms for each of the phases as described above. It should be understood that the same holds for the other voltages between lines, in other words for the voltage between the V and W lines and for the voltage between the W and U lines.

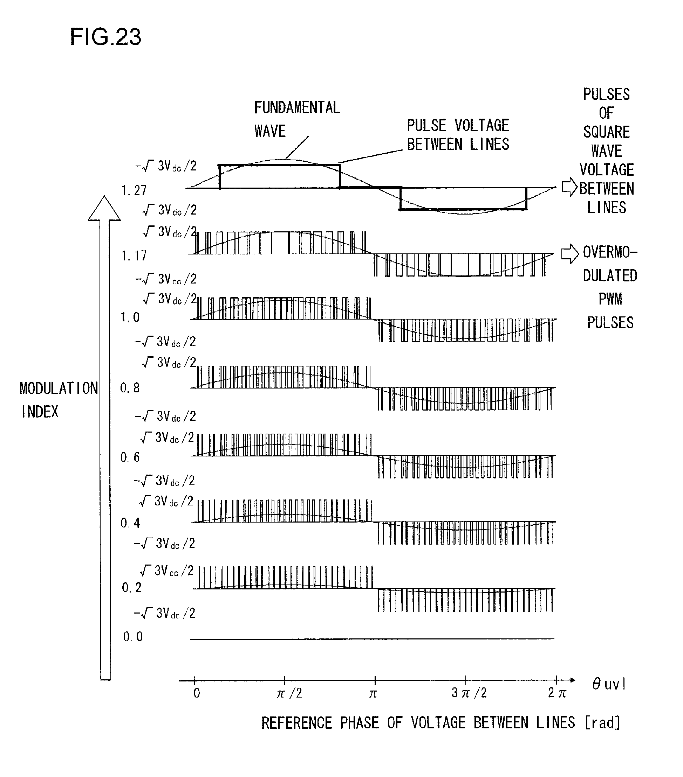

Fig. 23 shows examples of the waveforms of a voltage between lines created according to a PWM pulse signal, drawn for various modulation indices. Here, examples are shown of the pulse waveform of a voltage between lines when the modulation index changes from 0 to 1.27. In Fig. 23, when the modulation index becomes 1.17 or greater, the gaps between one or more pairs of adjacent pulses disappear, and they become combined into a single pulse. This type of pulse signal is termed an over-modulated PWM pulse signal. And finally, at a modulation index of 1.27, the pulse waveform of the voltage between lines becomes a square wave.

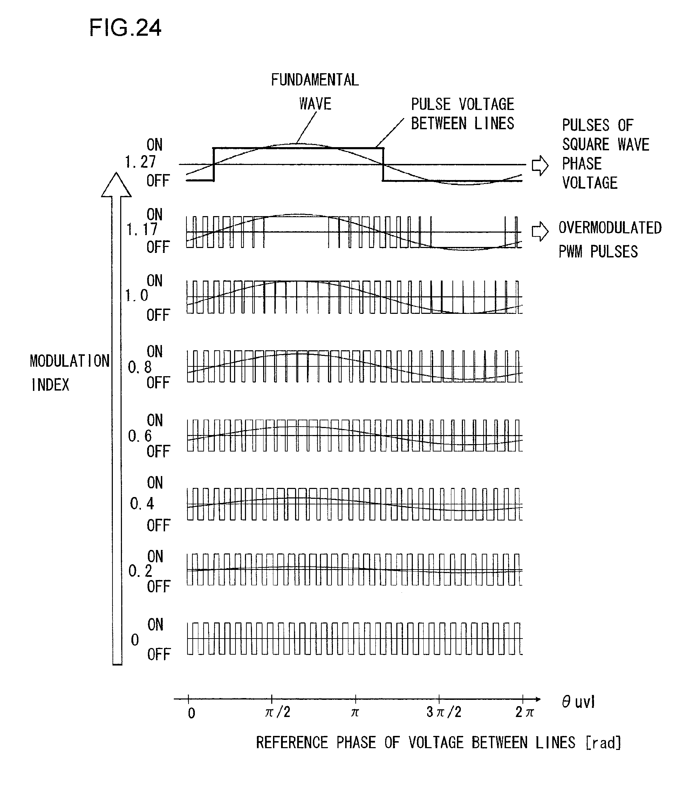

Examples are shown in Fig. 24 of the phase voltage pulse waveforms that correspond to the waveforms of the voltage between lines shown in Fig. 23. It will be understood that in Fig. 24, in a similar manner to the case with Fig. 23, when the modulation index becomes 1.17 or greater, the gaps between one or more pairs of adjacent pulses disappear. It should also be understood that there is a phase difference of $\pi/6$ between the phase voltage pulse waveform shown in Fig. 24 and the pulse waveform of the voltage between lines shown in Fig. 23.

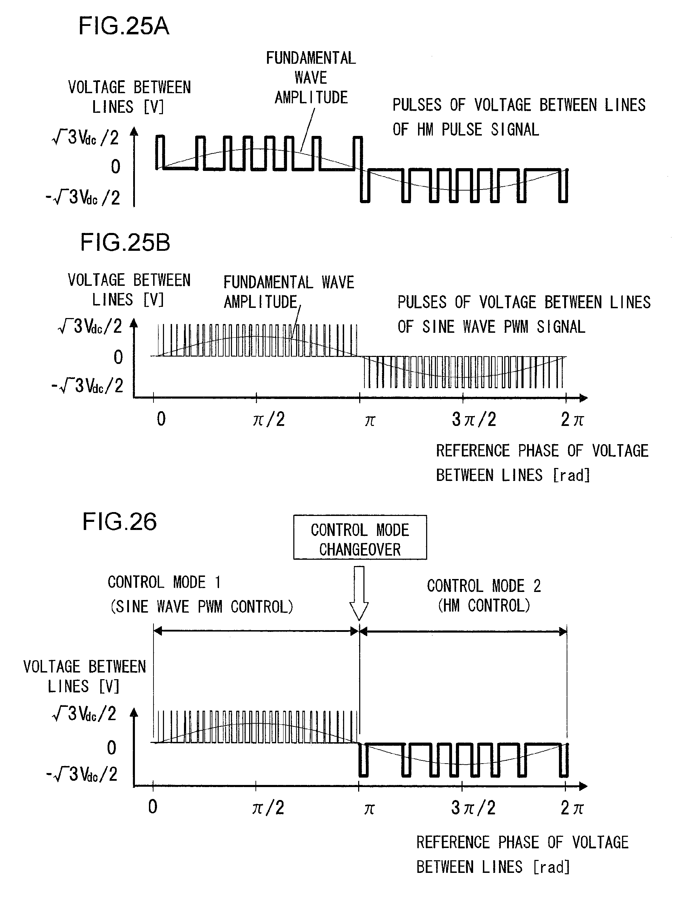

Now, the pulse waveform of the voltage between lines due to an HM pulse signal and the pulse waveform of the voltage between lines due to a PWM pulse signal will be compared together. Fig. 25A shows an example of the pulse waveform of the voltage between lines due to an HM pulse signal. This corresponds to the pulse waveform of the voltage between lines in Fig. 12 for a modulation index of 0.4. On the other hand, Fig. 25B shows an example of the pulse waveform of the voltage between lines due to a PWM pulse signal. This corresponds to the pulse waveform of the voltage between lines in Fig. 23 for a modulation index of 0.4.

When the numbers of pulses in Fig. 25A and in Fig. 25B are compared together, it will be understood that the pulse waveform of the voltage between lines due to an HM pulse signal shown in Fig. 25A has far fewer pulses than the pulse waveform of the voltage between lines due to a PWM pulse signal shown in Fig. 25B. Accordingly, if an HM pulse signal is used, while the control responsiveness is reduced as compared to the case of a PWM signal due to the number of pulses of the voltages between lines that are generated being decreased, on the other hand it is possible greatly to reduce the number of times that switching is performed, as compared to the case of a PWM signal. As a result, it is possible greatly to reduce the switching losses.

Fig. 26 shows the situation when changing over between the PWM control mode and the HM control mode according to the rotational speed of the motor is performed by the changeover operation of the changeover device 450. Here an example is shown of the pulse waveform of the voltage between lines when the control mode is changed over from the PWM control mode to the HM control mode, due to the source selected by the changeover device 450 being changed over from the PWM pulse signal to the HM pulse signal at the time point that $\theta uv1 = \pi$.

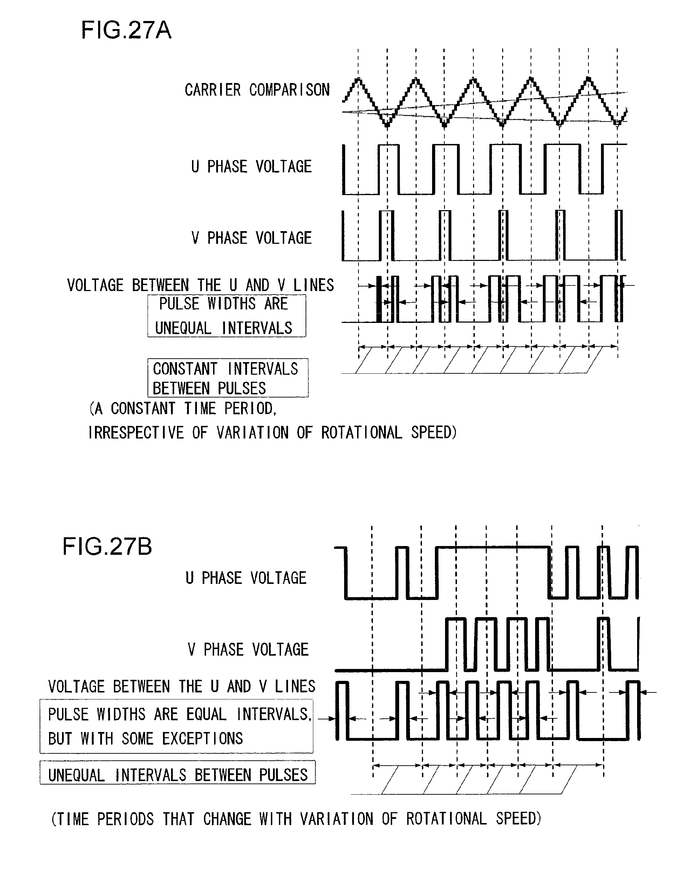

Next, the difference between the shapes of the pulses in PWM control and in HM control will be explained with reference to Figs. 27A and 27B. Fig. 27A shows a triangular wave carrier that is used for generating a PWM pulse signal, and the U phase voltage, the V phase voltage, and the voltage between the U and V lines that are generated due to this PWM pulse signal. And Fig. 27B shows the U phase voltage, the V phase voltage, and the voltage between the U and V lines that are generated due to an HM pulse signal. When these two figures are compared together it will be understood that, by contrast to the case when a PWM pulse signal is used in which the pulse widths of the pulses of the voltage between the U and V lines are not constant, when an HM pulse signal is used, the pulse widths of the pulses of the voltage between the U and V lines are constant. It should be understood that in some cases, as previously described, some of the pulse widths are not actually constant, but this is a phenomenon due to a pulse having positive amplitude and a pulse having negative amplitude being overlapped, and all of the pulses have the same width if such pulse overlapping is decomposed. Furthermore it will be understood that, by contrast to the situation when a PWM pulse signal is used in which, since the triangular wave carrier is constant irrespective of variations of the motor rotational speed, accordingly the intervals between the pulses of the voltage between the U and V lines are also constant irrespective of the motor rotational speed, on the other hand, when an HM pulse signal is used, the intervals between the pulses of the voltage between the U and V lines change according to the motor rotational speed.

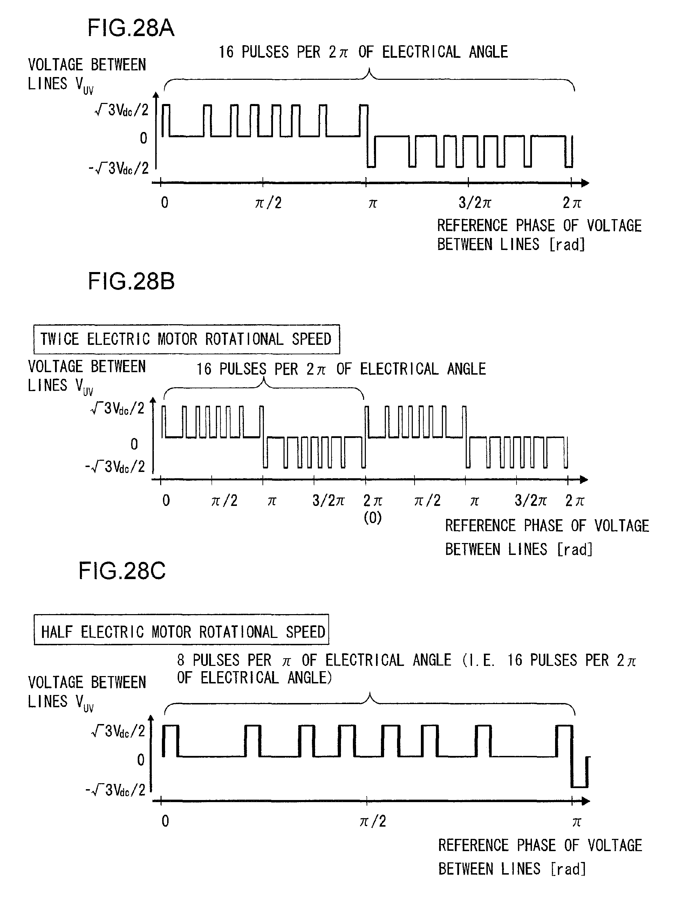

Figs. 28A, 28B, and 28C show the relationship between the motor rotational speed and the pulse waveform of the voltage between lines due to an HM pulse signal. Fig. 28A shows an example of a pulse waveform of a voltage between lines due to an HM pulse signal at a predetermined motor rotational speed. This corresponds to the pulse waveform of the voltage between lines in Fig. 12 for a modulation index of 0.4, and has 16 pulses per $2\pi$ of electrical angle (i.e. of the reference phase $\theta uv1$ of the voltage between the U and V lines).

And Fig. 28B shows an example of a pulse waveform of a voltage between lines due to an HM pulse signal at a motor rotational speed that is twice that of Fig. 28A. It should be understood that the length of the horizontal time axis in Fig. 28B is equivalent to that of the horizontal time axis in Fig. 28A. When Fig. 28A and Fig. 28B are compared together, it will be understood that, while the number of pulses per $2\pi$ of electrical angle is 16 in both cases and does not change, in the case of Fig. 28B the number of pulses in the same period of time is twice that in the case of Fig. 28A.

Moreover, Fig. 28C shows an example of a pulse waveform of a voltage between lines due to an HM pulse signal at a motor rotational speed that is half that of Fig. 28A. It should be understood that the length of the horizontal time axis in Fig. 28C is equivalent to that of the horizontal time axis in Fig. 28A, just as in the case of Fig. 28B. When Fig. 28A and Fig. 28C are compared together, it will be understood that, while the number of pulses per $2\pi$ of electrical angle is 16 in both cases and does not change, in the case of Fig. 28C the number of pulses in the same period of time is half that in the case of Fig. 28A, since the number of pulses per $\pi$ of electrical angle in Fig. 28C is 8.

As has been explained above, when an HM pulse signal is used, the number of pulses of the pulse voltage between lines per unit time changes in proportion to the motor rotational speed. In other words, when the number of pulses per $2\pi$ of electrical angle is considered, this is constant irrespective of the motor rotational speed. On the other hand, when a PWM pulse signal is used, as has been explained above in connection with Figs. 27A and 27B, the number of pulses of the voltage between lines per unit time is constant irrespective of the motor rotational speed. In other words, when the number of pulses per $2\pi$ of electrical angle is considered, this decreases as the motor rotational speed increases.

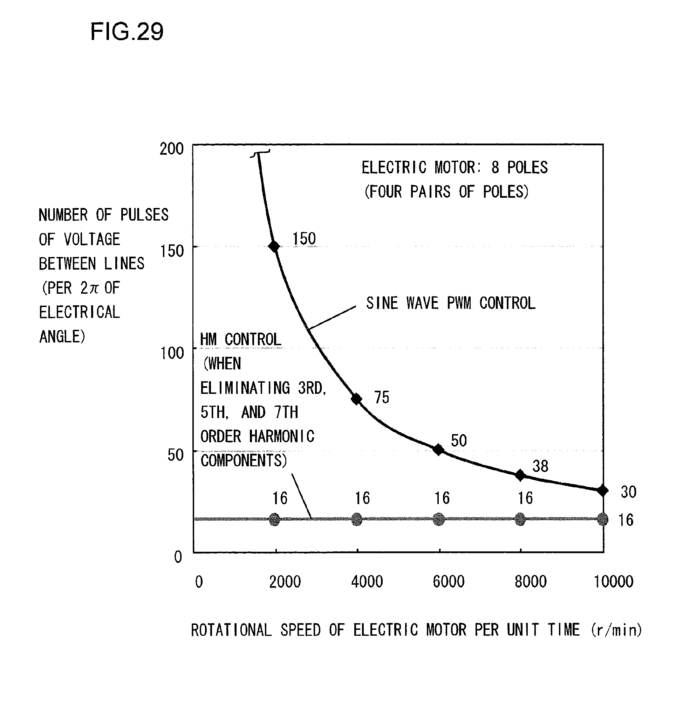

Fig. 29 shows the relationships between the numbers of pulses of the voltage between lines per $2\pi$ of electrical angle (in other words, per one cycle of the voltage between lines) generated with each of HM control and PWM control, and motor rotational speed. It should be understood that, in Fig. 29, an example is shown for a case in which an eight pole motor is used (i.e. a motor having four pairs of poles), the harmonic components that are targeted for elimination by HM control are the components of the third, fifth, and seventh orders, and the frequency of the triangular wave carrier used in the sine wave PWM control is 10 kHz. It will be understood that in this manner, while in the case of PWM control the number of pulses of the voltage between lines per $2\pi$ of electrical angle progressively decreases as the motor rotational speed rises, by contrast in the case of HM control it is constant irrespective of the motor rotational speed. It should be understood that the number of pulses of the voltage between lines in PWM control may be obtained with the following Equation (10):

$$\text{number of pulses of voltage between lines} = \text{frequency of triangular wave carrier}$$

$$/ \{ ( \text{number of pole pairs} \times \text{motor rotational speed} / 60 \} \times 2 \quad (10)$$

It should be understood that while, in Fig. 29, the number of pulses per one cycle of the voltage between lines is shown as being 16 in the case that the number of harmonic components that are subjects for elimination by HM control is three, this value changes as previously described according to the number of harmonic components that are subjects for elimination. That is to say, if the number of harmonic components that are subjects for elimination is two, this number of pulses per one cycle is 8; if the number of harmonic components to be eliminated is four, the number of pulses per one cycle is 32; if the number of harmonic components to be eliminated is five, the number of pulses per one cycle is 64; and every time the number of harmonic components to be eliminated increases by one, the number of pulses of the voltage between lines per one cycle is doubled.

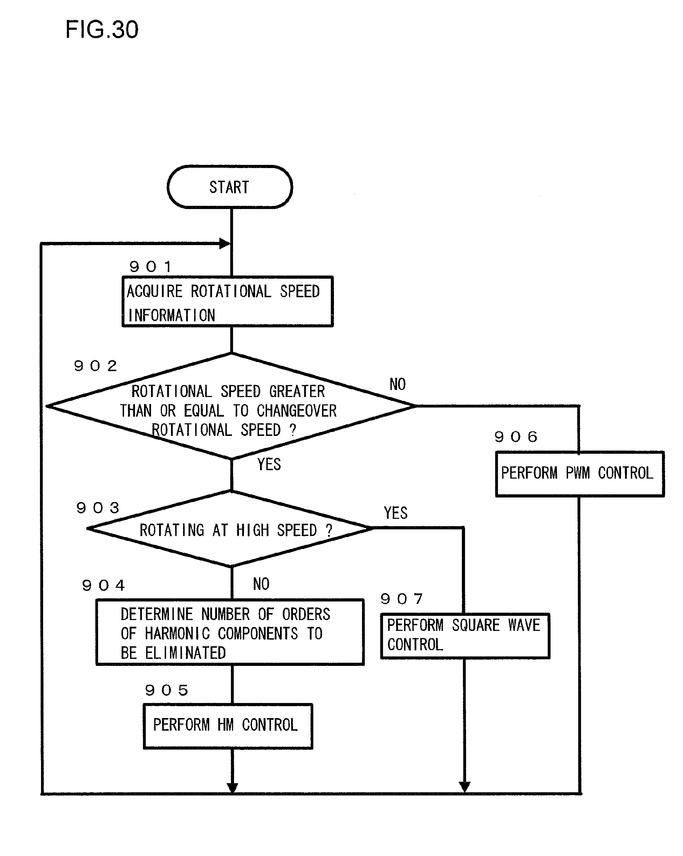

A flow chart of a procedure for motor control that is performed by the control circuit 172 according to the first embodiment of the present invention explained above is shown in Fig. 30. First in a step 901 the control circuit 172 acquires rotational speed information for the motor. This rotational speed information is obtained on the basis of the magnetic pole position signal $\theta$ outputted from the magnetic pole rotation sensor 193.

Then in a step 902, on the basis of the rotational speed information acquired in the step 901, the control circuit 172 makes a decision as to whether or not the rotational speed of the motor is greater than or equal to some predetermined changeover rotational speed. If the motor rotational speed is greater than or equal to the predetermined changeover rotational speed then the flow of control proceeds to a step 903, while if it is less than the changeover rotational speed then the flow of control is transferred to a step 906.

In the step 903, on the basis of the rotational speed information acquired in the step 901, the control circuit 172 makes a decision as to whether or not the motor-generator 192 is rotating at a high rotational speed. If the motor-generator 192 is rotating at a high rotational speed, in other words if the motor rotational speed is greater than or equal to another predetermined rotational speed, then the flow of control is transferred to a step 907, while if it is not then the flow of control proceeds to a step 904.

In this step 904, the control circuit 172 determines the number of orders of harmonic components that are to be the subjects for elimination. Here, as previously described, the harmonic components of the third order, the fifth order, and the seventh order may be determined as being the subjects of elimination, or the like. It should be understood that it would be acceptable to change the number of harmonic components that are to be the subjects for elimination, according to the motor rotational speed. For example, when the motor rotational speed is comparatively low the harmonic components of the third order, the fifth order, and the seventh order may be determined as being the subjects of elimination, while when the motor rotational speed is comparatively high the harmonic components of the third order and the fifth order may be determined as being the subjects of elimination. By reducing the number of harmonic components that are to be the subjects for elimination as the motor rotational speed becomes higher in this manner, it is possible to reduce the number of pulses in the HM pulse signal in the high rotational speed region in which it is more difficult for the influence of torque pulses due to the harmonic components to be experienced, so that it is possible effectively to decrease the switching losses by yet a further level.

Then in the next step 905 the control circuit 172 performs HM control while taking the number of harmonic components determined in the step 904 as being subjects for elimination. At this time, along with an HM pulse signal corresponding to the number of harmonic components that are to be the subjects for elimination being generated by the pulse modulator 430 according to the method for generation previously described, this HM pulse signal is selected by the changeover device 450, and is outputted from the control circuit 172 to the driver circuit 174. After this step 905 has been executed, the control circuit 172 returns the flow of control to the step 901, and the processing described above is repeated.

Alternatively in the step 906 the control circuit 172 performs PWM control. At this time, along with a PWM pulse signal being generated by the pulse modulator 440 according to the method of generation described above on the basis of the result of comparing a predetermined triangular wave carrier with a voltage command signal, this PWM pulse signal is selected by the changeover device 450, and is outputted from the control circuit 172 to the driver circuit 174. After this step 906 has been executed, the control circuit 172 returns the flow of control to the step 901, and the processing described above is repeated.

But in the next step 907 the control circuit 172 performs square wave control. As described previously, such square wave control may be viewed as being one type of HM control; in other words, it may be considered as being HM control with the modulation index having reached its maximum. While it is not possible to eliminate the harmonic components in the case of such square wave control, it is possible to minimize the number of times that switching is performed. It should be understood that the pulse signal that is used in square wave control may be generated by the pulse modulator 430, in a similar manner to the case for HM control. This pulse signal is selected by the changeover device 450, and is outputted from the control circuit 172 to the driver circuit 174. After this step 907 has been executed, the control circuit 172 returns the flow of control to the step 901, and the processing described above is repeated.

According to the first embodiment as explained above, not only may the advantageous operational effects described above be obtained, but also the following further advantageous operational effects may be obtained.

(1) The power conversion device 140 includes the three phase full bridge type power switching circuit 144 that includes the IGBTs 328 and 330 for the upper arms and for the lower arms respectively, and the control unit 170 that outputs drive signals to the IGBTs 328 and 330 for the various phases; and the voltage supplied from the battery 136 is converted into output voltages for each $2\pi/3$ radians of electrical angle by the switching operation of the IGBTs 328 and 330 according to the drive signals, those output voltages then being supplied to the motor-generator 192. And this power conversion device 140 changes over between the HM control mode and the sine wave PWM control mode on the basis of a predetermined condition. In the HM control mode, a first interval in which current is supplied to the motor-generator 192 from the battery 136 by turning the IGBTs 328 for the upper arms and the IGBTs 330 for the lower arms both ON at different phases, and a second interval in which either the IGBTs 328 for the upper arms or the IGBTs 330 for the lower arms for all of the phases are turned ON together and the torque is maintained by the energy accumulated in the motor-generator 192, are created alternatingly according to the electrical angle. And, in the sine wave PWM control mode, current is supplied to the motor-generator 192 from the battery 136 by turning the IGBTs 328 and 330 ON according to pulse widths that are determined on the basis of the results of comparison of a sine wave command signal and a carrier wave. Since this is done, it is possible to perform appropriate control according to the state of the motor-generator 192, along with reducing torque pulsations and switching losses.

(2) It is arranged for the power conversion device 140 to change over between the HM control mode and the sine wave PWM control mode on the basis of the rotational speed of the motor-generator 192 (in the steps 902, 905, and 906 of Fig. 30). Due to this, it is possible to change over to an appropriate control mode according to the rotational speed of the motor-generator 192.

(3) It is arranged also to include a square wave control mode in the HM control mode, in which the IGBTs 328 and 330 for the various phases are turned once ON and once OFF for each rotation of the motor-generator 192. Due to this, it is possible to minimize the switching losses when the motor-generator 192 is rotating at a high rotational speed or the like in which the influence of torque pulsations is small. This square wave control mode is a control mode that is used in the highest rotational speed region, as shown in Fig. 3, but it may also be used in a high output region in which a high modulation index is requested; and, in this embodiment, by making the modulation index high, it is possible gradually to reduce the number of times that switching is performed in each half cycle, and it is thus possible to transition smoothly to the square wave control mode described above.

(4) In the HM control mode, by changing at least one of the electrical angle position at which the first interval is defined and the length of the first interval, it is possible to change the harmonic components of the AC current flowing to the motor-generator 192 to desired values. Due to this change of the harmonic components, a transition is performed from the HM control mode to the square wave control mode. In more concrete terms, the length of the first interval is changed according to the modulation index, and it is square wave control comes to be performed when the modulation index is maximum. Due to this, it is possible simply and easily to implement transition from the HM control mode to the square wave control mode.

- The second embodiment -

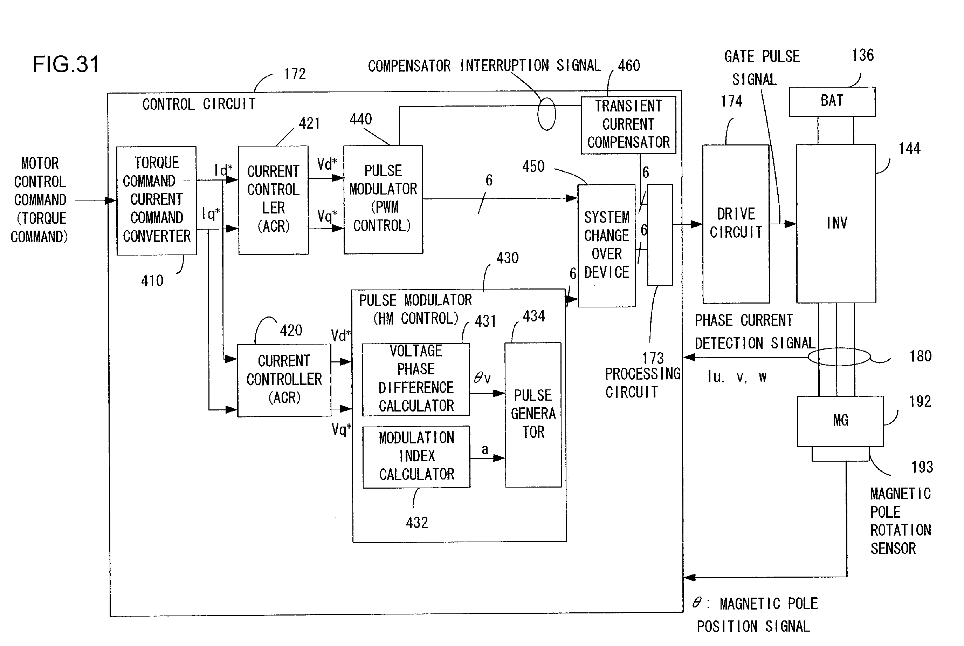

A motor control system having a control circuit 172 according to a second embodiment of the present invention is shown in Fig. 31. As compared with the motor control system according to the first embodiment shown in Fig. 6, this motor control system is additionally provided with a transient current compensator 460.

This transient current compensator 460 generates a compensation current for compensating for a transient current created in the phase current flowing to the motor-generator 192 when the control mode is changed over from PWM control to HM control, or from HM control to PWM control. This generation of a compensation current is performed by detecting the phase voltage during the control mode changeover, and by outputting a modulated wave in pulse form from the transient current compensator 460 to the driver circuit 174, for generating a compensation pulse so as to cancel out the phase voltage that has been detected. The compensation pulse is generated by drive signals being outputted from the driver circuit 174 to the IGBTs 328 and 330 of the power switching circuit 144 on the basis of these modulated waves from the transient current compensator 460, and thereby it is possible to generate the compensation current.

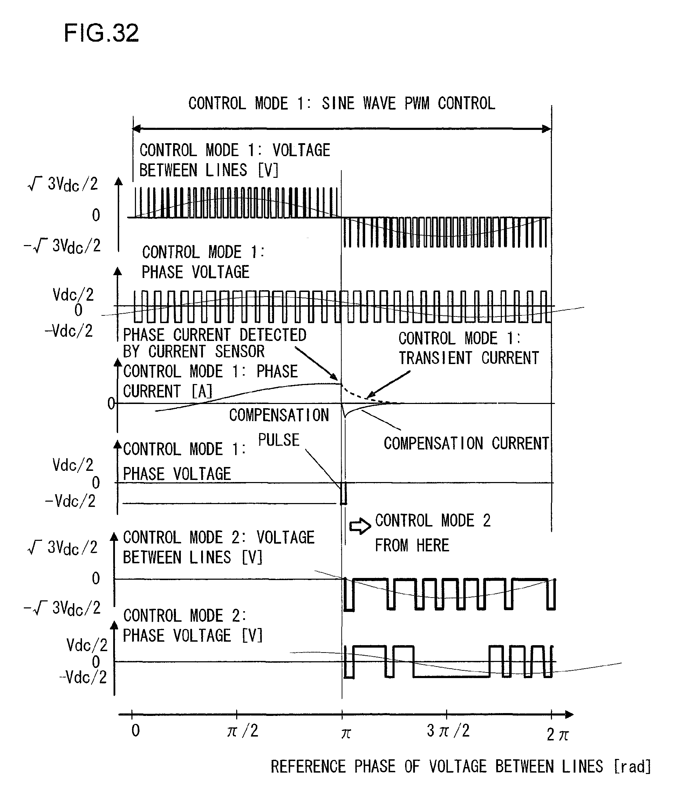

The generation of the compensation current described above by the transient current compensator 460 will now be explained with reference to Fig. 32. In Fig. 32, in sequence from the top, there are respectively shown a waveform of the voltage between lines and a phase voltage waveform due to a PWM pulse signal before control mode changeover, a phase current waveform and a compensation pulse waveform during control mode changeover, and a waveform of the voltage between lines and a phase voltage waveform due to an HM pulse signal after control mode changeover. It should be understood that, in Fig. 32, except for the waveform of the voltage between lines and the phase voltage waveform due to the PWM pulse signal before control mode changeover, an example is shown when the changeover from the PWM control mode to the HM control mode has been performed at the electrical angle (i.e. the reference phase) of in the figure.

When changing over of the control mode is performed, the phase current is detected as shown in the figure. The width for a compensation pulse is determined on the basis of the result of this detection of the phase current, and a compensation pulse is outputted of amplitude Vdc/2 and having a sign opposite to that of the phase voltage (in this case, negative). Due to this, as shown in the figure, a compensation current flows to the phase current so as to cancel out the transient current that is generated directly after the changing over of control mode. After this outputting of the compensation pulse has been completed, the HM pulse signal is outputted.

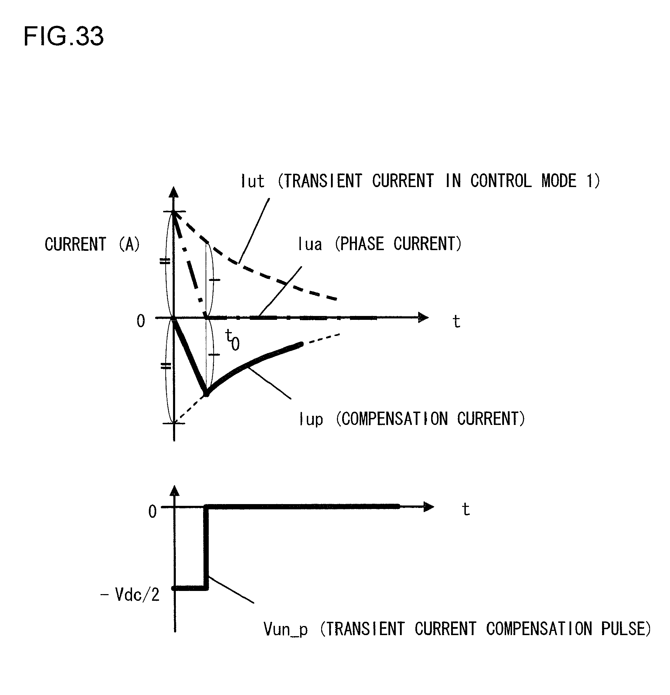

Fig. 33 shows portions of the phase current waveform and the compensation pulse waveform shown in Fig. 32 as enlarged, with the time point of changeover of control mode taken as the starting point. As shown in Fig. 33, while the compensation pulse Vun_p for the transient current is being outputted, the compensation current lup increases towards the negative side. And when, at the time point t0, the transient current lut and the compensation current lup agree with one another in magnitude (but have opposite signs), the output of the compensation pulse Vun_p terminates in agreement with this timing. Thereafter, the transient current lut and the compensation current lup have slopes of the same magnitude (but opposite in sign) and both tend towards zero. Due to this the phase current lua, i.e. the combination of the transient current lut and the compensation current lup, can be reduced to zero at the time point t0, and thereafter remains equal to zero.

As described above, it is possible to make the phase current lua converge quickly towards zero by determining the pulse width of the compensation pulse Vun_p to match a timing at which the magnitude of the transient current lut and the magnitude of the compensation current lup agree with one another, in other words to match a timing at which the transient current lut is perfectly cancelled out by the compensation current lup. It should be understood that this pulse width may be determined on the basis of the result of detection of the phase current lua during the control mode changeover, and in consideration of the time constant of the circuitry.

It should be understood that, while in Figs. 32 and 33 the case when changing over from the PWM control mode to the HM control mode was explained, by a similar method, it is possible to output a compensation pulse from the transient current compensator 460, and thus to generate a compensation current that cancels out the transient current in the phase current, in the opposite case of changing over from the HM control mode to the PWM control mode as well.

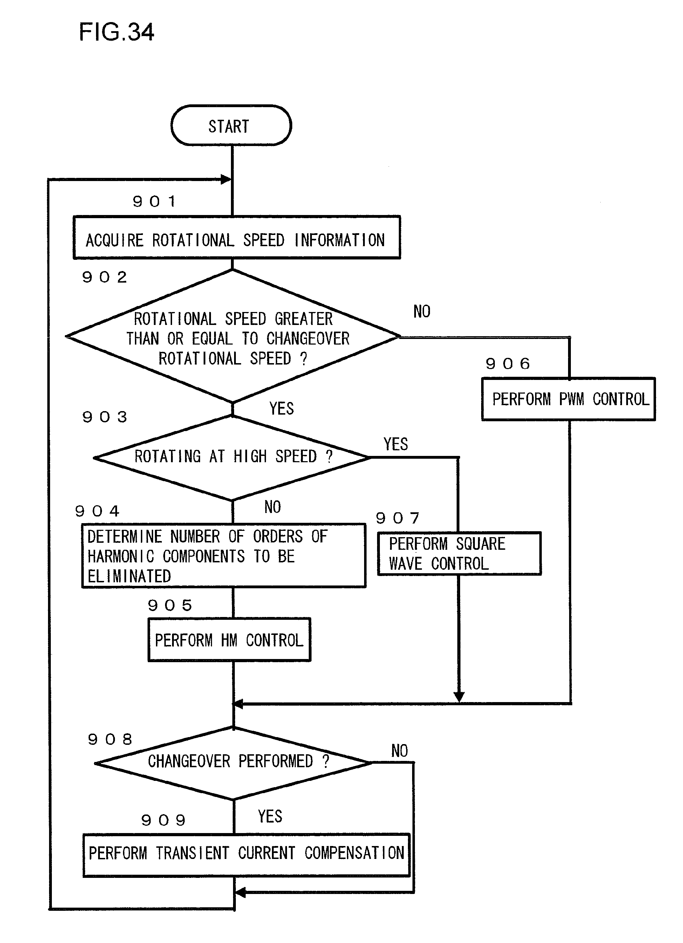

A flow chart for the motor control procedure performed by the control circuit 172 according to the second embodiment of the present invention explained above is shown in Fig. 34. In the steps 901 through 907, the control circuit 172 performs similar processing to that performed in the flow chart of Fig. 30 for the first embodiment.

In a step 908, the control circuit 172 makes a decision as to whether or not a changeover of control mode has been made. If the control mode has been changed over from PWM control to HM control, or from HM control to PWM control, then the control circuit 172 transfers the flow of control to a step 909. On the other hand, if no changeover of control mode has been performed, then the control circuit 172 returns the flow of control to the step 901 and the previous processing is repeated. It should be understood that the result of the decision in the step 908 is sent to the transient current compensator 460 by a compensator interrupt signal being outputted from the pulse modulator 430 for HM control or from the pulse modulator 440 for PWM control.

In the step 909, the control circuit 172 generates a compensation current by generating a compensation pulse according to the method previously described, and performs compensation of the transient current generated in the phase current with the transient current compensator 460. After the step 909 has been executed, the control circuit 172 returns the flow of control to the step 901 and the previous processing is repeated.

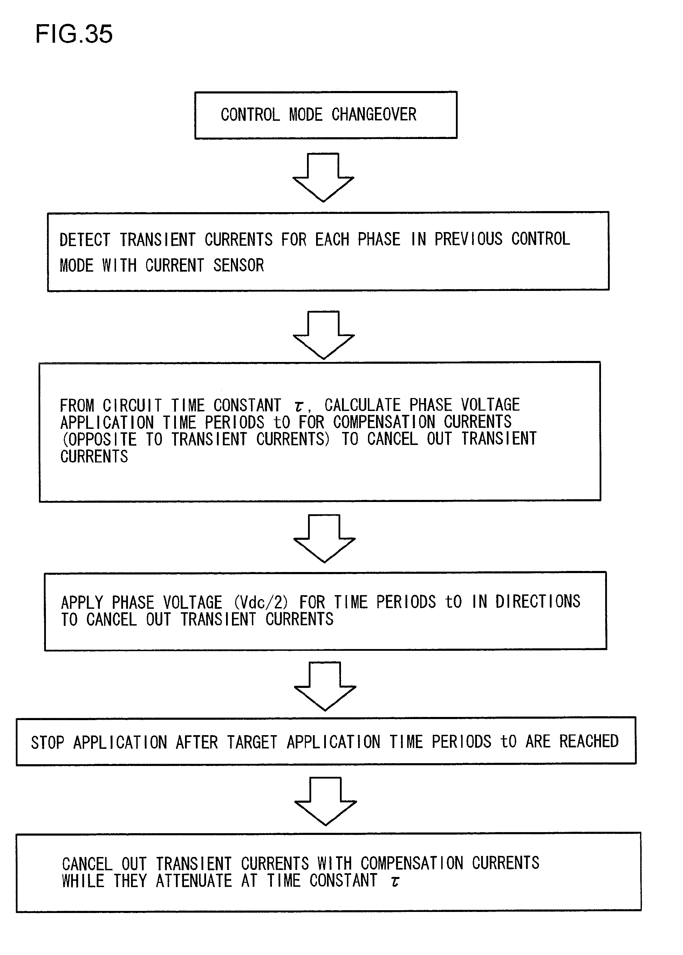

Now, the details of the transient current compensation in the step 909 will be explained with reference to the flow chart of Fig. 35. Initially, directly before the changeover of control mode, the transient current compensator 460 detects the transient currents in the U phase, the V phase, and the W phase. This detection of the transient currents is performed by using the current sensor 180. Next, the transient current compensator 460 calculates a phase voltage application time period t0 for each of the phases while using a circuit time constant $\tau$ determined in advance, so that the compensation currents to be created have appropriate magnitudes and appropriate orientations for canceling out the transient currents that were detected.

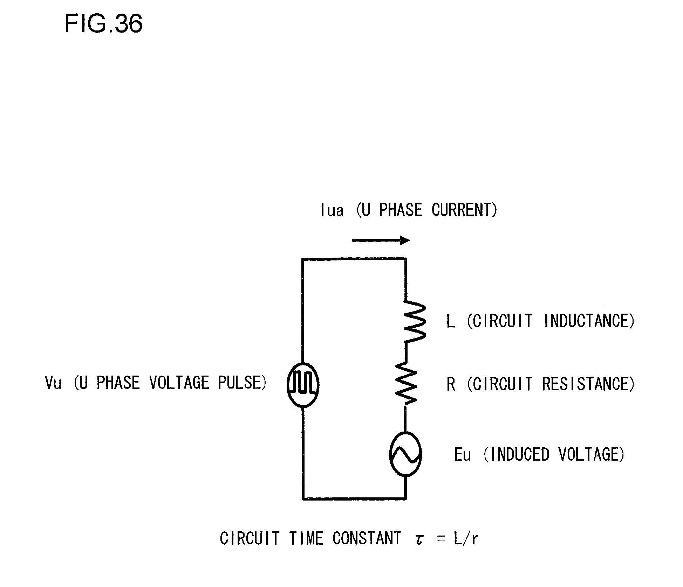

This calculation of the phase voltage application time periods t0 is performed on the basis of the circuit model shown in Fig. 36. In other words, a circuit time constant $\tau=L/r$ is calculated from the circuit inductance L and the circuit resistance r that are determined in advance, and, on the basis of this circuit time constant $\tau$ and the predetermined induced voltage Eu, a phase voltage application time period t0 is determined as the pulse width for a U phase voltage pulse Vu, in order to cancel out the U phase voltage lua that has been detected as the U phase transient current. Here, if it is desired to cancel out the transient current perfectly, the compensation current should be maintained for the phase voltage application time period t0, until the compensation current becomes balanced with the transient current. It should be understood that while, in Fig. 36, a circuit model for the U phase is shown by way of example, the same procedure is used for the V phase and for the W phase.

Next, the transient current compensator 460 starts application of the phase voltage to each phase according to the phase voltage application time periods t0 that have been calculated. Here, phase voltages of amplitudes Vdc/2 are applied in the directions to cancel out the transient currents for just the calculated phase voltage application time periods t0. When the time from the start of application of the phase voltage reaches the target application time period t0 (i.e. the phase voltage application time period) for each phase, the transient current compensator 460 stops application of the phase voltage to that phase. After the application of the phase voltage by the transient current compensator 460 has been terminated, the transient current attenuates with the time constant $\tau$ while being cancelled out by the compensation current. The compensation of the transient currents in this step 909 is performed as explained above.

According to the second embodiment of the present invention as explained above, when changeover is performed between the HM control mode and the PWM control mode, compensation pulses are outputted from the power conversion device 140 for compensating for transient currents generated in the AC current flowing to the motor-generator 192, using the transient current compensator 460. Due to this, it is possible quickly to stabilize the rotation of the motor-generator 192 during changing over of the control mode.

It should be understood that it would also be acceptable to arrange to output a compensation pulse in order to compensate for a transient current in other circumstances than during the changing over of control mode as described above. For example, it would be possible to output a compensation pulse using the transient current compensator 460 in order to compensate for a transient current when changing the number of orders of harmonic components that are to be eliminated in the HM control mode, or when the modulation index or the motor rotational speed changes abruptly or the like, or indeed during any transition of state in which it is thought that a transient current may be generated. Or, it would also be acceptable to arrange to determine whether or not to output a compensation pulse, by deciding upon the presence or absence of a transient current on the basis of detection of the phase current. It would be acceptable to perform this type of compensation pulse output in addition to outputting compensation pulses during changeover of the control mode, or instead of outputting compensation pulses during changeover of the control mode.

- The third embodiment -

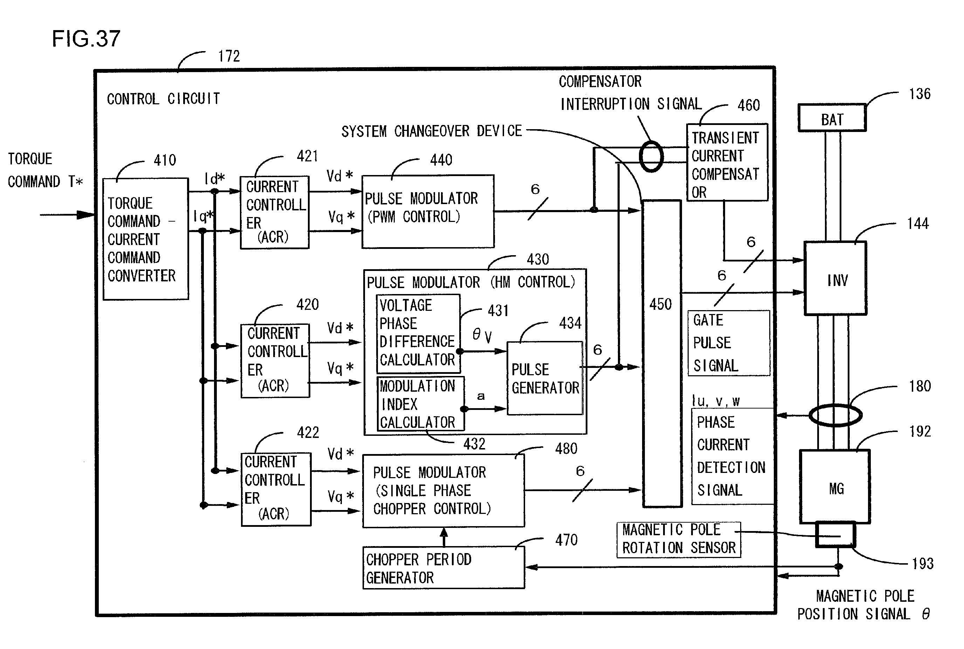

A motor control system with a control circuit 172 according to a third embodiment of the present invention is shown in Fig. 37. As compared with the motor control system according to the second embodiment shown in Fig. 31, this motor control system further includes a current controller (ACR) 422, a chopper period generator 470, and a pulse modulator 480 for single phase chopper control.

In a similar manner to the current controllers (ACRs) 420 and 421, the current controller (ACR) 422 calculates a d axis voltage command signal Vd* and a q axis voltage command signal Vq* on the basis of the d axis current command signal Id* and the q axis current command signal Iq* that are outputted from the torque command to current command converter 410, and on the basis of the phase current detection signals lu, 1v, and lw of the motor-generator 192 that are detected by the current sensor 180. And the d axis voltage command signal Vd* and the q axis voltage command signal Vq* that are thus obtained by the current controller (ACR) 422 are outputted to the pulse modulator 480 for single phase chopper control.

The chopper period generator 470 outputs to the pulse modulator 480 a chopper period signal that is repeated at a predetermined period. The period of this chopper period signals is set in advance, in consideration of the inductance of the motor-generator 192. And the pulse modulator 480 generates a pulse signal for single phase chopper control on the basis of this chopper period signal from the chopper period generator 470, and outputs it to the changeover device 450. In other words, the period of the pulse signal for single phase chopper control outputted by the pulse modulator 480 is determined according to the inductance of the motor-generator 192.

When it is decided that the motor-generator 192 is in the stopped state or in the very low speed rotational state, the changeover device 450 selects the pulse signal for single phase chopper control that is outputted from the pulse modulator 480, and outputs it to the driver circuit 174 (not shown in the figures). Due to this, the power conversion device 140 is caused to perform single phase chopper control.

The pulse signal for single phase chopper control outputted by the pulse modulator 480 is a signal for, when the motor-generator 192 is in the stopped state or in a very low speed rotational state in which appropriate motor control cannot be performed, raising the rotational speed of the motor generator 192 until appropriate motor control becomes possible. It should be understood that, when the motor-generator 192 is in the stopped state or in a very low speed rotational state, it becomes impossible to perform appropriate motor control because a magnetic pole position signal $\theta$ that specifies this rotational state cannot be obtained correctly from the magnetic pole rotation sensor 193. The period of the pulse signal for single phase chopper control is determined according to the chopper period signal from the chopper period generator 470.

If HM control is performed when as described above the motor-generator 192 is in the stopped state or in a very low speed rotational state, then one or the other of the first interval or the second interval described above is maintained for a long period of time. It should be understood that the first interval is the electrically continuous interval in which, individually for each phase, the IGBT 328 for its upper arm or the IGBT 330 for its lower arm is turned ON and current is supplied from the battery 136 to the motor-generator 192, and the upper arm or lower arm is turned ON for the one phase while opposite arms are turned ON for the other two phases. Moreover, the second interval is the three phase short circuited interval in which, for all of the phases, all of the IGBTs 328 for the upper arms or all of the IGBTs 330 for the lower arms are turned ON together, and the torque is maintained by the energy accumulated in the motor-generator 192.

If the first interval is maintained for a long time period, then this can be a cause that leads to anomalous generation of heat or to damage, because a locked current (a DC current) flows continuously during this interval in the IGBT 328 or 330 that is ON at this time. On the other hand, if the second interval is maintained for a long time period, then it becomes impossible to start the motor-generator 192 because power cannot be supplied to the motor-generator 192. Accordingly when in this embodiment it has been decided that the motor-generator 192 is in the stopped state or in a very low speed rotational state and PWM control should not be employed, then the single phase chopper control mode is employed in order to avoid getting into this type of difficult situation, and it is arranged to output the pulse signal for single phase chopper control from the control circuit 172 to the driver circuit 174 as a modulated wave. And drive signals are outputted by the driver circuit 174 to the IGBTs 328 and 330 of the power switching circuit 144 according to this modulated wave.

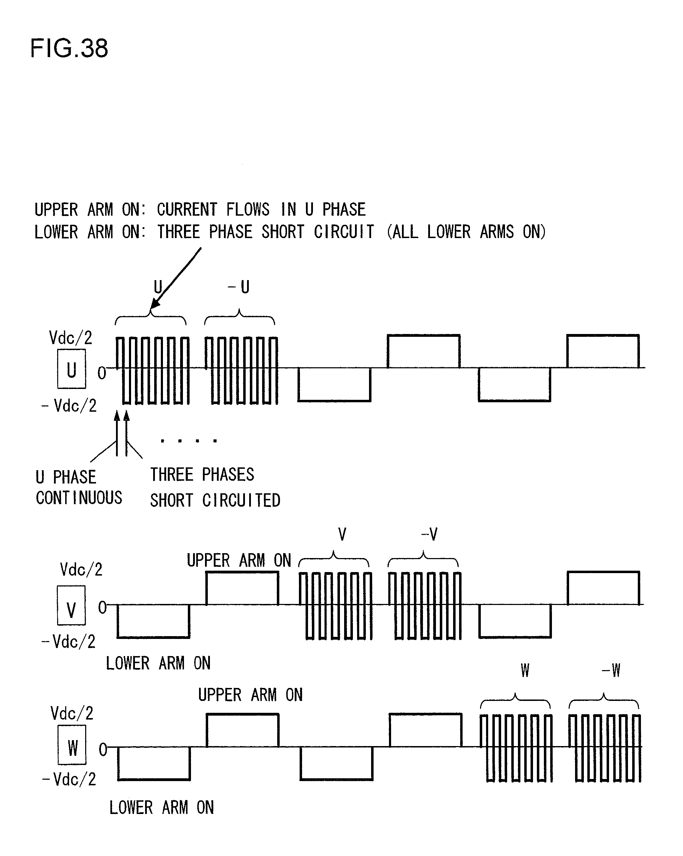

An example of single phase chopper control using a pulse signal that is outputted from the pulse modulator 480 is shown in Fig. 38. In Fig. 38, an example is shown of the phase voltage waveforms when single phase chopper control is performed in sequence for the U phase, for the V phase, and for the W phase. Initially the voltages for the V phase and for the W phase are maintained at -Vdc/2, while the U phase voltage is changed between +Vdc/2 and -Vdc/2 in the form of pulses. At this time, the pulse width is determined according to the chopper period signal outputted by the chopper period generator 470. When this is done, during the intervals in which the U phase voltage is +Vdc/2, since the upper arm for the U phase being turned ON and the lower arms for the V phase and for the W phase are both turned ON, accordingly a U phase continuous interval is created in which current flows in the U phase. Furthermore, during the intervals in which the U phase voltage is -Vdc/2, the lower arms for the U phase, for the V phase, and for the W phase are all turned ON, so that a three phase short circuited interval is created.

Next, while changing the U phase voltage in the same manner between +Vdc/2 and -Vdc/2 in the form of pulses, the voltages for the V phase and for the W phase are brought to +Vdc/2. At this time, during the intervals in which the U phase voltage is -Vdc/2, since the lower arm for the U phase being turned ON and the upper arms for the V phase and for the W phase are both turned ON, accordingly a U phase continuous interval is created in which current flows in the U phase. Furthermore, during the intervals in which the U phase voltage is +Vdc/2, the upper arms for the U phase, for the V phase, and for the W phase are all turned ON, so that a three phase short circuited interval is created.

Subsequently, in a similar manner for the V phase and for the W phase: while the V phase voltage is changed between +Vdc/2 and -Vdc/2 in the form of pulses, the voltages for the U phase and for the W phase are initially maintained at -Vdc/2, and subsequently at +Vdc/2. Moreover, while the W phase voltage is changed between +Vdc/2 and -Vdc/2 in the form of pulses, the voltages for the U phase and for the V phase are initially maintained at -Vdc/2, and subsequently at +Vdc/2. By repeating this type of single phase chopper control, it is possible alternatingly to create intervals in which each of the U phase, the V phase, and the W phase goes conducting, and three phase short circuited intervals, irrespective of the electrical angle. By doing this, even though the motor-generator 192 is in the stopped state or in a very low speed rotational state, nevertheless it is possible to increase the rotational speed of the motor-generator 192 from this state.

It should be understood that when, due to single phase chopper control having been performed as described above, the rotational speed of the motor-generator 192 has risen and it has escaped from the stopped state and from the very low speed rotational state, then control is changed over from single phase chopper control to some other form of control, i.e. to PWM control or to HM control. Thereafter, motor control is performed according to a similar method to that explained above in connection with the second embodiment.

A flow chart for the motor control procedure performed by the control circuit 172 according to the third embodiment of the present invention explained above is shown in Fig. 39. In the steps 901 through 909, the control circuit 172 performs similar processing to that performed in the flow chart of Fig. 34 for the second embodiment.

In a step 910, on the basis of the rotational speed information acquired in the step 901, the control circuit 172 makes a decision as to whether or not PWM control is to be performed, by judging as to whether of not the motor-generator 192 is in the stopped state or in a very low speed rotational state. If the rotational speed is less than some predetermined rotational speed so that it is decided that the motor-generator 192 is in the stopped state or in a very low speed rotational state, in other words in a situation in which it is decided that it is not possible to detect the rotational state of the motor-generator 192 properly because no adequate magnetic pole position signal θ is being received from the magnetic pole rotation sensor 193, then it is not decided that PWM control is to be performed, and the flow of control is transferred to a step 911. But if this is not the case then it is decided that PWM control is to be performed, the flow of control is transferred to the step 906, and PWM control is performed as previously described.

In the step 911, the control circuit 172 performs single phase chopper control for the region in which the rotational speed is extremely low, as shown in Fig. 3. Here, along with the pulse signal for single phase chopper control being generated by the pulse modulator 480 by the method of generation previously described on the basis of the chopper period signal from the chopper period generator 470, this pulse signal is selected by the changeover device 450, and is outputted from the control circuit 172 to the driver circuit 174. After this step 911 has been executed, the control circuit 172 returns the flow of control to the step 908.

It should be understood that, in the third embodiment of the present invention explained above, a motor control system has been explained by way of example that is based upon the motor control system of the second embodiment shown in Fig. 31, with the further addition of the current controller (ACR) 422, the chopper period generator 470, and the pulse modulator 480 for single phase chopper control. However, it would also be possible to employ the motor control system according to the first embodiment shown in Fig. 6 as a basis, and to additionally provide these elements thereto.

According to the third embodiment as explained above, it is decided whether or not it is possible to detect the rotational state of the motor-generator 192 and moreover whether or not PWM control is to be performed (in the step 910 of Fig. 39), and, on the basis of the result of this decision, the predetermined pulse signal for single phase chopper control is outputted by the pulse modulator 480 for single phase chopper control (in the step 911) for forming the first intervals and the second intervals alternatingly for each phase, irrespective of the electrical angle. Since this is done, even in a situation in which appropriate motor control cannot be performed because the motor-generator 192 is in the stopped state or in a very low speed rotational state, nevertheless it is still possible to increase the rotational speed of the motor-generator 192 until appropriate motor control becomes possible.

- Variant embodiments -

The embodiments explained above may also be varied in the following ways.

(1) In the embodiments described above, it was arranged to change over the control mode of the power conversion device 140 by performing HM control (including square wave control) if the motor rotational speed was greater than or equal to a predetermined changeover rotational speed, while performing PWM control if the motor rotational speed was less than the changeover rotational speed. However this type of changeover of control mode is not limited to the forms explained with reference to the embodiments; it would be possible to apply one or more changeovers at any desired rotational speed. For example, if the motor rotational speed can vary between 0 and 10,000 rpm, it would be possible to perform PWM control in the range from 0 to 1,500 rpm, to perform HM control in the range from 1,500 to 4,000 rpm, to perform PWM control in the range from 4,000 to 6,000 rpm, and to perform HM control in the range from 6,000 to 10,000 rpm. If this is done, it is possible to use the optimum control mode according to the motor rotational speed, and thus to implement motor control that is refined to a yet further level of delicacy.

(2) In the embodiments described above, it was arranged to perform PWM control when the motor rotational speed was less than the predetermined changeover rotational speed. However, if the present invention is applied to a hybrid electric vehicle or the like, it would also be acceptable to arrange to perform HM control instead of PWM control when the motor rotational speed is low, with the objective of encouraging pedestrians and so on near the vehicle to be careful. When HM control is performed while the motor rotational speed is low, current distortion takes place because harmonic components are not completely eliminated, and this can be a cause of motor operational noise. Accordingly, by intentionally creating motor operational noise in this way, it is possible to encourage pedestrians and so on in the vicinity of the vehicle to be careful. It should be understood that it would also be acceptable to arrange for the driver of the vehicle to be able to make this type of generation of motor operational noise by utilization of HM control effective or ineffective as he desires, by operating a switch or the like. Or, it would also be acceptable to arrange to detect the presence of a pedestrian or the like in the vicinity of the vehicle automatically and, in the event that a pedestrian or the like is thus detected, to perform HM control so as to generate motor operational noise. In this case, such detection of a pedestrian or the like may be performed using methods of various per se well known types, such as for example by the use of an infra-red ray sensor or an imaging means or the like. Yet further, it would also be possible to decide whether or not the current position of the vehicle is within an urban area on the basis of map information stored in advance or the like, and intentionally to generate motor operational noise by applying HM control if the vehicle is within an urban area.

Along with explaining the theory of operation of the pulse modulator 430 for HM control described in Fig. 6 above using Figs. 4 through 6, the case in which the pulse modulator 430 is implemented using a microprocessor has been explained using Fig. 8. Although the operational theory and method of implementation have already been sufficiently explained using Figs. 4 through 8, now they will be explained for a second time.

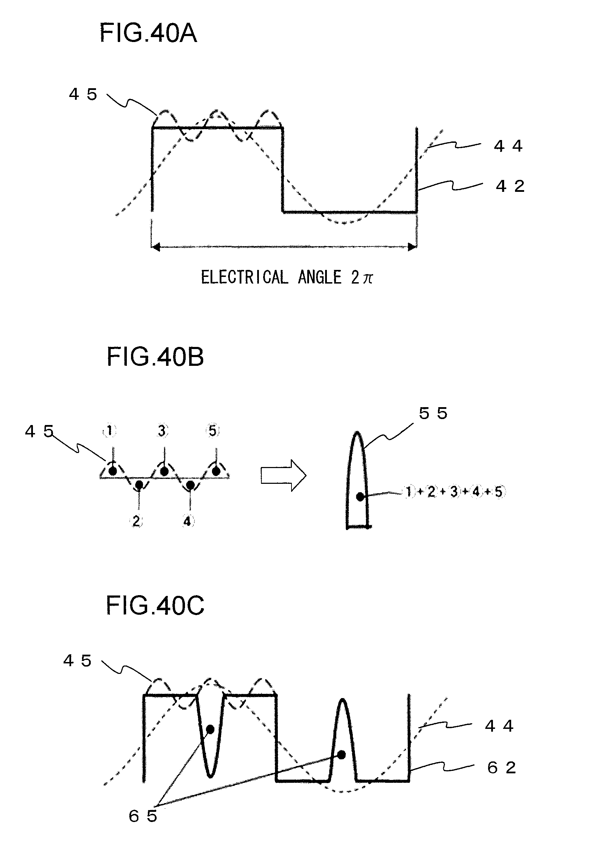

The fundamental theory of the operation of the pulse modulator 430 described above will now be explained for a second time using Figs. 40A through 43. As described above, if an extreme state is supposed in which the number of times of switching is performed is extremely low per unit phase of the AC power that it is desired to obtain by conversion from DC power, for example per one cycle thereof, then the state of square wave control described above comes to be considered. In this square wave control state, as shown in Fig. 40A, the switching elements 328 and 330 of the power switching circuit 144 are controlled so that switching is performed once in each half cycle, in other words so that switching is performed twice in one cycle. With this control the losses due to switching are greatly reduced, because the number of times that switching is performed is remarkably reduced as compared to the case with the PWM control method. However, the obverse of this is that harmonic components (of the fifth order, the seventh order, the eleventh order ... and so on) are included to a substantial extent, and these harmonic components become a cause for distortion. Accordingly, in normal control, in order to reduce the distortion due to the above described harmonic components, it is desirable to increase the number of times of switching of the switching elements of the power switching circuit 144 than that of the switching elements under the control shown in Fig. 40A described above, so as to eliminate the above described harmonic components as much as possible. While the harmonic components that should be eliminated vary according to the objective for which the AC power produced by this conversion process will be employed, the number of times switching is performed as compared with the PWM method is still decreased, since it is not necessary to eliminate all of the harmonic components. For example, with AC power that is to be supplied to a three phase rotating electrical machine, since the harmonic components whose orders are multiples of 3 are mutually cancelled out, no particularly large problem arises if they are not eliminated.

Next, in connection with the above described elimination of harmonic components, by way of example, a method of eliminating the fifth order harmonic component among them will be explained. As shown in Figs. 40A and 40B, the fifth order harmonic component is an oscillatory waveform having positive and negative peak values five times in an interval of electrical angle $\pi$, i.e. in one half cycle of the AC power waveform. In Fig. 40A, apart from its sine wave fundamental, the square wave 42 also includes a large number of harmonic components that are obtained by Fourier expansion, and one among these harmonic components is the fifth order harmonic components 45 described above. As shown in Fig. 40B, when this fifth order harmonic component 45 is overlapped in each unit phase, for example in each half cycle, an overlapped waveform 55 results. And, naturally, when the overlapped waveform 55 is Fourier expanded, the fifth order harmonic component described above results. When eliminating this fifth order harmonic component included in the basic square wave, from the point of view of reducing the number of times that switching of the power switching elements is performed as much as possible, it is desirable to eliminate the harmonic components that it is desired to eliminate all together, as much as possible. Thus, an overlapped waveform 55 of the same area as the fifth order harmonic component included in the square wave before elimination is eliminated at a specified position, as in the figure. In this embodiment, in each half cycle, it is arranged to eliminate the overlapped waveform 55 all collected together as one. By doing this, as described above, it is possible to reduce the number of times that switching of the switching elements 328 and 330 of the power switching circuit 144 is performed in each half cycle.

When the above described overlapped waveform 55 is eliminated from the square wave 42 as described in Fig. 40A, the waveform after this elimination does not contain any fifth order harmonic component. Thus the waveform 62 of Fig. 40C, resulting from eliminating the overlapped waveform 55 of the fifth order harmonic component from the square wave 42 shown in Fig. 40A, does not contain any fifth order harmonic component. The portions 65 of the waveform shown in Fig. 40C have the same area as the eliminated overlapped waveform 55: i.e., the area of these waveform portions 65 is the same as the area of the overlapped waveform 55 but is reversed. In other words, they are waveforms of the same shape, but with their signs inverted.

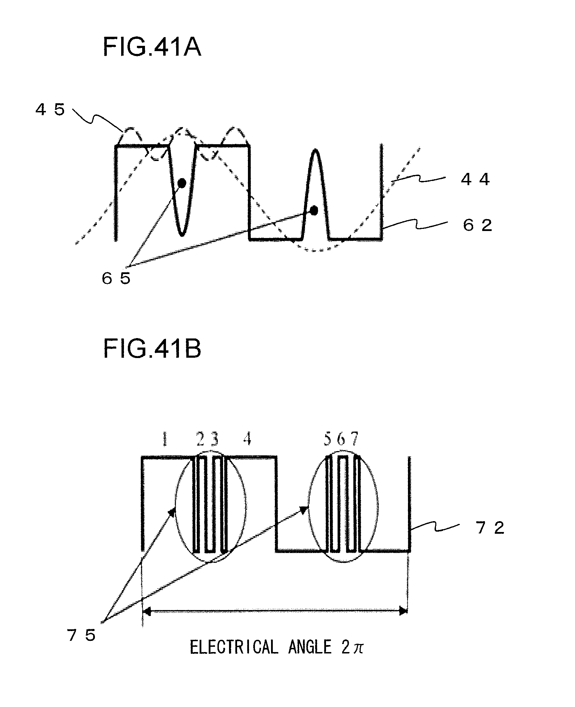

Figs. 41A and 41B shows the waveform for switching control of the switching elements 328 and 330 of the power switching circuit 144, due to the creation of the waveform 62 shown in Fig. 40C. Fig. 41A is the same waveform as the waveform 62 shown in Fig. 40C: by the current waveform shown in Fig. 41A flowing, current may be supplied having an AC waveform from which the fifth order harmonic component has been eliminated. And a waveform that gives the operational timing for flowing the current waveform shown in Fig. 41A is the waveform shown in Fig. 41B. Due to the waveform 75 shown in Fig. 41B, the waveform 65 is created that eliminates the fifth order harmonic component described above.

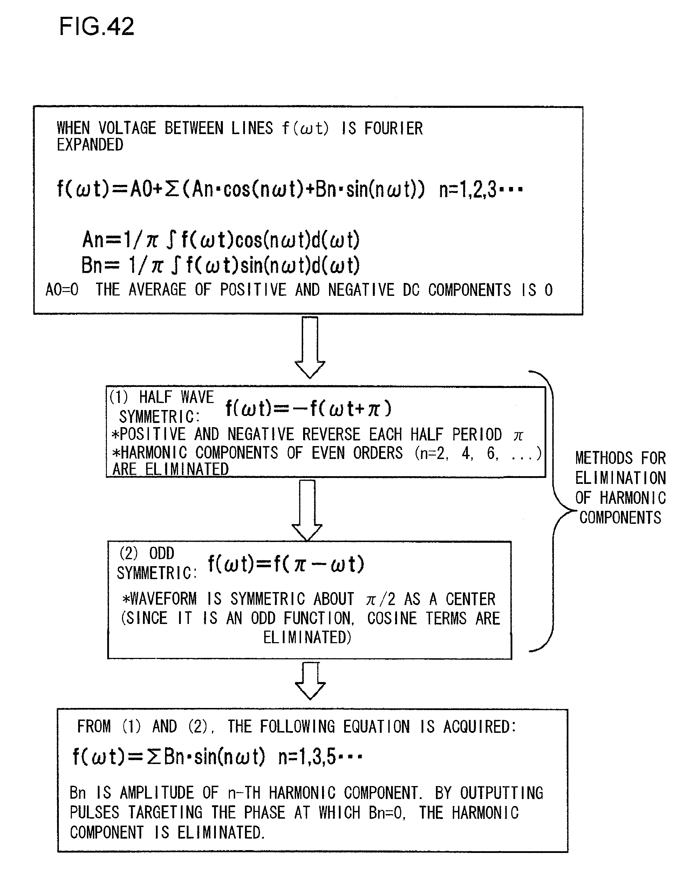

The other harmonic components may be eliminated by employing a similar technique. Fig. 42 is a figure showing a way in which the method of eliminating the harmonic component shown in Figs. 40A, 40B, 40C, 41A, and 41B may be thought of as a flow, when considered on the basis of Fourier series expansion. Here the waveform of the voltage between lines is termed $f(\omega t)$, and this shows the flow for creating the pulses of the waveform of the voltage between lines. A method is shown of obtaining the pulse pattern by adding the conditions $f(\omega t)=-f(\omega t+\pi)$ and $f(\omega t)=f(\pi-\omega t)$ that take into account the symmetry of the pulse waveform. The pulse pattern is obtained by expanding $f(\omega t)$ as a Fourier series, and by solving the equation obtained by putting the harmonic component of the order that is to be eliminated equal to zero.

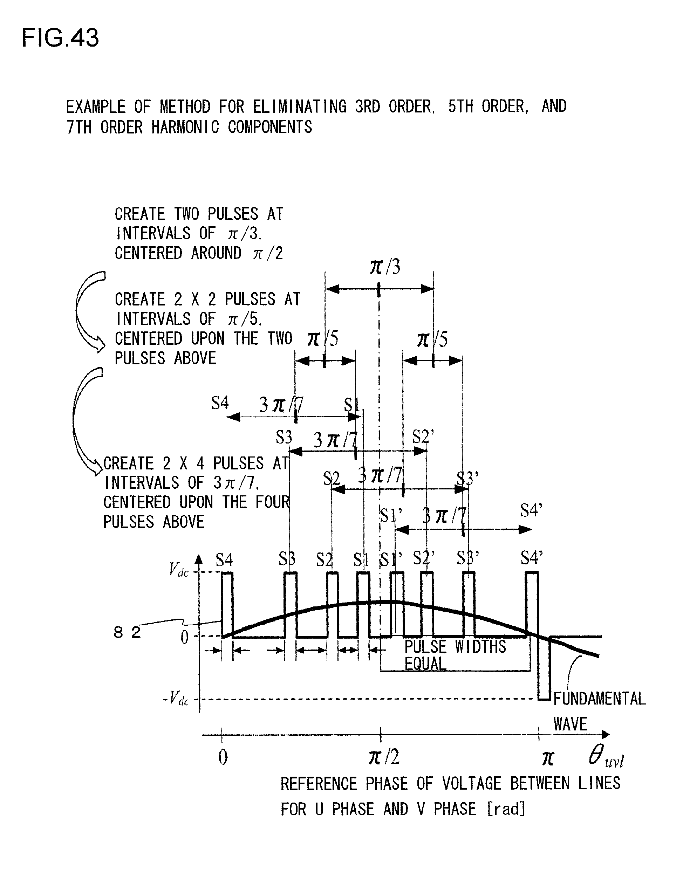

Fig. 43 is a figure showing, as one example, the process of creating a pattern for the voltage between the lines for the U phase and for the V phase in which the harmonic components of the third order, the fifth order, and the seventh order have been eliminated, and also showing the characteristic features of this pattern. However, the voltage between lines is the electrical potential difference between the terminals for the two phases, and, if the phase voltage of the U phase is termed Vu and the phase voltage of the V phase is termed Vv, then the voltage between the U and V lines Vuv is given by Vuv=Vu-Vv. Since the same is true for the voltage between the lines for the V phase and for the W phase and for the voltage between the lines for the W phase and for the U phase, accordingly in the following, as a representative example, only the creation of the pattern for the voltage between the lines for the U phase and for the V phase will be explained.

The horizontal axis in Fig. 43 is an axis that takes the fundamental wave of the voltage between the lines for the U phase and for the V phase as a reference, and in the following, as an abbreviation, will be termed the reference phase $\theta uvl$ of the voltage between the U and V lines. This reference phase $\theta uvl$ of the voltage between the U and V lines corresponds to the electrical angle, i.e. to the horizontal axis in Fig. 40A. It should be understood that the section $\pi \le \theta uvl \le 2\pi$ is omitted from the figure, since it has a shape symmetrical to that of the section $0 \le \theta uv1 \le \pi$, but with the sign of the waveform of the voltage pulse train inverted. As shown in Fig. 43, the fundamental wave of the voltage pulses is a sine wave voltage that takes $\theta uvl$ as a reference. According to the procedure shown in the figure, the pulses that are generated are arranged in positions as shown in the figure with respect to $\theta uvl$, centered around $\pi/2$ of this fundamental wave. Here the positions in which the pulses of Fig. 43 are arranged may be specified according to electrical angle, since as described above $\theta uvl$ is a parameter that corresponds to electrical angle. Accordingly, in the following, the positions in which these pulses are arranged will be defined as specific electrical angle positions. In this way, the pulse trains S 1 through S4 and S1' through S4' are defined. These pulse trains have spectral distributions in which no harmonic components of the third order, the fifth order, and the seventh order of the fundamental wave are included. To put it in another manner, these pulse trains are waveforms in which the harmonic components of the third order, the fifth order, and the seventh order have been eliminated from the square wave defined over the interval $0 \le \theta uv1 \le 2\pi$. It should be understood that it would also be possible for the orders of the harmonic components to be eliminated to be other than the third order, the fifth order, and the seventh order. The harmonic components may be eliminated are eliminated up to the highest order when the frequency of the fundamental wave is low, and may be eliminated only at low orders when the frequency of the fundamental wave is high. For example, for the sake of convenience, the orders of harmonic components to be eliminated may be changed as follows: when the rotational speed is low, the harmonic components of the fifth order, the seventh order, and the eleventh order may be eliminated; when the rotational speed rises somewhat, this may be changed to elimination of only the harmonic components of the fifth order and the seventh order; and when the rotational speed rises further, only the harmonic component of the fifth order may be eliminated. This is because the current pulsations become small in the high rotational speed region, since the winding impedance of the motor becomes large.

In a similar manner, in some cases the number of harmonic components to be eliminated may change according to the magnitude of the torque. For example, the number of harmonic components to be eliminated may change in the following manner as the torque increases under the condition that the rotational speed remains fixed: when the torque is low, a pattern in which the harmonic components of the fifth order, the seventh order, and the eleventh order are eliminated may be selected; when the torque increases somewhat, a pattern in which the harmonic components of the fifth order and the seventh order are eliminated may be selected; and, when the torque increases further, a pattern in which only the harmonic component of the fifth order is eliminated may be selected.

Furthermore not only, as described above, may the number of harmonic components to be eliminated decrease along with increase of the torque or increase of the rotational speed, but conversely, in some cases, the number of harmonic components to be eliminated may increase, or may not change, even though the torque and/or the rotational speed increases or decreases. This kind of condition must be determined upon in consideration of the magnitudes of indicators such as torque ripple of the motor, noise, EMC and so on, and accordingly the pattern of change of the number of harmonic components to be eliminated along with rotational speed and/or torque is not to be considered as being limited to being monotonic.

As described above, in the embodiment shown in Figs. 40A through 43, it is possible to select the number of orders of harmonic components that it is desired to eliminate in consideration of the influence of distortion upon the control object. The more the number of orders of harmonic components that are to be eliminated in this way increases, the more does the number of times of switching of the switching elements 328 and 330 of the power switching circuit 144 increase. Since, in the embodiment described above, it is possible to select the number of orders of harmonic components that it is desired to eliminate in consideration of the influence of distortion upon the control object, accordingly it is possible to prevent the elimination of more types of harmonic components than necessary, and therefore it is possible to reduce the number of times that the switching elements 328 and 330 of the power switching circuit 144 are switched in an appropriate manner in consideration of the influence of distortion upon the control object.

In the control of the voltage between lines as explained in connection with the embodiments described above, control is performed so that the switching timings in the interval from phase 0 [radians] to $\pi$ [radians], i.e. in half a cycle of the AC power that it is desired to output, and the switching timings in the interval from phase $\pi$ [radians] to $2\pi$ [radians], i.e. in the other half cycle of the AC power, become the same, and thus it is possible to simplify the control and to enhance the controllability. Furthermore, in the intervals from phase 0 [radians] to $\pi$ [radians] and from phase $\pi$ [radians] to $2\pi$ [radians], control is performed at the same switching timings centered around phase $\pi/2$ and $3\pi/2$ respectively as well, and thus it is possible to simplify the control and to enhance the controllability.

Yet further, since the harmonic component that it is desired to eliminate is overlapped as explained in connection with Fig. 40B, and since it is gotten rid of in this overlapped state as explained in connection with Fig. 40C, accordingly it is possible to reduce the number of times that switching of the switching elements 328 and 330 of the switching circuit 144 is performed.

Various embodiments have been described above by way of example; however, the present invention is not to be considered as being limited by the details of these embodiments, but only by the terms of the Claims, that follow.

**Claims**

1.  A power conversion device, comprising:

    DC terminals (314, 316) for receipt of DC power;
    a power switching circuit (144) that receives DC power and outputs AC power, including a plurality of series circuits (150) in each of which a switching element that operates as an upper arm (328) and a switching element that operates as a lower arm (330) are connected in series, and;
    AC terminals (159) for output of AC power;
    a driver circuit (174) that controls the switching operation of the switching elements (328, 330) incorporated in the power switching circuit (144); and
    a control circuit (172) that controls the driver circuit (174); wherein:

    the power switching circuit (144) is configured that the plurality of the series circuits (150) are all connected in parallel to the DC terminals (314, 316) and AC voltages generated at the connection portions between the switching elements that operate as the upper arms (328) and the switching elements that operate as the lower arms (330) are supplied to the AC terminals (159);
    the control circuit (172) generates and supplies to the driver circuit (174) signals for controlling the switching operation of the switching elements (328, 330) by a PWM method in a first operational region in which the frequency of the AC power to be outputted is low;
    the control circuit (172), generates and supplies to the driver circuit (174) signals for controlling the switching operation of the switching elements (328, 330) at timings based upon the phase of the AC power to be outputted in an operational region in which the frequency of the AC power to be outputted is higher than in the first operational region; and
    the driver circuit (174) controls the switching operation of the switching elements (328, 330) on the basis of the signals from the control circuit (172).

**2.** A power conversion device according to Claim 1, wherein:

the power switching circuit (144) generates three-phase AC power having a U phase, a V phase, and a W phase; and,

in the state in which the switching operation of the switching elements (328, 330) is controlled at timings based upon the phase of the AC power to be outputted, in order to generate AC voltages between the phases, the driver circuit (174) supplies to the power switching circuit (144) signals specifying switching timings for an interval from phase angle 0 to phase angle $\pi$ of the AC voltage, and signals specifying switching timings for an interval from phase angle $\pi$ to phase angle $2\pi$, which are the same as the switching timings for the interval from phase angle 0 to phase angle $\pi$.

**3.** A power conversion device according to Claim 1 or 2, wherein, in the state in which the switching operation of the switching elements (328, 330) is controlled at timings based upon the phase of the AC power to be outputted:

in first control to eliminate harmonic components in which one or more orders of harmonic components are to be eliminated, the control circuit (172) generates and supplies to the driver circuit (174) first signals for controlling the switching operation for each half cycle of an AC waveform determined on the basis of the harmonic components that are to be eliminated;

in second control to eliminate harmonic components in which the number of orders of harmonic components to be eliminated is greater than in the first control to eliminate harmonic components, the control circuit (172) generates and supplies to the driver circuit (174) second signals for controlling the switching operation for each half cycle of an AC waveform determined on the basis of the harmonic components that are to be eliminated; and, due to control by the driver circuit (174), the power switching circuit (144) performs more switching operations per half cycle of the second control to eliminate harmonic components, than the number of switching operations performed per half cycle of the first control to eliminate harmonic components.

**4.** A power conversion device, comprising:

a power converter of a three phase full bridge type that includes upper arm switching elements (328) and lower arm switching elements (330); and

a controller that outputs drive signals to the switching elements (328, 330) for each phase;

wherein:

by the switching operation of the switching elements (328, 330) according to the drive signals, voltage supplied from a DC power supply (136; 500) is converted into AC output voltages each of which are shifted by $2\pi/3$ of electrical angle from one another, and the AC output voltages are supplied to a three phase AC motor (192; 194; 195); and,

on the basis of a predetermined condition, changeover is performed between:

an HM control mode for creating a first interval in which the switching elements for the upper arms (328) and the switching elements for the lower arms (330) are turned ON for different phases and current is supplied from the DC power supply (136; 500) to the motor (192; 194; 195), and a second interval in which, for all of the phases, either all of the switching elements for the upper arms (328) or all of the switching elements for the lower arms (330) are turned ON and torque is maintained by the energy accumulated in the motor (192; 194; 195), alternatingly according to electrical angle; and

a sine wave PWM control mode for supplying current from the DC power supply (136; 500) to the motor (192; 194; 195) by the switching elements being turned ON according to pulse widths that are determined on the basis of comparison of sine wave command signals and a carrier wave.

**5.** A power conversion device according to Claim 4, wherein the changeover between the HM control mode and the sine wave PWM control mode is performed on the basis of the rotational speed of the motor (192; 194; 195).

**6.** A power conversion device according to Claim 4 or 5, wherein the HM control mode further includes a square wave control mode in which the switching elements (328, 330) for each phase are turned ON once and OFF once for each rotation of the motor (192; 194; 195).

**7.** A power conversion device according to Claim 6, wherein:

in the HM control mode, at least one of the electrical angle position at which the first interval is created and the length of the first interval is changed, so that a harmonic component of the AC current flowing to the motor (192; 194, 195) is changed to a desired value; and
transition to the square wave control mode is performed by change of that harmonic component.

**8.** A power conversion device according to at least one of Claims 4 to 7, further comprising a transient current compensator (460) that outputs a compensation pulse for compensating a transient current generated in the AC current flowing to the motor (192; 194; 195); wherein:

the transient current compensator (460) outputs the compensation pulse when the changeover between the HM control mode and the sine wave PWM control mode is performed.

**9.** A power conversion device according to Claim 8, wherein the transient current compensator (460) outputs the compensation pulse when a predetermined condition is satisfied, instead of, or in addition to, when the changeover between the HM control mode and the sine wave PWM control mode is performed.

**10.** A power conversion device according to at least one of Claims 4 to 9, further comprising:

a decision device that makes a decision as to whether or not it is possible to detect the rotational state of the motor (192; 194; 195); and
a chopper controller that, on the basis of the result of the decision by the decision device, outputs a predetermined signal for single phase chopper control for creating the first interval and the second interval alternatingly for each phase, irrespective of electrical angle.

**11.** A power conversion device according to Claim 10, wherein the period of the signal for single phase chopper control is determined according to the inductance of the motor (192; 194; 195).

**12.** A power conversion device, comprising:

a power converter of a three phase full bridge type that includes upper arm switching elements (328) and lower arm switching elements (330); and
a controller that outputs drive signals to the switching elements (328, 330) for each phase;

wherein:

by the switching operation of the switching elements (328, 330) according to the drive signals, voltage supplied from a DC power supply (136; 500) is converted into AC output voltages each of which are shifted by $2\pi/3$ of electrical angle from one another, and the AC output voltages are supplied to a three phase AC motor (192; 194; 195);
a first interval in which the switching elements for the upper arms (328) and the switching elements for the lower arms (330) are turned ON for different phases and current is supplied from the DC power supply (136; 500) to the motor (192; 194; 195), and a second interval in which, for all of the phases, either all of the switching elements for the upper arms (328) or all of the switching elements for the lower arms (330) are turned ON and torque is maintained by the energy accumulated in the motor (192; 194; 195), are created alternatingly according to electrical angle;
by changing the length of the first interval according to a modulation index, a harmonic component of the AC current flowing to the motor (192; 194; 195) is changed to a desired value; and
when the modulation index is a maximum, square wave control is performed in which the switching elements (328; 330) for each phase are turned ON once and OFF once for each rotation of the motor (192; 194, 195).

**13.** A power conversion device, comprising:

an inverter circuit that includes a plurality of switching elements (328, 330) for converting DC power into three phase AC power for supply to a three phase AC motor (192; 194, 195); and
a control circuit (172) that receives a control command for controlling the three phase AC motor (192; 194; 195), and that generates control signals for controlling the switching operation of the plurality of switching elements (328, 330) of the inverter circuit; wherein:
the control circuit (172) has a first control mode in which a carrier wave is generated, and the continuity operation of the plurality of switching elements (328, 330) of the inverter circuit is controlled on the basis of the carrier wave and of the AC signal to be outputted, and a second control mode in which, in order to suppress a harmonic component of the three phase AC power, the inverter circuit outputs a phase position signal that specifies phase positions for the plurality of switching elements (328, 330) of the inverter circuit to go continuous, and the continuity operation of the plurality of switching elements (328, 330) of the inverter circuit is controlled on the basis of the phase position signal; and

the inverter circuit is controlled in the first control mode in a first operational region in which the rotational speed of the three phase AC motor (192; 194; 195) is relatively low, and the inverter circuit is controlled in the second control mode in a second operational region in which the rotational speed of the three phase AC motor (192; 194; 195) is higher than in the first rotational speed region.

14. A power conversion device according to Claim 13, wherein the control circuit (172) includes:

a carrier wave generation unit (492) that receives a command value for controlling the three phase AC motor (192; 194; 195) and a rotational speed signal for the three phase AC motor (192; 194; 195);

a first pulse generation unit that outputs signals created on the basis of the command value and the rotational speed signal to control the continuity operation of the plurality of switching elements (328, 330) of the inverter circuit, according to the AC signal to be outputted and the carrier wave;

a phase position signal output unit that outputs the phase position signal; and a second pulse generation unit that outputs signals to control the continuity operation of the plurality of switching elements (328, 330) of the inverter circuit, on the basis of the phase position signal; wherein:

in the second operational region in which the rotational speed of the three phase AC motor (192; 194; 195) is higher than in the first rotational speed region, the control circuit (172) controls the continuity operation of the plurality of switching elements (328, 330) of the inverter circuit by the output of the second pulse generation unit.

15. A power conversion device according to Claim 13 or 14, wherein:

the inverter circuit includes a U phase circuit in which a plurality of the switching elements (328, 330) are connected together in series at a U phase connection point, a V phase circuit in which a plurality of the switching elements (328, 330) are connected together in series at a V phase connection point, and a W phase circuit in which a plurality of the switching elements (328, 330) are connected together in series at a W phase connection point;

AC voltages to be supplied to the three phase AC motor (192; 194; 195) are generated between each pairs of the U phase connection point, the V phase connection point, and the W phase connection point, by controlling the continuity operation of the plurality of switching elements (328, 330); and

in the second control mode, the control circuit (172) controls the continuity operation of the switching elements (328, 330) so that the number of times of continuity of the inverter circuit for supplying the DC power via the inverter circuit becomes a plurality in a half cycle of the AC power supplied to the three phase AC motor (192; 194; 195) for each phase.

16. A power conversion device according to at least one of Claims 13 to 15, wherein:

the control circuit (172) further has a square wave control mode in which the DC power is supplied to the three phase AC motor (192; 194; 195) by making the inverter circuit go continuous once per each half cycle of the AC power supplied to the three phase AC motor (192; 194; 195); and

the control circuit (172) selects the square wave control mode for control of the plurality of switching elements (328, 330) in an operational region in which the rotational speed of the three phase AC motor (192; 194; 195) is higher than in the second operational region.

17. A power conversion device according to Claim 15, wherein:

the control circuit (172) receives a torque command value as the control command; and

in the state in which the rotational speed of the three phase AC motor (192; 194; 195) is in the second operational region and the continuity operation of the plurality of switching elements (328, 330) of the inverter circuit is being controlled in the second control mode, the control circuit (172) controls the continuity operation of the plurality of switching elements (328, 330) so that an interval in which the inverter circuit is continuous and the next interval in which the inverter circuit is continuous are connecting together, and thereby the number of times of continuity of the inverter circuit in a half cycle of the voltages generated between each pairs of the U phase connection point, the V phase connection point, and the W phase connection point is decreased, by increasing the widths of the intervals in which the inverter circuit is continuous and DC power is supplied to the three phase AC motor (192; 194; 195) and decreasing the widths of the intervals in which the inverter circuit is discontinuous; on the basis of increase of the torque command value.

18. A power conversion device according to Claim 17, wherein:

on the basis of increase of the torque command value, the control circuit (172) controls the continuity operation of the plurality of switching elements (328, 330) of the inverter circuit so that the number of times of continuity of the inverter circuit in a half cycle of the voltages between phases generated between each pairs of the U phase connection point, the V phase connection point, and the W phase connection point decreases; and when the torque command value is a maximum, the control circuit (172) controls the switching elements (328, 330) of the inverter circuit in a square wave control mode in which the inverter circuit goes continuous once, and the DC power is supplied once between the connection points, in a half cycle of the voltages between phases.

19. A power conversion device according to at least one of Claims 15 to 18, wherein, if the rotational speed of the three phase AC motor (192; 194; 195) is in a region in which the rotational speed is lower than in the first rotational speed region, the control circuit (172) performs chopper control in which one of the plurality of switching elements (328, 330) included in the series circuit (150) of one of the U phase circuit, the V phase circuit and the W phase circuit, and another of the plurality of switching elements (328, 330) included in the series circuits (150) of the others of the U phase circuit, the V phase circuit and the W phase circuit, are repeatedly made continuous alternatingly.

FIG.1

EP 2 355 319 A2

# FIG.2

EP 2 355 319 A2

38

## FIG.3

SINGLE PHASE CHOPPER CONTROL: STEP 911;
OR PWM CONTROL: STEP 906

SINE WAVE PWM CONTROL MODE: STEP 906

CHANGEOVER LINE

TORQUE

HM CONTROL MODE (INCLUDING SQUARE WAVE CONTROL MODE)

SQUARE WAVE
CONTROL
MODE: STEP
907

ROTATIONAL SPEED

CHANGEOVER ROTATIONAL SPEED
MAY BE VARIED AS DESIRED

FIG.4

PWM CONTROL

GOOD FEATURE: CLOSE TO
SINE WAVE
BAD FEATURE: LARGE
NUMBER OF TIMES OF
SWITCHING, HIGH
SWITCHING LOSSES

SINGLE PULSE (SQUARE WAVE) CONTROL
GOOD FEATURE: LOW NUMBER OF TIMES OF
SWITCHING, LOW SWITCHING LOSSES
BAD FEATURE: HARMONIC COMPONENTS OF
FIFTH ORDER, SEVENTH ORDER, ELEVENTH
ORDER ... ARE INCLUDED

CONTRAST

ELECTRICAL
ANGLE $2\pi$

ELECTRICAL
ANGLE $2\pi$

FIG.5A

FUNDAMENTAL WAVE +
AMPLITUDE OF THIRD ORDER
HARMONIC COMPONENT

FUNDAMENTAL
WAVE

FUNDAMENTAL WAVE + AMPLITUDES OF
THIRD ORDER AND FIFTH ORDER
HARMONIC COMPONENTS

SQUARE WAVE

$4/\pi = 1.27$

0

$\pi$

$2\pi$

-1

$-4/\pi = -1.27$

FIG.5B

FUNDAMENTAL WAVE

AMPLITUDE

THIRD ORDER HARMONIC COMPONENT

FIFTH ORDER HARMONIC
COMPONENT

1.5

1

0.5

0

0.5

1

1.5

1.27

0.42

0.25

$\pi$

$2\pi$

## FIG.6

MOTOR CONTROL COMMAND (TORQUE COMMAND) →

CONTROL CIRCUIT — 172

**410** — TORQUE COMMAND – CURRENT COMMAND CONVERTER

Id* / Iq* →

**421** — CURRENT CONTROLLER (ACR)

Vd* / Vq* →

**440** — PULSE MODULATOR (PWM CONTROL)

6 →

**450** — CHANGE OVER DEVICE

PULSE SIGNAL

6 → 174 → INV (144)

BAT (136)

**420** — CURRENT CONTROLLER (ACR)

Vd* / Vq* →

**430** — PULSE MODULATOR (HM CONTROL)

**431** — VOLTAGE PHASE DIFFERENCE CALCULATOR → θv

**432** — MODULATION INDEX CALCULATOR → a

**434** — PULSE GENERATOR

6 →

PHASE CURRENT DETECTION SIGNAL
Iu, v, w
180

MG (192)

MAGNETIC POLE ROTATION SENSOR
193

θ: MAGNETIC POLE POSITION SIGNAL

EP 2 355 319 A2

FIG.7

VOLTAGE PHASE
SIGNAL

MODULATION
INDEX SIGNAL

434

PHASE FINDER

...

TIMER
COUNTER OR
PHASE
COUNTER
COMPARATOR

... PULSE SIGNAL

435

436

ROTATIONAL SPEED SIGNAL

## FIG.8

START

↓

INPUT MODULATION INDEX — 801

↓

INPUT PHASE — 802

↓

CALCULATE PHASE OF CONTROL SECTION — 803

↓

LOOKUP ROM — 804

↓

OUTPUT SWITCHING PHASES — 805

↓

PERFORM TIMER COUNTER COMPARISON OR PHASE COUNTER COMPARISON — 806

↓

OFF TIME PERIOD LESS THAN OR EQUAL TO PREDETERMINED VALUE ? — 850

NO → OUTPUT PULSE SIGNAL FOR CONTINUOUS ON AT PHASE POSITION THAT OFF TIME PERIOD BECOMES LESS THAN OR EQUAL TO PREDETERMINED VALUE — 851 → END

YES ↓

OUTPUT PULSE SIGNAL — 807

↓

END

FIG.9

START

INPUT MODULATION INDEX                    801

INPUT PHASE                               802

CALCULATE PULSE PATTERN AND PERFORM       820
TIMER COUNTER COMPARISON OR PHASE
COUNTER COMPARISON

OUTPUT PULSE SIGNAL                       807

END

FIG.10

```
                    ┌─────────────────────┐
                    │        START        │
                    └──────────┬──────────┘
                               │
                               ▼
            ╱────────────────────────────────────╲          8 2 1
           ╱   INPUT ORDERS OF HARMONIC            ╲
          ╱    COMPONENTS TO BE ELIMINATED          ╲
         ╱────────────────────────────────────────────╲
                               │
                               ▼
            ┌──┬─────────────────────────┬──┐          8 2 2
            │  │    PERFORM MATRIX        │  │
            │  │    CALCULATION           │  │
            └──┴─────────────────────────┴──┘
                               │
                               ▼
            ╱────────────────────────────────────╲          8 2 3
           ╱   OUTPUT PULSE REFERENCE ANGLES       ╲
          ╱────────────────────────────────────────╲
                               │
                               ▼
            ┌──┬─────────────────────────┬──┐          8 2 4
            │  │    COMPARE WITH          │  │
            │  │    TRIANGULAR WAVES      │  │
            └──┴─────────────────────────┴──┘
                               │
                               ▼
            ╱────────────────────────────────────╲          8 2 5
           ╱   OUTPUT VOLTAGES                     ╲
          ╱    BETWEEN LINES                        ╲
         ╱────────────────────────────────────────────╲
                               │
                               ▼
            ┌──┬─────────────────────────┬──┐          8 2 6
            │  │ PERFORM CONVERSION FROM  │  │
            │  │ VOLTAGES BETWEEN LINES TO│  │
            │  │ GATE PULSES              │  │
            └──┴─────────────────────────┴──┘
                               │                          8 2 7
                               ▼
            ╱────────────────────────────────────╲
           ╱   OUTPUT PULSE SIGNALS                ╲
          ╱────────────────────────────────────────╲
                               │
                               ▼
                    ┌─────────────────────┐
                    │         END         │
                    └─────────────────────┘
```

# FIG.11

PULSE WIDTHS DETERMINED BY DEVIATION BETWEEN CARR1 AND CARR2 IN THE HEIGHT DIRECTION (AND THE SAME FOR CARR3 AND CARR4)

REFERENCE PHASE OF VOLTAGE BETWEEN U AND V LINES [rad]

COMPARE PULSE REFERENCE POSITIONS $S_1$, $S_2$, $S_3$, AND $S_4$ WITH TRIANGULAR WAVE OF PERIOD $2\pi$

※$d\theta = \mathrm{carr1}(\theta_{uvl}) - \mathrm{carr2}(\theta_{uvl}) = \mathrm{carr3}(\theta_{uvl}) - \mathrm{carr4}(\theta_{uvl})$

PULSE WIDTH $\propto$ MODULATION INDEX

FIG.12

FIG.13

EXAMPLE OF PULSE WAVEFORM OF VOLTAGE BETWEEN LINES

PULSE WIDTH IS NOT CONSTANT

DECOMPOSITION OF PULSES

# FIG.14

FIG.15

FUNDAMENTAL
WAVE AMPLITUDE

PHASE VOLTAGE PULSE

GAPS BETWEEN PULSES ARE 0

SQUARE WAVE
PHASE VOLTAGE
PULSES

MODULATION
INDEX

1.27
1.17
1.0
0.8
0.6
0.4
0.2
0.0

ON
OFF

$\theta$uvl

0    $\pi/2$    $\pi$    $3\pi/2$    $2\pi$

REFERENCE PHASE OF VOLTAGE
BETWEEN LINES [rad]

## FIG.16

| MODE | VOLTAGE BETWEEN LINES (NORMALIZED) | | | | PHASE TERMINAL VOLTAGE (NORMALIZED) | | |
|---|---|---|---|---|---|---|---|
| | Vuv | Vvw | Vwu | | Vu | Vv | Vw |
| 1 | 1 | 0 | -1 | → | 1 | 0 | 0 |
| 2 | 0 | 1 | -1 | → | 1 | 1 | 0 |
| 3 | -1 | 1 | 0 | → | 0 | 1 | 0 |
| 4 | -1 | 0 | 1 | → | 0 | 1 | 1 |
| 5 | 0 | -1 | 1 | → | 0 | 0 | 1 |
| 6 | 1 | -1 | 0 | → | 1 | 0 | 1 |

(EXAMPLE)
Vu-Vv=+1
Vv-Vw= 0
Vw-Vu=-1

(EXAMPLE)

Vu=1   U PHASE: UPPER ARM ON / LOWER ARM OFF

Vv=0   V PHASE: UPPER ARM OFF / LOWER ARM ON

Vw=0   W PHASE: UPPER ARM OFF / LOWER ARM ON

## FIG.17

MODE 5  6  1  2  3  4  5  6  1  2  3  4  5

FUNDAMENTAL WAVE AMPLITUDE
VOLTAGE Vuv BETWEEN U AND V LINES
$Vu - Vv = Vuv$

U PHASE TERMINAL VOLTAGE Vu

V PHASE TERMINAL VOLTAGE Vv

W PHASE TERMINAL VOLTAGE Vw

0    $\pi$    $2\pi$ (0)    $\pi$    $2\pi$    $\theta$ uvl

$\pi/2$    $3\pi/2$    $\pi/2$    $3\pi/2$

REFERENCE PHASE OF VOLTAGE BETWEEN THE U AND V LINES [rad]

FIG.18

THREE PHASE SHORT CIRCUIT

MODE  6  5  6  51  6 -1  6 2 1  2  13  2  3  24  3 -4  3 5  4  5  4

VOLTAGE Vuv
BETWEEN U AND V
LINES
    Vu − Vv = Vuv

U PHASE TERMINAL
VOLTAGE Vu

V PHASE TERMINAL
VOLTAGE Vv

W PHASE TERMINAL
VOLTAGE Vw

0        π/2        π        3/2π        2π  $\theta_{uvl}$

REFERENCE PHASE OF VOLTAGE BETWEEN
U AND V LINES [rad]

FIG.19A

PATTERN OF ELIMINATION OF 3RD AND
5TH ORDER HARMONIC COMPONENTS

FIG.19B

PATTERN OF ELIMINATION OF 3RD, 5TH,
AND 7TH ORDER HARMONIC COMPONENTS

# FIG.20

PULSE VOLTAGE
BETWEEN LINES

$\sqrt{3}\text{Vdc}/2$
1.27
$-\sqrt{3}\text{Vdc}/2$

$\sqrt{3}\text{Vdc}/2$
1.20
$-\sqrt{3}\text{Vdc}/2$

$\sqrt{3}\text{Vdc}/2$
1.0
$-\sqrt{3}\text{Vdc}/2$

$\sqrt{3}\text{Vdc}/2$
0.8
$-\sqrt{3}\text{Vdc}/2$

$\sqrt{3}\text{Vdc}/2$
0.6
$-\sqrt{3}\text{Vdc}/2$

$\sqrt{3}\text{Vdc}/2$
0.4
$-\sqrt{3}\text{Vdc}/2$

$\sqrt{3}\text{Vdc}/2$
0.2
$-\sqrt{3}\text{Vdc}/2$

0.0

MODULATION
INDEX

FUNDAMENTAL WAVE

UP TO HERE,
TARGETED
HARMONIC
COMPONENTS
CAN BE
ELIMINATED

0    $\pi/2$    $\pi$    $3\pi/2$    $2\pi$    $\theta$ uvl

REFERENCE PHASE OF VOLTAGE
BETWEEN LINES [rad]

55

FIG.21

FIG.22A

W PHASE VOLTAGE COMMAND

TRIANGULAR WAVE CARRIER

U PHASE VOLTAGE COMMAND

V PHASE VOLTAGE COMMAND

TIME

FIG.22B

U PHASE VOLTAGE (NUMBER OF PULSES = NUMBER OF PULSES IN CARRIER)

TIME

FIG.22C

V PHASE VOLTAGE (NUMBER OF PULSES = NUMBER OF PULSES IN CARRIER)

TIME

FIG.22D

W PHASE VOLTAGE (NUMBER OF PULSES = NUMBER OF PULSES IN CARRIER)

TIME

FIG.22E

VOLTAGE BETWEEN U AND V LINES (NUMBER OF PULSES = TWICE NUMBER OF PULSES IN CARRIER)

TIME

FIG.23

FIG.24

FIG.25A

VOLTAGE BETWEEN
LINES [V]

FUNDAMENTAL
WAVE
AMPLITUDE

PULSES OF VOLTAGE BETWEEN LINES
OF HM PULSE SIGNAL

$\sqrt{3}V_{dc}/2$

0

$-\sqrt{3}V_{dc}/2$

FIG.25B

VOLTAGE BETWEEN
LINES [V]

FUNDAMENTAL WAVE
AMPLITUDE

PULSES OF VOLTAGE BETWEEN LINES
OF SINE WAVE PWM SIGNAL

$\sqrt{3}V_{dc}/2$

0

$-\sqrt{3}V_{dc}/2$

0          $\pi/2$          $\pi$          $3\pi/2$          $2\pi$

REFERENCE PHASE OF VOLTAGE
BETWEEN LINES [rad]

FIG.26

CONTROL MODE
CHANGEOVER

CONTROL MODE 1
(SINE WAVE PWM CONTROL)

CONTROL MODE 2
(HM CONTROL)

VOLTAGE BETWEEN
LINES [V]

$\sqrt{3}V_{dc}/2$

0

$-\sqrt{3}V_{dc}/2$

0          $\pi/2$          $\pi$          $3\pi/2$          $2\pi$

REFERENCE PHASE OF VOLTAGE
BETWEEN LINES [rad]

FIG.27A

CARRIER COMPARISON

U PHASE VOLTAGE

V PHASE VOLTAGE

VOLTAGE BETWEEN THE U AND V LINES

PULSE WIDTHS ARE
UNEQUAL INTERVALS

CONSTANT INTERVALS
BETWEEN PULSES

(A CONSTANT TIME PERIOD,
IRRESPECTIVE OF VARIATION OF ROTATIONAL SPEED)

FIG.27B

U PHASE VOLTAGE

V PHASE VOLTAGE

VOLTAGE BETWEEN THE U AND V LINES

PULSE WIDTHS ARE EQUAL INTERVALS,
BUT WITH SOME EXCEPTIONS

UNEQUAL INTERVALS BETWEEN PULSES

(TIME PERIODS THAT CHANGE WITH VARIATION OF ROTATIONAL SPEED)

# FIG.28A

VOLTAGE BETWEEN LINES $V_{UV}$

16 PULSES PER $2\pi$ OF ELECTRICAL ANGLE

$\sqrt{3}V_{dc}/2$

0

$-\sqrt{3}V_{dc}/2$

0          $\pi/2$          $\pi$          $3/2\pi$          $2\pi$

REFERENCE PHASE OF VOLTAGE BETWEEN LINES [rad]

# FIG.28B

TWICE ELECTRIC MOTOR ROTATIONAL SPEED

VOLTAGE BETWEEN LINES $V_{UV}$

16 PULSES PER $2\pi$ OF ELECTRICAL ANGLE

$\sqrt{3}V_{dc}/2$

0

$-\sqrt{3}V_{dc}/2$

0     $\pi/2$     $\pi$     $3/2\pi$     $2\pi$     $\pi/2$     $\pi$     $3/2\pi$     $2\pi$
                                        (0)

REFERENCE PHASE OF VOLTAGE BETWEEN LINES [rad]

# FIG.28C

HALF ELECTRIC MOTOR ROTATIONAL SPEED

VOLTAGE BETWEEN LINES $V_{UV}$

8 PULSES PER $\pi$ OF ELECTRICAL ANGLE (I.E. 16 PULSES PER $2\pi$ OF ELECTRICAL ANGLE)

$\sqrt{3}V_{dc}/2$

0

$-\sqrt{3}V_{dc}/2$

0                    $\pi/2$                    $\pi$

REFERENCE PHASE OF VOLTAGE BETWEEN LINES [rad]

FIG.29

NUMBER OF PULSES OF VOLTAGE BETWEEN LINES (PER 2π OF ELECTRICAL ANGLE)

ROTATIONAL SPEED OF ELECTRIC MOTOR PER UNIT TIME (r/min)

FIG.30

START

901
ACQUIRE ROTATIONAL SPEED INFORMATION

902
ROTATIONAL SPEED GREATER THAN OR EQUAL TO CHANGEOVER ROTATIONAL SPEED ?

NO

YES

906
PERFORM PWM CONTROL

903
ROTATING AT HIGH SPEED ?

YES

904
NO

DETERMINE NUMBER OF ORDERS OF HARMONIC COMPONENTS TO BE ELIMINATED

907
PERFORM SQUARE WAVE CONTROL

905
PERFORM HM CONTROL

# FIG.31

FIG.31 — Control circuit block diagram.

MOTOR CONTROL COMMAND (TORQUE COMMAND)

172 CONTROL CIRCUIT

COMPENSATOR INTERRUPTION SIGNAL — 460

TRANSIENT CURRENT COMPENSATOR

410 — TORQUE COMMAND – CURRENT COMMAND CONVERTER

Id* / Iq*

421 — CURRENT CONTROLLER (ACR)

Vd* / Vq*

440 — PULSE MODULATOR (PWM CONTROL)

6

450 — SYSTEM CHANGE OVER DEVICE

6 / 6 / 6

173 PROCESSING CIRCUIT

GATE PULSE SIGNAL
174 — DRIVE CIRCUIT

136 — BAT

144 — INV

420 — CURRENT CONTROLLER (ACR)

Vd* / Vq*

430 — PULSE MODULATOR (HM CONTROL)

431 — VOLTAGE PHASE DIFFERENCE CALCULATOR — θv

432 — MODULATION INDEX CALCULATOR — a

434 — PULSE GENERATOR

PHASE CURRENT DETECTION SIGNAL
Iu, v, w

180

192 — MG

193 — MAGNETIC POLE ROTATION SENSOR

θ : MAGNETIC POLE POSITION SIGNAL

EP 2 355 319 A2

FIG.32

CONTROL MODE 1: SINE WAVE PWM CONTROL

CONTROL MODE 1: VOLTAGE BETWEEN LINES [V]

$\sqrt{3}V_{dc}/2$

0

$-\sqrt{3}V_{dc}/2$

CONTROL MODE 1: PHASE VOLTAGE

$V_{dc}/2$
0
$-V_{dc}/2$

PHASE CURRENT DETECTED BY CURRENT SENSOR

CONTROL MODE 1: PHASE CURRENT [A]

0

COMPENSATION PULSE

CONTROL MODE 1: TRANSIENT CURRENT

COMPENSATION CURRENT

CONTROL MODE 1: PHASE VOLTAGE

$V_{dc}/2$
0
$-V_{dc}/2$

CONTROL MODE 2 FROM HERE

CONTROL MODE 2: VOLTAGE BETWEEN LINES [V]

$\sqrt{3}V_{dc}/2$

0

$-\sqrt{3}V_{dc}/2$

CONTROL MODE 2: PHASE VOLTAGE [V]

$V_{dc}/2$
0
$-V_{dc}/2$

0    $\pi/2$    $\pi$    $3\pi/2$    $2\pi$

REFERENCE PHASE OF VOLTAGE BETWEEN LINES [rad]

FIG.33

Iut (TRANSIENT CURRENT IN CONTROL MODE 1)

CURRENT (A)

Iua (PHASE CURRENT)

0

$t_0$

t

Iup (COMPENSATION CURRENT)

0

t

− Vdc/2

Vun_p (TRANSIENT CURRENT COMPENSATION PULSE)

FIG.34

START

901 ACQUIRE ROTATIONAL SPEED INFORMATION

902 ROTATIONAL SPEED GREATER THAN OR EQUAL TO CHANGEOVER ROTATIONAL SPEED ?

NO

906 PERFORM PWM CONTROL

YES

903 ROTATING AT HIGH SPEED ?

YES

907 PERFORM SQUARE WAVE CONTROL

NO

904 DETERMINE NUMBER OF ORDERS OF HARMONIC COMPONENTS TO BE ELIMINATED

905 PERFORM HM CONTROL

908 CHANGEOVER PERFORMED ?

NO

YES

909 PERFORM TRANSIENT CURRENT COMPENSATION

FIG.35

CONTROL MODE CHANGEOVER

DETECT TRANSIENT CURRENTS FOR EACH PHASE IN PREVIOUS CONTROL MODE WITH CURRENT SENSOR

FROM CIRCUIT TIME CONSTANT $\tau$, CALCULATE PHASE VOLTAGE APPLICATION TIME PERIODS t0 FOR COMPENSATION CURRENTS (OPPOSITE TO TRANSIENT CURRENTS) TO CANCEL OUT TRANSIENT CURRENTS

APPLY PHASE VOLTAGE (Vdc/2) FOR TIME PERIODS t0 IN DIRECTIONS TO CANCEL OUT TRANSIENT CURRENTS

STOP APPLICATION AFTER TARGET APPLICATION TIME PERIODS t0 ARE REACHED

CANCEL OUT TRANSIENT CURRENTS WITH COMPENSATION CURRENTS WHILE THEY ATTENUATE AT TIME CONSTANT $\tau$

FIG.36

Iua (U PHASE CURRENT)

Vu (U PHASE VOLTAGE PULSE)

L (CIRCUIT INDUCTANCE)

R (CIRCUIT RESISTANCE)

Eu (INDUCED VOLTAGE)

CIRCUIT TIME CONSTANT $\tau = L/r$

FIG.37

CONTROL CIRCUIT — 172

TORQUE COMMAND T*

TORQUE COMMAND – CURRENT COMMAND CONVERTER — 410

CURRENT CONTROLLER (ACR) — 421

PULSE MODULATOR (PWM CONTROL) — 440

SYSTEM CHANGEOVER DEVICE

COMPENSATOR INTERRUPTION SIGNAL

TRANSIENT CURRENT COMPENSATOR — 460

BAT — 136

CURRENT CONTROLLER (ACR) — 420

PULSE MODULATOR (HM CONTROL) — 430

VOLTAGE PHASE DIFFERENCE CALCULATOR — 431

MODULATION INDEX CALCULATOR — 432

PULSE GENERATOR — 434

GATE PULSE SIGNAL

INV — 144

CURRENT CONTROLLER (ACR) — 422

PULSE MODULATOR (SINGLE PHASE CHOPPER CONTROL) — 480

PHASE CURRENT DETECTION SIGNAL

Iu, v, w

MG — 192

180

CHOPPER PERIOD GENERATOR — 470

MAGNETIC POLE ROTATION SENSOR — 193

MAGNETIC POLE POSITION SIGNAL θ

Id*  Iq*  Vd*  Vq*  θv  a  450

EP 2 355 319 A2

71

## FIG.38

UPPER ARM ON: CURRENT FLOWS IN U PHASE
LOWER ARM ON: THREE PHASE SHORT CIRCUIT (ALL LOWER ARMS ON)

U PHASE
CONTINUOUS

THREE PHASES
SHORT CIRCUITED

# FIG.39

```
                    START

      901
    ACQUIRE ROTATIONAL SPEED INFORMATION

  902
         ROTATIONAL SPEED
       GREATER THAN OR EQUAL TO        NO
       CHANGEOVER ROTATIONAL
            SPEED ?                  910

                  YES
  903                                      PERFORM PWM        YES
       ROTATING AT HIGH SPEED ?    YES      CONTROL ?

  904              NO         907         911              NO        906
    DETERMINE NUMBER OF ORDERS    PERFORM SQUARE    PERFORM SINGLE         PERFORM PWM
    OF HARMONIC COMPONENTS TO     WAVE CONTROL      PHASE CHOPPER          CONTROL
    BE ELIMINATED                                   CONTROL

      905
    PERFORM HM CONTROL

  908
       CHANGEOVER PERFORMED ?      NO

  909              YES
    PERFORM TRANSIENT
    CURRENT COMPENSATION
```

FIG.40A

45

44

42

ELECTRICAL ANGLE 2π

FIG.40B

45

① ③ ⑤

② ④

55

①+②+③+④+⑤

FIG.40C

45

44

62

65

## FIG.41A

45

44

62

65

## FIG.41B

1  2 3  4      5 6 7

72

75

ELECTRICAL ANGLE $2\pi$

# FIG.42

WHEN VOLTAGE BETWEEN LINES $f(\omega t)$ IS FOURIER EXPANDED

$f(\omega t)=A0+\Sigma(An\cdot\cos(n\omega t)+Bn\cdot\sin(n\omega t))$   n=1,2,3···

$An=1/\pi \int f(\omega t)\cos(n\omega t)d(\omega t)$
$Bn= 1/\pi \int f(\omega t)\sin(n\omega t)d(\omega t)$

A0=0   THE AVERAGE OF POSITIVE AND NEGATIVE DC COMPONENTS IS 0

(1) HALF WAVE SYMMETRIC:   $f(\omega t)=-f(\omega t+\pi)$

*POSITIVE AND NEGATIVE REVERSE EACH HALF PERIOD $\pi$
*HARMONIC COMPONENTS OF EVEN ORDERS (n=2, 4, 6, ...) ARE ELIMINATED

METHODS FOR ELIMINATION OF HARMONIC COMPONENTS

(2) ODD SYMMETRIC:   $f(\omega t)=f(\pi-\omega t)$

*WAVEFORM IS SYMMETRIC ABOUT $\pi/2$ AS A CENTER (SINCE IT IS AN ODD FUNCTION, COSINE TERMS ARE ELIMINATED)

FROM (1) AND (2), THE FOLLOWING EQUATION IS ACQUIRED:

$f(\omega t)=\Sigma Bn\cdot\sin(n\omega t)$   n=1,3,5···

Bn IS AMPLITUDE OF n-TH HARMONIC COMPONENT. BY OUTPUTTING PULSES TARGETING THE PHASE AT WHICH Bn=0, THE HARMONIC COMPONENT IS ELIMINATED.

# FIG.43

EXAMPLE OF METHOD FOR ELIMINATING 3RD ORDER, 5TH ORDER, AND
7TH ORDER HARMONIC COMPONENTS

CREATE TWO PULSES AT
INTERVALS OF $\pi/3$,
CENTERED AROUND $\pi/2$

CREATE 2 X 2 PULSES AT
INTERVALS OF $\pi/5$,
CENTERED UPON THE TWO
PULSES ABOVE

CREATE 2 X 4 PULSES AT
INTERVALS OF $3\pi/7$,
CENTERED UPON THE FOUR
PULSES ABOVE

REFERENCE PHASE OF VOLTAGE BETWEEN LINES
FOR U PHASE AND V PHASE [rad]

FIG.44

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010051963 W

- JP S63234878 B